# EUROPEAN PATENT APPLICATION

(11) **EP 2 105 798 A1**
(43) Date of publication of application: **30.09.2009**
(21) Application number: 08703760.2
(22) Date of filing: 17.01.2008
(51) Int. Cl.: G03F 7/32, G11B 7/26

(54) **DEVELOPING SOLUTION AND METHOD FOR PRODUCTION OF FINELY PATTERNED MATERIAL**

(30) Priority: 17.01.2007 JP 2007008537; 23.05.2007 JP 2007137240
(71) Applicant: Sony Corporation, Tokyo 108-0075 (JP)
(72) Inventor: SAITO, Noriyuki, Minato-ku Tokyo 108-0075 (JP); ADACHI, Norio, Minato-ku Tokyo 108-0075 (JP)
(74) Representative: Müller - Hoffmann & Partner
(86) International application number: PCT/JP2008/050931
(87) International publication number: WO 2008/088076

(57) **Abstract**

A developing solution comprising an aqueous alkali solution, at least one anion selected from a silicate ion, a carbonate ion, a borate ion and a phosphate ion, and at least one cation selected from an ammonium ion, an organic ammonium ion and an alkali metal ion. The aqueous alkali solution may be an aqueous solution of a tetraalkylammonium hydroxide.

## Description

### Technical Field

The present invention relates to a developing solution, and a method for producing a finely patterned material using the same. More particularly, the invention relates to a developing solution used in the development of thermosensitive inorganic resists, which utilizes an oxidation/reduction reaction of transition metal oxides or phase transfer.

### Background Art

As a means for realizing shape patterns of controlled angles with high resolution, there have been proposed methods of utilizing inorganic resists. These have been reported to include methods of using, as an active energy source for drawing shape patterns, an electron beam or an ion beam (see, for example, Japanese Patent Application Laid-Open (JP-A) No. 6-132188, and JP-A No. 8-69960), methods of using far ultraviolet radiation (see, for example, JP-A No. 2004-172272), methods of using laser radiation (see, for example, Japanese Journal of Applied Physics, 44, 3574-3577, 2005), and the like.

Among the methods making use of laser radiation as the drawing energy, a method of using a metal oxide as the material for inorganic resist has been proposed (see, for example, JP-A No. 2003-315988 and JP-A No. 2004-152465). Since this inorganic resist leads to the formation of latent images through thermosensitive reactions, it is possible to achieve exposure of a pattern smaller than the spot diameter, even through exposure to a visible laser light at about 405 nm. For this reason, the method has been paid attention as a technology which is useful for the optical disk mastering technology in coping with Blu-ray Disc (registered trademark) or even further increases in recording density.

Here, the developing solution used in the resist development will be described. In addition to the development of photographic films, the development of the organic resists which are used in the production of semiconductors or plate making, is carried out by means of alkaline aqueous solutions mixed with various additives. These developing solutions undergo deterioration as a result of the consumption of alkali sources due to chemical reactions with developing products, as well as the reaction with carbon dioxide in air, or the like. When a developing solution which has been worn out and thus has the alkali source consumed up, is to be replaced with a new developing solution, if all of the developing solution is completely exchanged, development properties such as the rate of development or the contrast may be changed to a large extent in some cases. As a method of avoiding this, a method of discarding only a half of the worn out developing solution, and replenishing the remaining portion with a new developing solution, or a method of adding an alkali source at a high concentration to the worn out developing solution, to thereby supplement the consumed portion, is generally known. Furthermore, a method of replacing all of the developing solution, subsequently repeating preliminary development until the development properties are stabilized, and using a developing solution which has been stored for a while, is also adopted.

The rate of development is largely affected by the pH of the developing solution, and in general, the rate of development is increased as the pH value is increased (as the alkalinity becomes stronger). In the case of developing black-and-white photographs, the pH of the developing solution is adjusted to control the reducing power of metol (N-methyl-p-aminophenol hemisulfate), hydroquinone, phenidone (1-phenyl-3-pyrazolidone) or the like, which are the main developing agents, and as the alkali is stronger, the reducing power of the main developing agent becomes stronger. It is known that when a buffering agent such as borax (sodium tetraborate), sodium metaborate, or sodium carbonate is mixed into a developing solution, the pH value is stabilized, and at the same time, dissociation of the main developing agent is proceeded to activate the developing solution, thereby a development accelerating effect being brought about. On the other hand, when potassium bromide is incorporated in, the reaction is suppressed, the rate of development is decreased, and at the same time, development of weakly exposed parts is suppressed so that an effect of preventing "fogging" is obtained.

In regard to organic resists which are used in the production of semiconductors and the like, for example, in the case of the positive type, a latent image is formed by irradiating the polymer resist with ultraviolet radiation, an electron beam or the like to cleave the polymer chain, or by generating an acidic functional group such as -COOH or -OH in the polymer chain, the latent image is neutralized and dissolved with an alkaline developing solution, and thereby image formation is achieved. In the case of the negative type, image formation is achieved by making use of the difference in the solubility in an alkaline or acidic developing solution between the part where the monomer or oligomer has been polymerized by the irradiation with ultraviolet radiation or the like, and the part where no polymerization has occurred. These organic resists are such that detachment may occur prior to dissolution of the resist at excessively high pH values, while the dissolution rate may be slowed down at excessively low pH values. For this reason, a method of incorporating a buffering agent is used in order to stabilize the developing solution to an appropriate pH value. As for the type of the buffering agent, a method of employing phosphates (see, for example, JP-A No. 2005-300694), a method of employing silicates (see, for example, JP-A No. 2005-049542), a method of employing carbonates (see, for example, US Patent No. 5853963 and JP-A No. 02-002572), a method of employing carbon dioxide gas (see, for example, JP-A No. 2001-228628), and the like have been published.

An alkaline developing solution absorbs carbon dioxide gas when contacted with air, and thus alkali components are consumed (carbon dioxide fatigue). To prevent this, a method of incorporating a carbonate or a hydrogen carbonate into the developing solution as an alkali component or an additive, is adopted (see, for example, JP-A No. 2002-202616).

In regard to the plate making of photosensitive lithographic printing plates, there has been disclosed a method of performing the plate making by applying an organic resist on a support made of aluminum. It is reported that aqueous solutions of silicates are effective as the developing solution (see, for example, JP-A No. 52-127338, JP-A No. 54-062004, and Japanese Patent Application Publication (JP-B) No. 57-007427). This is said to be because when the aluminum support is exposed by dissolving and removing the resist by developing, it is difficult for the developing solution to corrode the support, and adjustment of the development properties is possible to a certain degree by adjusting the ratio and concentrations of metal oxide and silicon oxide, which is a silicate component. Furthermore, silicates are reported to exhibit notable effects in view of preventing contamination by hydrophilizing the intaglio-shaped exposed parts of the support, which are the parts to be developed (see, for example, JP-A No. 08-160633, JP-A No. 11-065129, JP-A No. 2003-015318, JP-A No. 2003-035960, JP-A No. 2003-043701, JP-A No. 2003-043702, JP-A No. 2003-057847, JP-A No. 2003-057848, JP-A No. 2003-057849, JP-A No. 2003-107743, JP-A No. 2003-270775, and JP-A No. 2003-270776).

In addition to this, as a method of shortening the development time, there may be mentioned a method of imparting the developing solution with the affinity to polymer resist. Specifically, measures such as enhancing the wettability of the resist surface by adding surfactants to the developing solution, or enhancing the resist penetrability of the developing solution by adding an organic solvent, are being adopted.

### Disclosure of the Invention

For the master stamper used in the production of optical disks, typically, a pattern is formed by applying an organic resist on a glass substrate, forming a spiral latent image with laser radiation or the like, and developing the latent image. In this case, commercially available developing apparatuses are usually operated such that a low-power laser light is irradiated from the rear surface of the glass substrate, to thus transmit through the substrate, and the transmitted laser light undergoes scattering at the surface irregularities of the organic resist, which appear along with the progress of development. Furthermore, the time point at which the ratio of the first-order scattered light to the zero-order unscattered, transmitted light reaches a value established in advance, is taken as the end point.

On the other hand, inorganic resists are often opaque to visible light, and there may occur situations where this method cannot be applied. For this reason, the development of inorganic resists frequently adopts a method of measuring in advance the time taken to reach an appropriate state of development for every type of resist master, and managing the development based on the development time. Here, when a worn-out, deteriorated developing solution is completely changed with a new one, it may happen that the optimal development time or the shape obtainable by the development is altered to a large extent. Particularly, in the case where the development time is changed to a large extent, the management value for the end point must be re-established, and when the developing solution composition is changed concomitantly with the development of the resist, it becomes necessary to re-establish the management value from occasion to occasion, in accordance with the change. It is known that developing solutions have the development properties gradually stabilized while they are being used for some time, and thus, under general situations of resist development, a method of repeating preliminary development, and then putting the resist into actual use, is frequently used. However, in the case of master stamper for optical disks, since the resist film thickness is extremely thin to the order of nanometers, a large number of the preliminary development process will be required until the developing solution becomes stabilized by the development of resist.

Therefore, an object of this invention is to provide a developing solution which can maintain the rate of development almost constantly from the state of being fresh to the state of being worn out, and at the same time, can shorten the development time, and a method for producing a finely patterned material using the same.

The present invention is an invention obtained as a result of devoted investigation carried out in order to solve the above-described problems of the prior art. Hereinafter, the gist of the invention will be described. First, attention was paid to the point that the rate at which an alkaline aqueous solution used as a developing solution dissolves a metal oxide, which is the dissoluble component of an inorganic resist, is highly accelerated by the salts included in the developing solution in addition to the alkali source. Then, the relations between the type of the salts and the development properties such as the rate of development or the surface morphology, were investigated, and thus the present invention was completed.

If a compound which directly exerts action to WO₃, MoO₃ and the like, which are the dissoluble components (acid components) in the inorganic resist, is incorporated into a developing solution in the state of being dissolved in an alkaline aqueous solution, the rate of development is rapidly increased proportionally to the amount of incorporation, until a certain amount of incorporation is reached, and then the rate of development is slowly converged to a certain rate of development. This converged value varies depending on the type of the salts added. By incorporating these salts individually alone or as mixtures, it has become possible to shorten the time required in development, as well as to control the development time. Thereby, it has become possible to make the developing solution to maintain the rate of development almost constantly, from the state of being fresh to the state of being worn out. Here, in the case where the compound to be added is a salt, the alkali moiety may be identical with or different from the alkali source of the developing solution. On the other hand, when a compound having reactivity with the alkali source, for example, a basic compound weaker than the alkali source, an acidic oxide, an amphoteric oxide, an amphoteric hydroxide or the like, is added to an alkaline aqueous solution, the compound reacts with the alkali source of the developing solution while being dissolved. As a result, an effect equivalent to the case where the alkali moiety of the salt is the same as the alkali source contained in the developing solution, can be obtained.

A first invention of the present invention is a developing solution characterized by containing:
an alkaline aqueous solution; and
at least one anion among a silicate ion, a carbonate ion, a borate ion and a phosphate ion.

A second invention of the present invention is a developing solution containing an alkaline aqueous solution and a development accelerating agent, wherein the development accelerating agent is at least one among a silicate, a carbonate, a borate and a phosphate.

A third invention of the present invention is a method for producing a finely patterned material, the method including:
exposing an inorganic resist layer provided on a base material; and
developing the exposed inorganic resist with a developing solution,
wherein the developing solution contains:
   an alkaline aqueous solution; and
   at least one anion among a silicate ion, a carbonate ion, a borate ion and a phosphate ion.

In the first and third inventions, the alkaline aqueous solution is preferably an aqueous solution of tetraalkylammonium hydroxide. The developing solution preferably further contains at least one among ammonium ion and an organic ammonium ion as a cation, or further contains an alkali metal ion as a cation, or further contains at least one among ammonium ion and an organic ammonium ion, and an alkali metal ion as cations.

In the first and third inventions, when the inorganic resist is developed, the anion repeatedly exerts action on the inorganic resist in the alkaline aqueous solution. Furthermore, when the inorganic resist is developed, the anion forms a bond with the inorganic resists.

In the first and third inventions, when titration is performed with an acid to determine a titration curve showing the relationship between the amount of dropwise addition and the pH, typically, the point of neutralization of the alkaline aqueous solution and an inflection point originating from the anion appear on the titration curve. It is preferable that the pH of the alkaline aqueous solution be set at a higher value compared to any of the pH of the point of neutralization and the inflection point appearing on the titration curve. Furthermore, it is preferable, in the case where titration is performed with an acid to determine a titration curve showing the relationship between the amount of dropwise addition and conductivity, that the titration curve have a minimum region between the point of neutralization of the alkaline aqueous solution and the inflection point originating from the anion.

In the second invention, the salt is preferably a product produced by the reaction between the alkaline aqueous solution and at least one among silicon, a silicon compound, a carbon compound, a boron compound and a phosphorus compound. Furthermore, the salt is preferably a product produced by the reaction between at least one selected from the group consisting of an alkali metal compound, an ammonium compound and a basic oxide, as an alkali component, and at least one selected from the group consisting of a protonic acid, an acidic oxide, an amphoteric oxide and an amphoteric hydroxide, as an acid component.

In the second invention, the cation of the alkali source of the alkaline aqueous solution and the cation of the development accelerating agent are preferably the same species, and in particular, it is preferable that the cation of the alkali source of the alkaline aqueous solution and the cation of the development accelerating agent be ammonium ion or an organic ammonium ion.

In the third invention, it is preferable that the method further includes a process of producing a developing solution by adding a silicate, a carbonate, a borate and a phosphate to the alkaline aqueous solution, prior to the process of exposing.

As discussed in the above, according to the present invention, the rate of development can be maintained almost constantly, from the state of being fresh to the state of being worn out, and at the same time, the development time can be shortened.

### Brief Description of the Drawings

Fig. 1A to Fig. 1C are schematic diagrams for explaining the reaction mechanism of an inorganic resist;
Fig. 2 is a schematic diagram for explaining the development mechanism of an inorganic resist;
Fig. 3 is a graph for explaining the relationship between the amount of dropwise addition of hydrochloric acid and the pH in the titration of a developing solution;
Fig. 4A to Fig. 4C are schematic cross-sectional views for explaining the method for producing a resist master according to an embodiment of the present invention;
Fig. 5A to Fig. 5C are schematic cross-sectional views for explaining the method for producing a resist master according to an embodiment of the present invention;
Fig. 6A to Fig. 6C are AFM diagrams for the inorganic resist master according to Comparative Example 1;
Fig. 7 is a graph showing the relationship between the amount of dropwise addition of hydrochloric acid, and the pH as well as conductivity in Comparative Example 1;
Fig. 8A to Fig. 8C are AFM diagrams for the inorganic resist master according to Comparative Example 2;
Fig. 9 is a graph showing the relationship between the amount of dropwise addition of hydrochloric acid and the pH as well as conductivity in Comparative Example 2;
Fig. 10A to Fig. 10C are AFM diagrams for the inorganic resist master according to Comparative Example 3;
Fig. 11 is a graph showing the relationship between the amount of dropwise addition of hydrochloric acid and the pH as well as conductivity in Comparative Example 3;
Fig. 12A to Fig. 12C are AFM diagrams for the inorganic resist master according to Comparative Example 4;
Fig. 13 is a graph showing the relationship between the amount of dropwise addition of hydrochloric acid and the pH as well as conductivity in Comparative Example 4;
Fig. 14A to Fig. 14C are AFM diagrams for the inorganic resist master according to Comparative Example 5;
Fig. 15 is a graph showing the relationship between the amount of dropwise addition of hydrochloric acid and the pH as well as conductivity in Comparative Example 5;
Fig. 16A to Fig. 16C are AFM diagrams for the inorganic resist master according to Example 1;
Fig. 17 is a graph showing the relationship between the amount of dropwise addition of hydrochloric acid and the pH as well as conductivity in Example 1;
Fig. 18 is a graph showing the relationship between the amount of dropwise addition of hydrochloric acid and the pH as well as conductivity in Example 2;
Fig. 19 is a partial magnified view of Fig. 18;
Fig. 20 is a graph showing the relationship between the amount of dropwise addition of hydrochloric acid and the pH as well as conductivity in Example 3;
Fig. 21 is a partial magnified view of Fig. 20;
Fig. 22A to Fig. 22C are AFM diagrams for the inorganic resist master according to Example 4;
Fig. 23 is a graph showing the relationship between the amount of dropwise addition of hydrochloric acid and the pH as well as conductivity in Example 4;
Fig. 24 is a graph showing the relationship between the amount of dropwise addition of hydrochloric acid and the pH as well as conductivity in the case of using the developing solution saturated with additives in Example 4;
Fig. 25A to Fig. 25C are AFM diagrams for the inorganic resist master according to Example 5;
Fig. 26 is a graph showing the relationship between the amount of dropwise addition of hydrochloric acid and the pH as well as conductivity in Example 5;
Fig. 27 is a graph showing the relationship between the amount of incorporation of a development accelerating agent and the development time in Example 6;
Fig. 28A to Fig. 28C are AFM diagrams for the inorganic resist master according to Example 7;
Fig. 29 is a graph showing the relationship between the amount of dropwise addition of hydrochloric acid and the pH as well as conductivity in Example 7;
Fig. 30A to Fig. 30C are AFM diagrams for the inorganic resist master according to Example 8;
Fig. 31 is a graph showing the relationship between the amount of dropwise addition of hydrochloric acid and the pH as well as conductivity in Example 8;

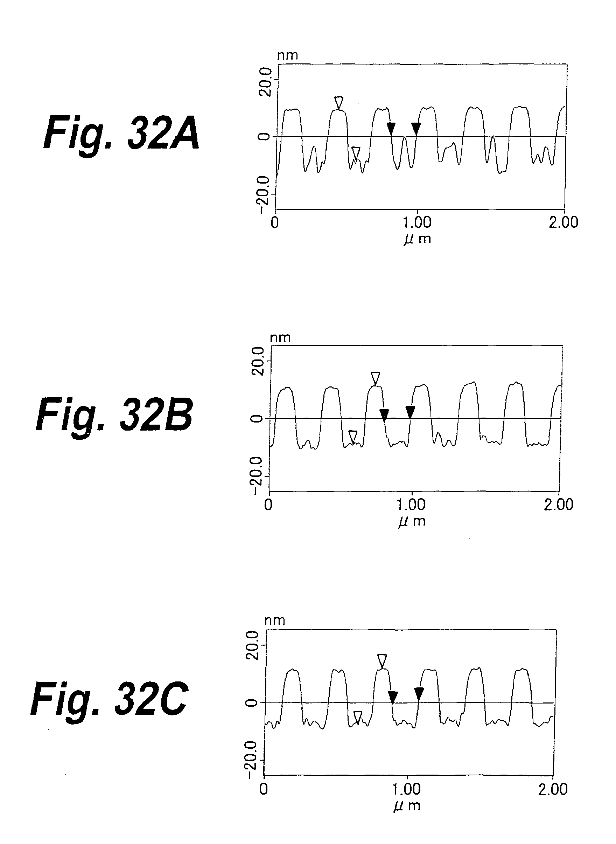

Fig. 32A to Fig. 32C are AFM diagrams for the inorganic resist master according to Example 9;

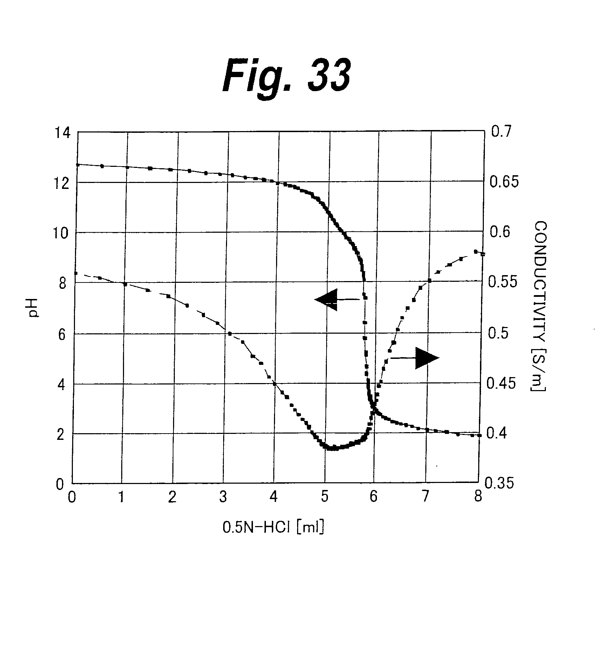

Fig. 33 is a graph showing the relationship between the amount of dropwise addition of hydrochloric acid and the pH as well as conductivity in Example 9;

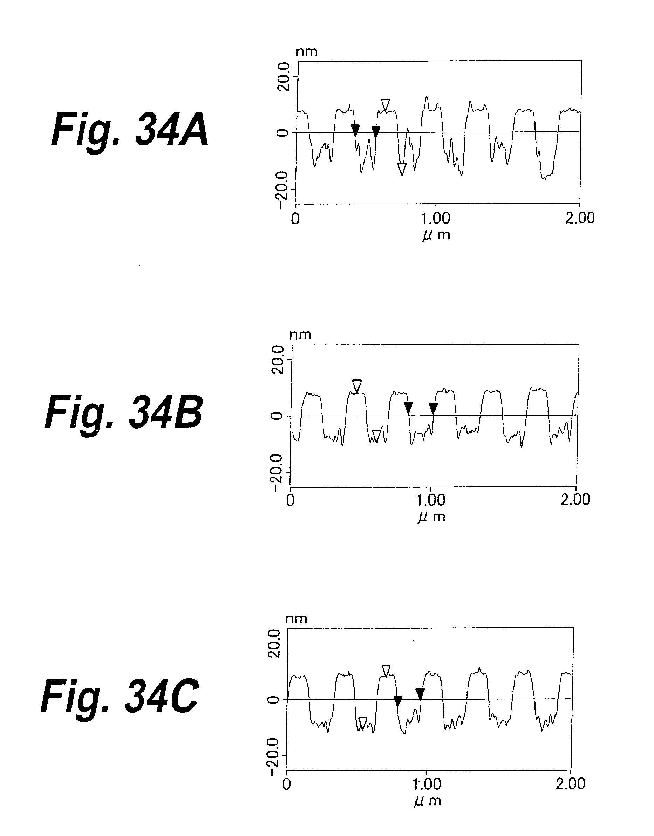

Fig. 34A to Fig. 34C are AFM diagrams for the inorganic resist master according to Example 10;

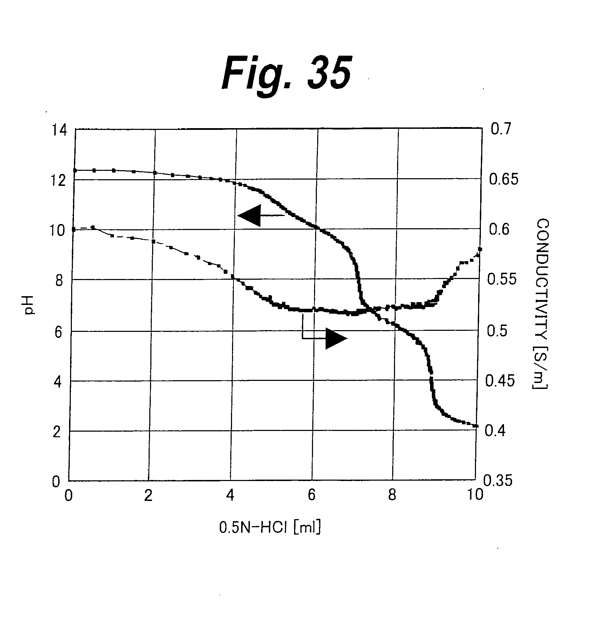

Fig. 35 is a graph showing the relationship between the amount of dropwise addition of hydrochloric acid and the pH as well as conductivity in Example 10;

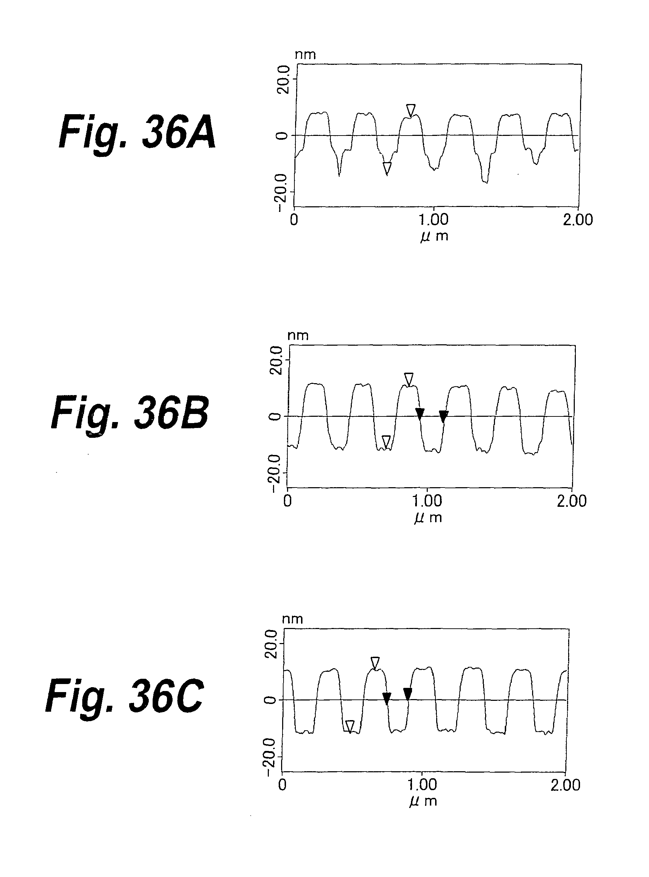

Fig. 36A to Fig. 36C are AFM diagrams for the inorganic resist master according to Example 11;

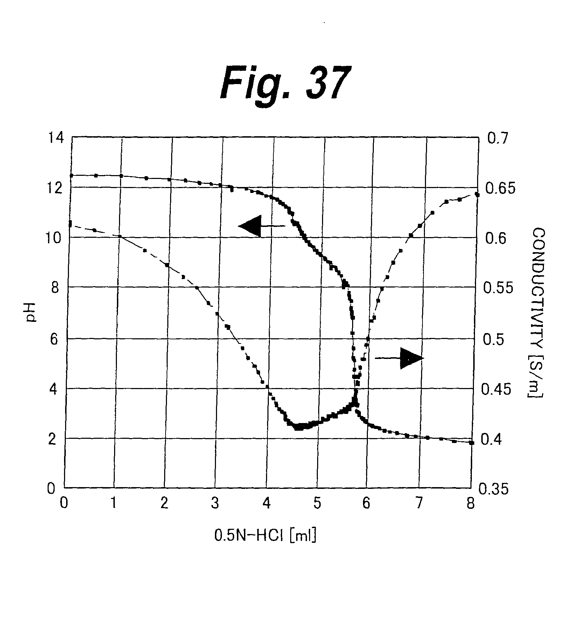

Fig. 37 is a graph showing the relationship between the amount of dropwise addition of hydrochloric acid and the pH as well as conductivity in Example 11;

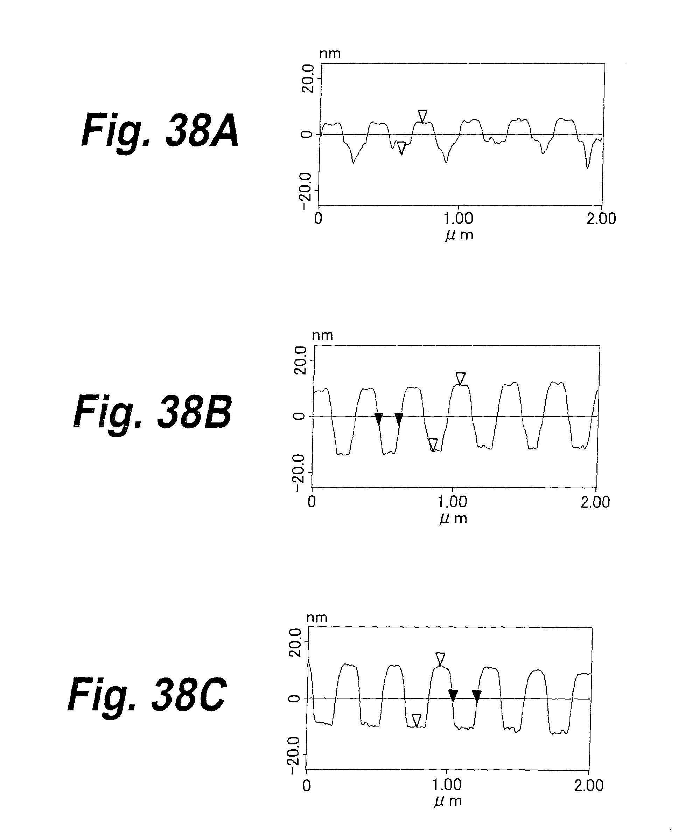

Fig. 38A to Fig. 38C are AFM diagrams for the inorganic resist master according to Example 12;

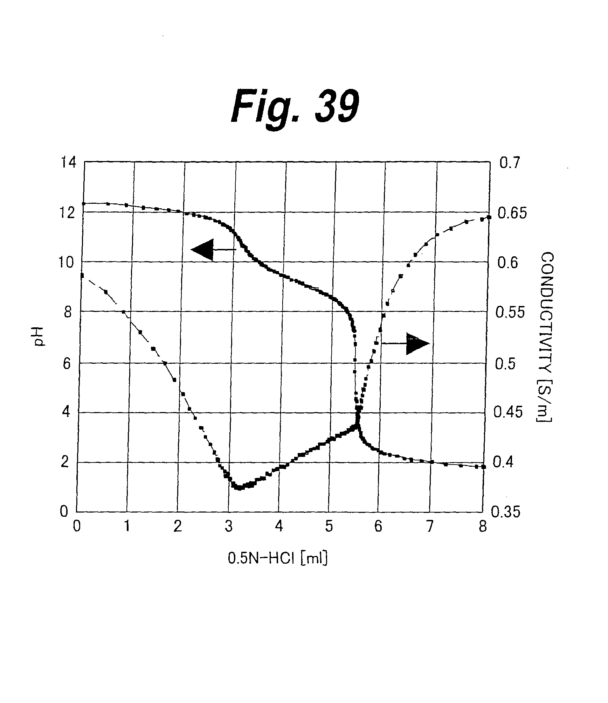

Fig. 39 is a graph showing the relationship between the amount of dropwise addition of hydrochloric acid and the pH as well as conductivity in Example 12;

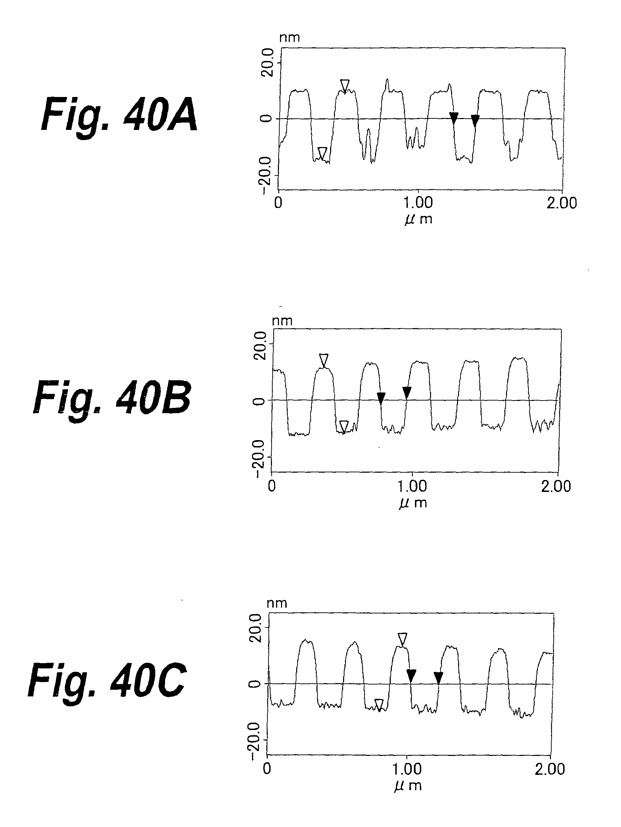

Fig. 40A to Fig. 40C are AFM diagrams for the inorganic resist master according to Example 13;

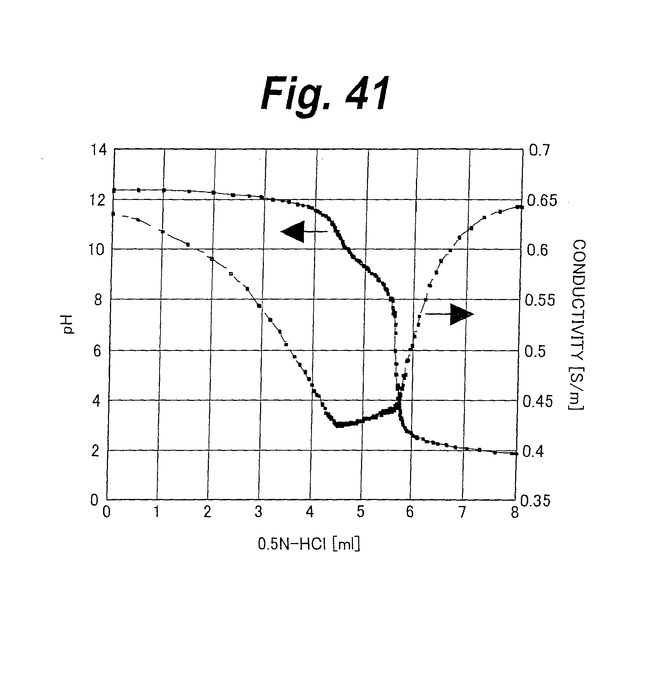

Fig. 41 is a graph showing the relationship between the amount of dropwise addition of hydrochloric acid and the pH as well as conductivity in Example 13;

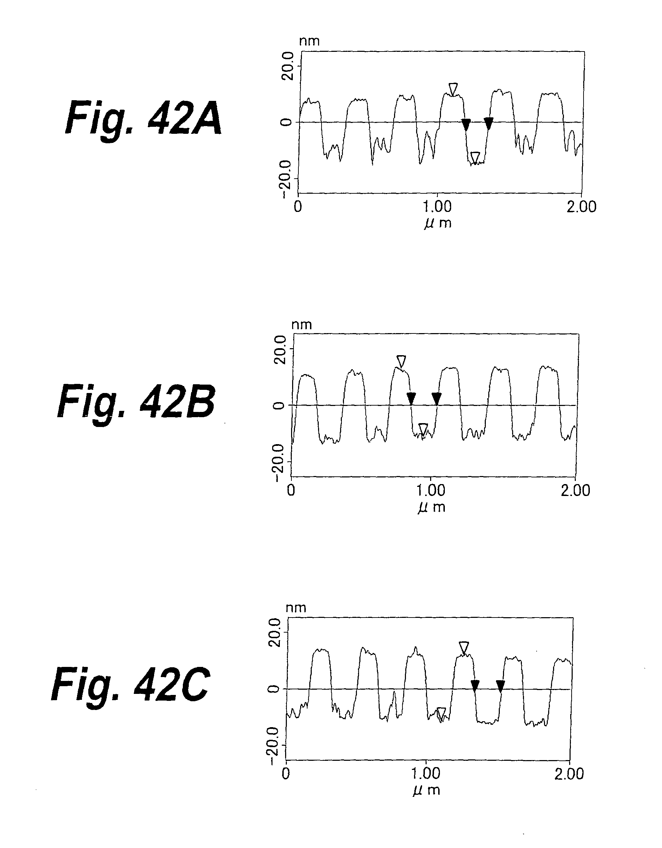

Fig. 42A to Fig. 42C are AFM diagrams for the inorganic resist master according to Example 14;

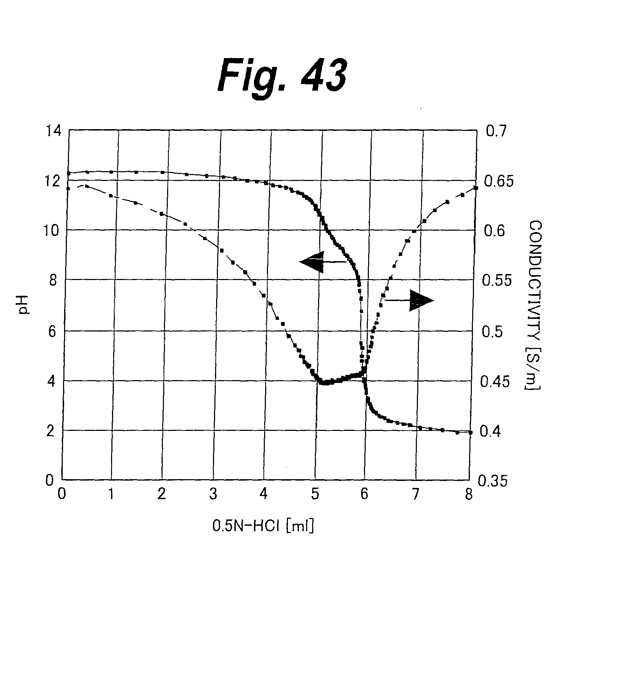

Fig. 43 is a graph showing the relationship between the amount of dropwise addition of hydrochloric acid and the pH as well as conductivity in Example 14;
Fig. 44A to Fig. 44C are AFM diagrams for the inorganic resist master according to Example 15;
Fig. 45 is a graph showing the relationship between the amount of dropwise addition of hydrochloric acid and the pH as well as conductivity in Example 15;
Fig. 46A to Fig. 46C are AFM diagrams for the inorganic resist master according to Example 16;
Fig. 47 is a graph showing the relationship between the amount of dropwise addition of hydrochloric acid and the pH as well as conductivity in Example 16;
Fig. 48 is a graph showing the relationship between the amount of incorporation of a development accelerating agent and the development time in Example 17 to Example 20;
Fig. 49 is a graph showing the relationship between the amount of incorporation of a development accelerating agent and the development time in Example 21 to Example 24;
Fig. 50 is a graph showing the relationship between the amount of incorporation of a development accelerating agent and the development time in Example 25 and Example 26;
Fig. 51A to Fig. 51C are AFM diagrams for the inorganic resist master according to Example 27;
Fig. 52 is a graph showing the relationship between the amount of dropwise addition of hydrochloric acid and the pH as well as conductivity in Example 27;
Fig. 53A to Fig. 53C are AFM diagrams for the inorganic resist master according to Example 28;
Fig. 54 is a graph showing the relationship between the amount of dropwise addition of hydrochloric acid and the pH as well as conductivity in Example 28;
Fig. 55A to Fig. 55C are AFM diagrams for the inorganic resist master according to Example 29;
Fig. 56 is a graph showing the relationship between the amount of dropwise addition of hydrochloric acid and the pH as well as conductivity in Example 29;
Fig. 57A to Fig. 57C are AFM diagrams for the inorganic resist master according to Example 30;
Fig. 58 is a graph showing the relationship between the amount of dropwise addition of hydrochloric acid and the pH as well as conductivity in Example 30;

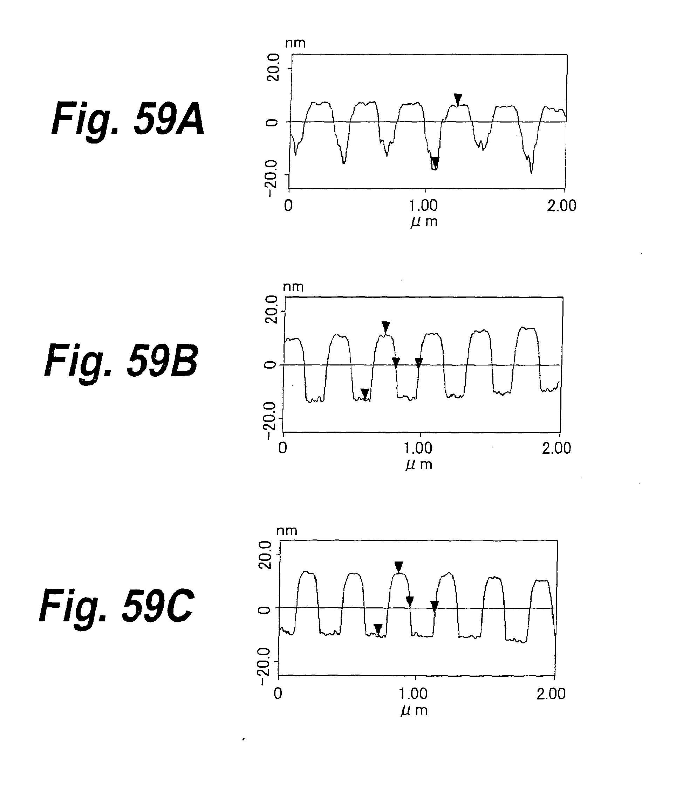

Fig. 59A to Fig. 59C are AFM diagrams for the inorganic resist master according to Example 31;

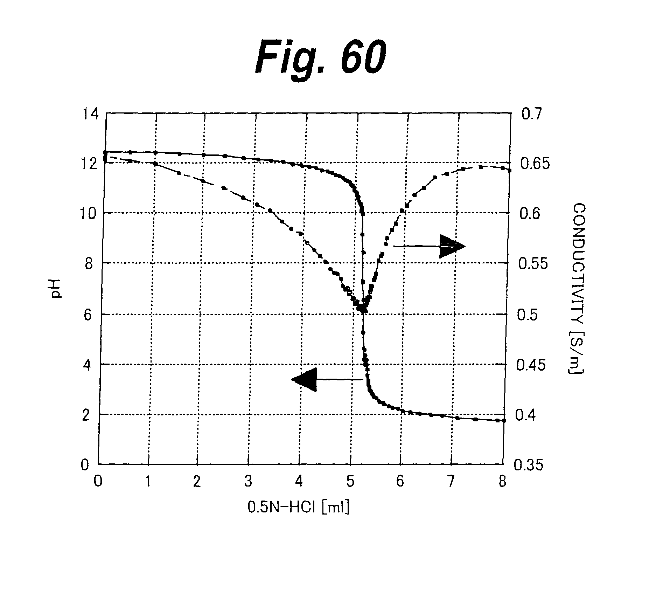

Fig. 60 is a graph showing the relationship between the amount of dropwise addition of hydrochloric acid and the pH as well as conductivity in Example 31;

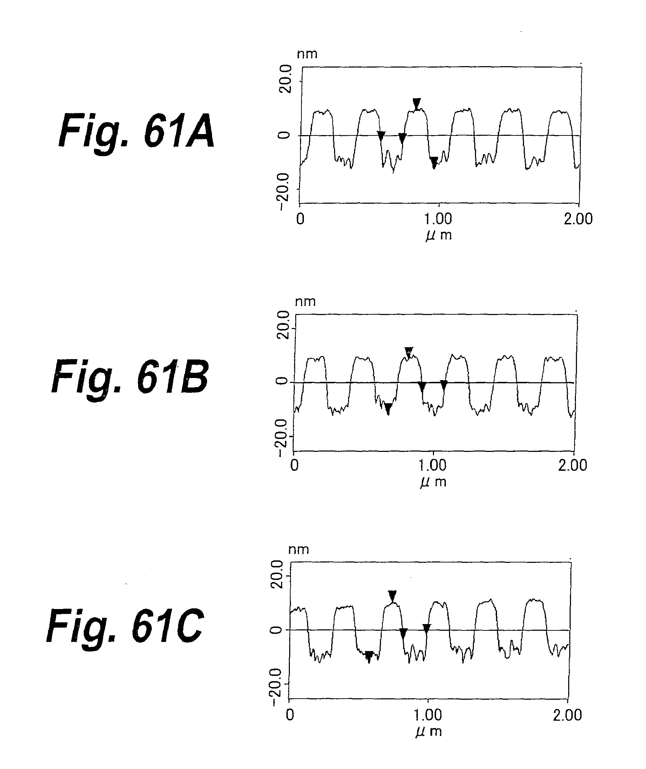

Fig. 61A to Fig. 61C are AFM diagrams for the inorganic resist master according to Example 32;

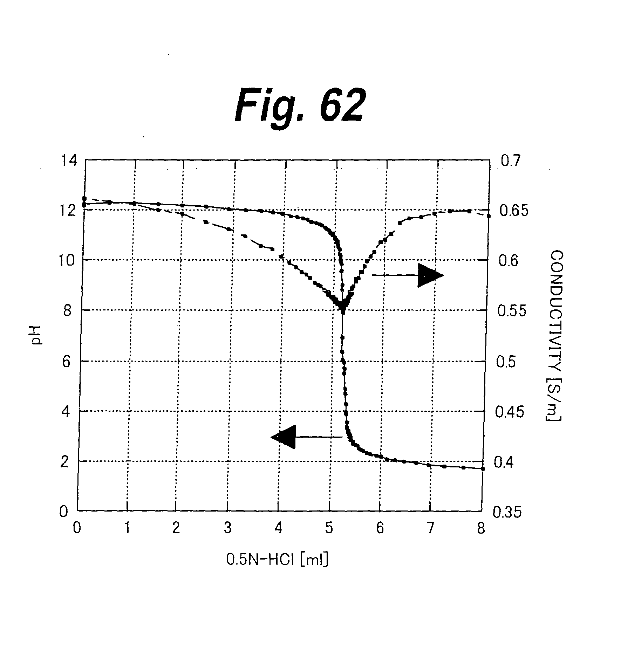

Fig. 62 is a graph showing the relationship between the amount of dropwise addition of hydrochloric acid and the pH as well as conductivity in Example 32;

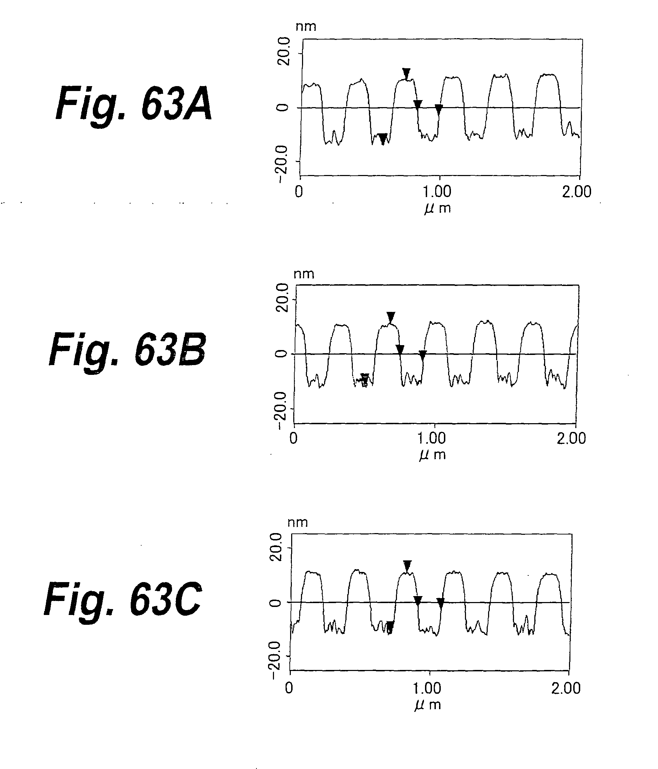

Fig. 63A to Fig. 63C are AFM diagrams for the inorganic resist master according to Example 33;

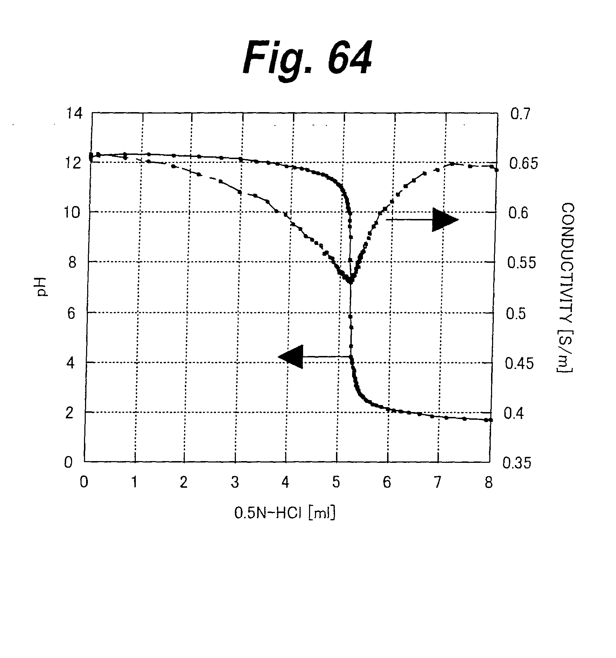

Fig. 64 is a graph showing the relationship between the amount of dropwise addition of hydrochloric acid and the pH as well as conductivity in Example 33;
Fig. 65A to Fig. 65C are AFM diagrams for the inorganic resist master according to Example 34;
Fig. 66 is a graph showing the relationship between the amount of dropwise addition of hydrochloric acid and the pH as well as conductivity in Example 34;
Fig. 67A to Fig. 67C are AFM diagrams for the inorganic resist master according to Example 35;
Fig. 68 is a graph showing the relationship between the amount of dropwise addition of hydrochloric acid and the pH as well as conductivity in Example 35;
Fig. 69 is a graph showing the relationship between the amount of incorporation of a development accelerating agent and the development time in Example 36 to Example 38; and
Fig. 70 is a graph showing the relationship between the amount of incorporation of a development accelerating agent and the development time in Example 39 to Example 42.

### Best Mode for carrying out the Invention

Embodiments of the present invention will be described in the following order.

### (1) First embodiment

(1-1) Inorganic resist
(1-2) Developing solution
(1-3) Reaction mechanism of inorganic resist
(1-4) Reaction between inorganic resist and developing solution
(1-5) Method for producing resist master
(1-6) Method for monitoring developing solution

### (2) Second embodiment

(2-1) Developing solution
(2-2) Reaction between inorganic resist and developing solution

### (3) Third embodiment

(3-1) Developing solution
(3-2) Reaction between inorganic resist and developing solution

### (1) First embodiment

### (1-1) Inorganic resist

First, the inorganic resist used in the first embodiment of the present invention will be described.

In photolithography, inorganic resists are known to have high thermal stability compared to organic resists, and markedly high γ property is easily obtained therewith. For example, organic resists such as polystyrene (PS), polymethyl methacrylate (PMMA), polyglycidyl methacrylate-chlorostyrene copolymer (GMC), poly(butene-1-sulfone) (PBS), and phenyl formaldehyde novolac, typically can only give a γ property of 3 or less after development, in the case of using ultraviolet radiation, as well as even in the case of using a finely converged electron beam, ion beam or the like. In addition, γ = 1/(log δ1 - log δ0) (wherein δ0: the minimum amount of exposure required for photosensitizing the resist, and δ1: the amount of exposure required to completely photosensitize the resist). This is because, since organic resists have large molecular weights, the boundaries between the exposed parts and the unexposed parts become indefinite. On the other hand, inorganic resists which are made of chalcogenide glass, a metal oxide or the like, can give a γ property of greater than 4, and sometimes a γ property which would exceed 8. Therefore, the inorganic resists allow steeper taper angles to be obtained, as compared to the organic resists.

In regard to the metal oxide, any material can be used in accordance with the process for producing a desired shape on the base material. As for specific examples thereof, titanium monoxide (TiO), titanium dioxide (TiO₂), barium titanate (BaTiO₃), tungsten trioxide (WO₃), tungsten dioxide (WO₂), tungsten monoxide (WO), molybdenum trioxide (MoO₃), molybdenum dioxide (MoO₂) , molybdenum monoxide (MoO), vanadium pentoxide (V₂O₅), vanadium tetroxide (V₂O₄), vanadium trioxide (V₂O₃), bismuth oxide (Bi₂O₃), cerium oxide (CeO₂), copper oxide (CuO), niobium pentoxide (Nb₂O₅), stibium oxide (antimony oxide: Sb₂O₃), silicon monoxide (SiO), gadolinium oxide (Gd₂O₃), tantalum oxide (Ta₂O₅), yttrium oxide (Y₂O₃), nickel oxide (NiO), samarium oxide (Sm₂O₃), iron oxide (Fe₂O₃), tin oxide (SnO₂), aluminum oxide (Al₂O₃), silicon dioxide (SiO₂), chromium oxide (Cr₂O₃), zinc oxide (ZnO), indium oxide (In₂O₃), zirconium oxide (ZrO₂), magnesium oxide (MgO), barium sulfate (BaSO₄), calcium sulfate (CaSO₄), calcium carbonate (CaCO₃), calcium silicate (CaSi₂O₅), magnesium carbonate (MgCO₃), lithium carbonate (Li₂CO₃), sodium carbonate (Na₂CO₃), cobalt carbonate (CoCO₃), strontium carbonate (SrCO₃), nickel carbonate (Ni₂CO₃), bismuth carbonate ((BiO)₂CO₃), aluminum phosphate (AlPO₄), barium hydrogen phosphate (BaHPO₄) , lithium phosphate (Li₃PO₄), zinc citrate (Zn₃(C₆H₅O₇)₂), zinc borate (2ZnO · 3B₂O₃), barium borate (BaB₄O₇), uranium oxide (U₃O₈), and the like may be mentioned as examples.

Among these, as the inorganic resist which causes a difference in solubility in the developing solution (selection ratio) under the effect of active energy rays such as laser, electron beam, ion beam, hydrogen plasma, ultraviolet radiation, visible radiation and infrared radiation, those containing, as the metallic element in the metal oxide, tungsten (W), molybdenum (Mo), vanadium (V), tantalum (Ta), iron (Fe), nickel (Ni), copper (Cu), titanium (Ti), ruthenium (Ru), silver (Ag), zinc (Zn), aluminum (Al), thallium (Tl), boron (B), germanium (Ge), niobium (Nb), silicon (Si), uranium (U), tellurium (Te), bismuth (Bi), cobalt (Co), chromium (Cr), tin (Sn), zirconium (Zr) or manganese (Mn), are known. Even among these, tungsten (W), molybdenum (Mo), vanadium (V), tantalum (Tl) and iron (Fe) can be used as the metallic element, and in particular, metal oxides containing tungsten (W), molybdenum (Mo) and vanadium (V) are suitably used as the inorganic resist layer.

As for the method for forming the inorganic resist layer, there can be used, as dry methods, CVD methods (Chemical Vapor Deposition: a technology of precipitating a thin film from a gas phase by utilizing a chemical reaction) such as thermal CVD, plasma CVD and photo CVD, as well as PVD methods (Physical Vapor Deposition: a technology of forming a thin film by physically aggregating a vaporized material on a substrate in vacuo) such as vacuum deposition, plasma-assisted deposition, sputtering and ion plating. Also, as wet methods, there can be used coating methods such as bar coating, spin coating and screen printing, as well as the LB (Langmuir Blodgett) method, chemical precipitation, anodic oxidation, electrolytic precipitation, and the like.

The compositional ratio of oxygen (0) to the metallic element is not necessarily required to be stoichiometric, and any value can be taken within the range up to the maximum oxidation number that can be adopted by the metallic element. For example, in the case of tungsten oxide, WOₓ can take any value of x within the range of 0 < x ≤ 3.

The method of adjusting the amount of oxygen which constitutes the metal oxide to be used as the inorganic resist, can be appropriately selected in accordance with the respective film forming methods. For example, in the case of performing film formation by a sputtering method, a method of forming a film by subjecting a metal target which does not contain oxygen, to reactive sputtering with a gas containing oxygen; a method of forming a film by sputtering a target formed from a metal oxide having controlled oxygen content, with an inert gas; and the like can be employed.

### (1-2) Developing solution

Next, the developing solution used for developing the above-described inorganic resist will be described.

The developing solution according to the first embodiment of the present invention is a method of adding, to an alkaline aqueous solution, an element and/or compound which is reactive with this alkaline aqueous solution, producing a salt having a development accelerating action (development accelerating agent) in the system, and if necessary, removing the residues by a method such as filtration, to obtain a developing solution. Hereinafter, the development accelerating agent and the alkaline aqueous solution will be described in sequence.

### (Development accelerating agent)

As for the element or compound of which the reaction product with an alkaline aqueous solution manifests a development accelerating action, for example, the following may be mentioned.

Examples of the element which directly reacts with an alkaline aqueous solution, include amphoteric elements such as aluminum (Al), zinc (Zn), tin (Sn) and lead (Pb), or silicon (Si) and the like.

Examples of the compound which acts as an acid in an alkaline aqueous solution, include weakly basic compounds, acidic oxides, amphoteric oxides, amphoteric hydroxides, amphoteric electrolytes, and the like.

The weakly basic compounds refer to compounds which exhibit basicity when dissolved in an aqueous solution, but react with strong alkalis such as hydroxides, and for example, ammonium hydrogen carbonate ((NH₄)HCO₃), tetramethylammonium hydrogen carbonate ([(CH₃)₄N]HCO₃), tetraethylammonium hydrogen carbonate ([(C₂H₅)₄N]HCO₃), tetrapropylammonium hydrogen carbonate ([(C₃H₇)₄N]HCO₃), lithium hydrogen carbonate (LiHCO₃), sodium hydrogen carbonate (NaHCO₃), potassium hydrogen carbonate (KHCO₃), sodium hydrogen phosphite (NaHPHO₃), disodium hydrogen phosphate (Na₂HPO₄), sodium dihydrogen phosphate (NaH₂PO₄), dipotassium hydrogen phosphate (K₂HPO), potassium dihydrogen phosphate (KH₂PO₄), diammonium hydrogen phosphate ((NH₄)₂HPO₄), ammonium dihydrogen phosphate (NH₄H₂PO₄), ammonium lithium hydrogen phosphate ((NH₄)LiHPO₄), ammonium sodium hydrogen phosphate ((NH₄)NaHPO₄), ammonium potassium hydrogen phosphate ((NH₄)KHPO₄), diethylammonium dihydrogen phosphate (C₄H₁₁N · H₂PO₄), tetrabutylammonium dihydrogen phosphate ([CH₃(CH₂)₃]₄NH₂PO₄], ammonium hypophosphite (NH₄PH₂O₂), sodium hypophosphite (NaPH₂O₂), and the like may be mentioned.

As the acidic oxides, for example, carbon dioxide (CO₂), silicon dioxide (SiO₂), chromium (VI) oxide (CrO₃), phosphorus (V) oxide (P₂O₅), boron oxide (B₂O₃), gallium (III) oxide (Ga₂O₃), sulfur dioxide (SO₂), sulfur trioxide (SO₃), nitrogen dioxide (NO₂), nitrogen trioxide (NO₃), tungsten trioxide (WO₃), manganese trioxide (MnO₃), vanadium pentoxide (V₂O₅), vanadium tetroxide (V₂O₄), germanium oxide (GeO₂), boric acid (H₃BO₃), phosphoric acid (H₃PO₄), phosphorous acid (H₃PO₃), hypophosphorous acid (H₃PO₂), and the like may be mentioned.

As the amphoteric oxides, for example, aluminum oxide (Al₂O₃), arsenic oxide (As₂O₃), zinc oxide (ZnO), lead oxide (PbO), tin oxide (SnO), chromium (III) oxide (Cr₂O₃), and the like may be mentioned.

As the amphoteric hydroxides, for example, aluminum hydroxide (Al(OH)₃), zinc hydroxide (Zn(OH)₂), tin hydroxide (Sn(OH)₂), lead hydroxide (Pb(OH)₂), and the like may be mentioned.

As the amphoteric electrolytes, there may be mentioned those compounds which simultaneously have a basic group (-NH₂) and an acidic group (-COOH) in one molecule, such as amino acids.

When solutions obtained by dissolving these elements or compounds in an alkaline aqueous solution or by reacting the elements or compounds with an alkaline aqueous solution, are titrated with an acid, in many cases, a point of neutralization appears, which is different from the point of neutralization of the alkali source. These generally act as a buffering agent with respect to the acid, and in the titration curves (pH), the points of neutralization of the development accelerating agent and the acid often appear as an inflection point accompanied by a gentle curve. As will be described later, these additives, or the reaction products of the additives and the alkali source, are believed to have strong affinity to WO₃, MoO₃ and the like, which are the dissoluble components of inorganic resist materials, and since the additives or the reaction products have an effect of enhancing the solubility of the dissoluble components of the inorganic resist in the developing solution, the additives or the reaction products are speculated to act as development accelerating agents. The suitable amount of incorporation of these elements or compounds which are used as the development accelerating agents, into the developing solution, can be appropriately adjusted and determined according to the desired rate of development. Furthermore, these elements or compounds can be used individually alone, and also as mixtures of two or more species.

Here, even those elements which react with an alkaline aqueous solution may often require time to be completely dissolved and to undergo a reaction. Furthermore, the acidic oxides, amphoteric oxides and amphoteric hydroxides do not necessarily have high solubility in alkaline aqueous solutions. For this reason, in the case of using these as the development accelerating agent, the time for preparing the developing solution can be shortened by a method of accelerating dissolution by a method such as heating or ultrasonic irradiation, as well as by a method of adding an excess amount, allowing the mixture to stand for a certain time, and removing the portion remaining after dissolution by a method such as filtration, before use. Alternatively, there can be used a method of preparing in advance a liquid obtained by dissolving the additives in an alkaline aqueous solution, and adding this liquid to anew alkaline aqueous solution to dilute the liquid.

### (Alkaline aqueous solution)

The alkaline aqueous solution is not particularly limited, and any base which would even dissolve in water can also be used. As for the type of the alkaline compound which serves as the alkali source, there can be used inorganic alkali compounds such as lithium hydroxide, sodium hydroxide (NaOH), potassium hydroxide (KOH), ammonium hydroxide (NH₄OH), lithium phosphate (Li₃PO₄), trisodium phosphate (Na₃PO₄), disodium hydrogen phosphate (Na₂HPO₄), sodium dihydrogen phosphate (NaH₂PO₄), tripotassium phosphate (K₃PO₄), dipotassium hydrogen phosphate (K₂HPO₄), potassium dihydrogen phosphate (KH₂PO₄), triammonium phosphate ((NH₄)₃PO₄), diammonium hydrogen phosphate ((NH₄)₂HPO₄), ammonium dihydrogen phosphate (NH₄H₂PO₄), ammonium lithium hydrogen phosphate ((NH₄)₂HPO₄), ammonium sodium hydrogen phosphate ((NH₄)NaHPO₄), ammonium potassium hydrogen phosphate ((NH₄)KHPO₄), sodium carbonate (Na₂CO₃), sodium hydrogen carbonate (NaHCO₃), potassium carbonate (K₂CO₃), potassium hydrogen carbonate (KHCO₃), ammonium carbonate ((NH₄)₂CO₃), ammonium hydrogen carbonate ((NH₄)HCO₃), sodium borate (Na₂B₄O₇), potassium borate (K₂B₄O₇), ammonium borate (((NH₄)₂B₄O₇), sodium silicate (Na₂SiO₃), potassium silicate (K₂SiO₃), ammonium silicate ((NH₄)₂SiO₃), tetramethylammonium silicate ([(CH₃)₄N]₂SiO₃), tetraethylammonium silicate ([(C₂H₅)₄N]₂SiO₃), tetrapropylammonium silicate ([(C₃H₇)₄N]₂SiO₃), tetrabutylammonium silicate ([(C₄H₉)₄N]₂SiO₃), and ammonia water (NH₄OH); as well as organic alkali compounds such as monomethylamine (CH₃NH₂), dimethylamine ((CH₃)₂NH), trimethylamine ((CH₃)₃N), monoethylamine (C₂H₅NH₂), diethylamine ((C₂H₅)₂NH), triethylamine ((C₂H₅)₃N), monoisopropylamine (C₃H₇NH₂), diisopropylamine ((C₃H₇)₂NH), triisopropylamine ((C₃H₇)₃N), n-butylamine (C₄H₉NH₂), monoethalamine (NH₂(C₂H₄OH)), diethanolamine (NH(C₂H₄OH)₂), triethanolamine (N(C₂H₄OH)₃), monoisopropanolamine (NH₂(C₃H₇OH)), diisopropanolamine (NH(C₃H₇OH)₂), tetramethylammonium hydroxide ((CH₃)₄NOH), tetraethylammonium hydroxide ((C₂H₅)₄NOH), tetrapropylammonium hydroxide ((C₃H₇)₄NOH), tetrabutylammonium hydroxide ((C₄H₉)₄NOH), and choline ((CH₃)₃N (OH) CH₂CH₂OH). These can be used individually alone, or as mixtures of two or more species. The concentration of alkali is not particularly limited, but when the developing solution is titrated with an acid while development accelerating agents have been added, it is necessary that the developing solution have a pH value higher than all of the points of neutralization of the development accelerating agents. In general, it is desirable to adjust the concentration of the alkali source so that pH 10 or higher, and preferably pH 12 or higher, is obtained. In regard to the alkali aqueous solution in which these alkali sources have been dissolved, if a solution having a development time which is long to a certain extent, while not having development accelerating agents incorporated thereinto, is used, the scope of the adjustment of the development time by means of development accelerating agents is broadened, and thus it becomes easy to set the development time as desired, as well as it becomes easy to secure a margin for the development time. In this regard, it is preferable to employ water-soluble ammonium compounds such as tetramethylammonium hydroxide, ammonia water, tetraethylammonium hydroxide, tetrabutylammonium hydroxide and tetra-n-propylammonium hydroxide as an alkali source.

Generally, with regard to the organic resists, when pH is high, the penetrating power into the resist becomes stronger, and the organic resists frequently cause problems such as detachment. However, the inorganic resists have a smaller risk of penetration such as permeation through the film. Therefore, it is possible to use the developing solution at high pH, so as to extend the use life of the developing solution.

Here, the metal oxide part of the inorganic resist which is dissolved as a result of development, for example, WO₃, is solvated in the alkaline aqueous solution. As for the form of solvate, structures such as sodium phosphotungstate ·n hydrate (Na₃PO₄ ·12WO₃ ·nH₂O), ammonium phosphotungstate ·n hydrate (2(NH₄)₃PO₄ ·12WO₃ ·nH₂O), ammonium tungstate ·pentahydrate (5(NH₄)₂O ·12WO₃ ·5H₂O), and sodium tungstate (VI) ·dihydrate (Na₂WO₄ ·2H₂O), are known as stable compounds. Thus, it is conceived that development proceeds when the alkali source directly acts on the dissoluble components (acid components) such as WO₃ in the inorganic resist, and is hydrated.

The developing solution can be used, with appropriate surfactants, organic solvents, defoaming agents and the like being incorporated therein, for the purpose of enhancing the wettability of the inorganic resist, or defoaming. The temperature of the developing solution is not particularly limited, but in order to adjust the dissolution rate of the thin film, the temperature can be appropriately adjusted.

### (1-3) Reaction mechanism of inorganic resist

Next, the speculative reaction mechanism of the inorganic resist will be explained.

In the case of using a metal oxide as a thermosensitive inorganic resist, it is thought that local thermal expansion at the site of laser irradiation of the resist film, redistribution of oxygen (oxidation/reduction reaction) between the molecules constituting the inorganic resist, and release of oxygen gas due to decomposition of the metal oxide occur all at the same time. Furthermore, due to an increase in the rapid molecular vibration which is caused by localized strong heating for a short time, instantaneous volume expansion and chemical reactions occur at the site of laser irradiation, and fine cracks are generated.

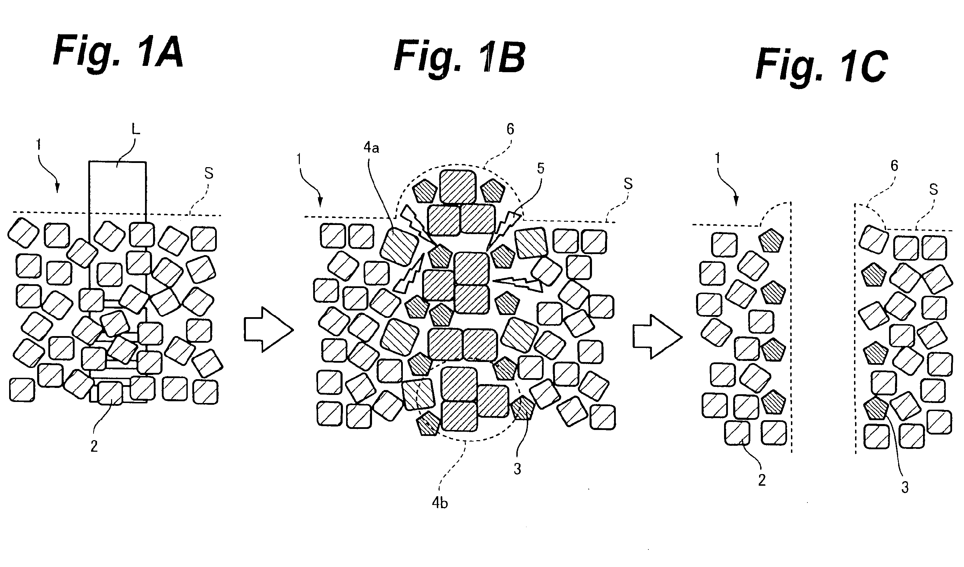

Hereinafter, the speculative reaction mechanism of the inorganic resist will be described with reference to Fig. 1.

When the inorganic resist 1 is irradiated with laser radiation L (see Fig. 1A), among the molecules 2 (for example, amorphous MO_{1.5}) strongly heated by the irradiation of laser radiation L, some of them release oxygen to become reduced bodies 3 (for example, amorphous WO), while some of them accept the oxygen to become oxidized bodies 4a (for example, amorphous WO₃) or oxidized bodies 4b (for example, crystalline WO₃) (see Fig. 1B). In the metal oxides used as the inorganic resist, such as tungsten oxide (WOₓ, 0 < x ≤ 3) or molybdenum oxide (MoOₓ, 0 < x ≤ 3), a compound having a high oxidation level (x is large) has high alkali solubility, while a compound having a low oxidation level (x is small) has low alkali solubility. Therefore, at the site of irradiation with laser radiation, the oxidized parts have improved alkali solubility, while the reduced parts have decreased alkali solubility. As such, when a mixture in which the oxidation product and the reduction product are co-present, is subjected to development by means of alkali development, the acidic product is dissolved, and the reduction product which has been dispersed therein is also eliminated together (see Fig. 1C). As a result, it is thought that the entire site which has induced the oxidation/reduction reaction is developed, and a shape pattern is formed.

During the oxidation/reduction reaction, the reduced bodies 3 have their volume reduced as compared to the original molecules, while the oxidized bodies 4a and 4b have the volume increased. Here, to take an example of the specific weights of metal oxides, crystalline W₃O: 14.7 g/cm³, crystalline WO₂: 10.8 g/cm³, crystalline WO₃: 7.2 g/cm³, amorphous WO₃: 6.8 g/cm³, crystalline MoO₂: 6.5 g/cm³, and crystalline MoO₃: 4.7 g/cm³, and thus, as oxidation progresses, the specific weight is decreased (the volume is increased). Also, when the formed amorphous metal oxide layer is heated by irradiation with laser radiation, a large number of crystalline particles are generated in and around the laser irradiated parts. Here, when amorphous particles and crystalline particles are compared in terms of the alkali solubility, in the case of compounds of the same oxidation level, for example, between WO₃, the portion which does not form crystalline lattices, that is, the amorphous particles, dissolves in alkali within a shorter time than crystals. On the other hand, this property is utilized in the formation of patterns of negative type resist. It is contemplated that the simultaneous occurrence of such increase and decrease of volume and the generation of crystalline particles in a short time, is also causative of crack generation.

It is also contemplated that the oxygen released as a result of decomposition of metal oxide by strong heating, enlarge the cracks 5, or produce voids between crystals. Here, in regard to the metal oxide such as tungsten oxide (WOₓ, 0 < x ≤ 3) or molybdenum oxide (MoOₓ, 0 < x ≤ 3), a compound having a relatively high oxidation level, for example, with x being 2 or greater, is thought to be associated with a higher proportion of oxygen gas generated due to the heating by irradiation with laser radiation, and this is believed to cause enlargement of cracks 5 or production of voids between crystals, thereby inducing large expansion of the volume (Fig. 1B, bulge 6). For this reason, the bulge at the edge part of the shape pattern obtained after development (Fig. 1C, bulge 6) also becomes larger. On the other hand, a compound having a relatively low oxidation level, for example, with x being less than 2, is thought to be associated with a smaller amount of generation of oxygen gas. Therefore, the volume expansion at the site of irradiation with laser radiation is also diminished, and the bulge at the edge part of the shape pattern obtained after development (Fig. 1C, bulge 6) also becomes smaller.

The generated cracks 5 or the voids between crystals are thought to contribute in enhancing the effect of making the developing solution to penetrate into the inside. Thus, the more the metal oxide with higher oxidation level is used, the further the alkali solubility is enhanced.

Furthermore, in the case of forming an inorganic resist layer formed from a metal oxide on a base material, it is preferable to appropriately form a foundation layer aiming for heat storage (heat storage layer) on the base material, and to form the inorganic resist layer thereon. It is because the exposure sensitivity can be increased.

### (1-4) Reaction between inorganic resist and developing solution

Next, the speculative reaction between the inorganic resist material and the developing solution will be described.

The inorganic resist corresponds to an inorganic compound having a low molecular weight and adopting an amorphous or crystalline form. Therefore, in the development of the inorganic resist, a relatively simple neutralization reaction in which these inorganic resist molecules and the alkali component of the developing solution react, is the main process. Therefore, it is possible to shorten the development time by adding a compound having a reaction accelerating action or a catalytic action, or the like into the developing solution.

Although the mechanism by which the compound added to the alkaline aqueous solution accelerates the reaction is not clear, it is speculated to be approximately as follows.

The compound added to the alkaline aqueous solution reacts with the alkali source and forms a salt. For example, when silicon (Si), carbon dioxide gas (CO₂) and tetramethylammonium hydrogen carbonate ([(CH₃)₄N]HCO₃) are dissolved in an aqueous solution of tetramethylammonium hydroxide ((CH₃)₄N ·OH), they respectively form salts such as tetramethylammonium metasilicate ([(CH₃)₄N]₂O ·SiO₂) and tetramethylammonium carbonate ([CH₃)₄N]₂CO₃) by the reactions such as follows.

Si + 2(CH₃)₄N ·OH + H₂O → [(CH₃)₄N]₂O ·SiO₂ + H₂ ↑

CO₂ + 2(CH₃)₄N ·OH → [(CH₃)₄N]₂CO₃ + H₂O

[(CH₃)₄N]HCO₃ + (CH₃)₄N · OH → [(CH₃)₄N]₂CO₃ + H₂O

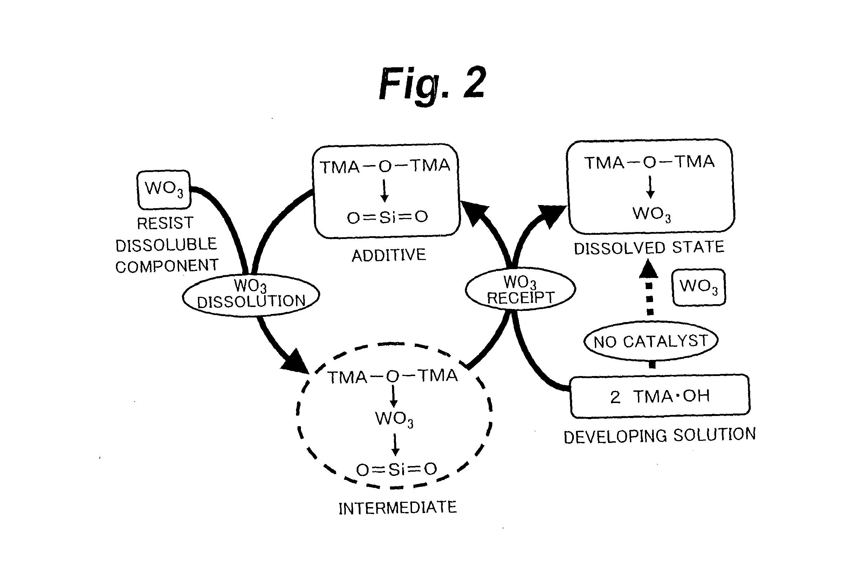

In the following, the speculative development mechanism of the inorganic resist will be described, with reference to Fig. 2, by taking the case in which tetramethylammonium metasilicate is produced in an aqueous solution of tetramethylammonium hydroxide, as an example. Here, in Fig. 2, description of water molecules is omitted. Also, in Fig. 2, "TMA" indicates (CH₃)₄N.

It is conceived that, in the developing solution, tetramethylammonium metasilicate forms a kind of intermediate with an acidic substance (MO₃) which has been produced in the inorganic resist as a result of the latent image formation of the inorganic resist. Since a structure such as silicotungstic acid (SiO₂ ·12WO₃ ·26H₂O) or sodium tungstate (VI) dihydrate (Na₂WO₄ ·2H₂O) exists as a water-soluble, stable compound, it is thought that the intermediate also forms a bond between WO₃ and SiO₂, and between WO₃ and (CH₃)₄N ·OH or (CH₃)₄N ·O ·N(CH₃)₄. Subsequently, this intermediate is hydrated, and seeps out into the developing solution. Furthermore, this solvate delivers WO₃ to tetramethylammonium hydroxide ((CH₃)₄N ·OH), which is the alkali source in the developing solution, to separate from SiO₂, and SiO₂ in turn becomes able to form an intermediate with WO₃ of the inorganic resist. The WO₃ seeped out from the inorganic resist is speculated to be solvated in the solvent in a form such as [(CH₃)₄N]₂O ·WO₃. Thus, it is speculated that the added salts are repeatedly used as a medium which delivers WO₃ from the inorganic resist to the alkali source in the developing solution, almost without being consumed. That is, it is speculated that there exists a mechanism in which SiO₂ acts as a kind of catalyst. When the development accelerating agent is tetramethylammonium carbonate, CO₂ serves as the catalyst. It is conceived that because of such mechanism, as is the case of conventional methods, a constant rate of development is maintained by replenishing the worn out developing solution with a new developing solution or alkali. Therefore, when a compound which brings about such catalytic action is incorporated into the developing solution as a development accelerating agent, and the development time is set to be constant from the beginning, the developing solution may maintain a stable rate of development all the time.

When a developing solution incorporated with a development accelerating agent is titrated with an acid such as hydrochloric acid, in many cases, the points of neutralization of the development accelerating agent and the acid appear as an inflection point accompanied by a gentle curve in the titration curve (pH). It is conceived that within this region, the neutralization reaction proceeds while the development accelerating agent acts as a kind of buffering agent to the acid. If the developing solution is prepared such that its pH is higher than the point of neutralization of the alkali source of the developing solution and all of the points of neutralization, the development accelerating agent exerts action on the acid components such as WO₃ which has been generated at the site of laser irradiation of the inorganic resist. Therefore, it is necessary to establish the pH of the developing solution to be higher than the point of neutralization of the alkali source of the developing solution and all of the points of neutralization of the development accelerating agents.

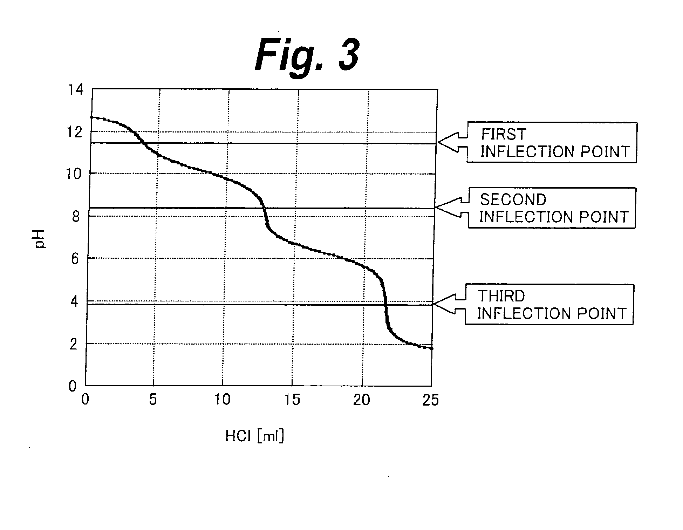

Fig. 3 shows a titration curve (pH) obtained when a developing solution prepared by dissolving tetramethylammonium carbonate in an aqueous solution of tetramethylammonium hydroxide, was titrated with dilute hydrochloric acid. The reactions occurring in the respective regions of the titration curve ₍pH) are speculated to be as follows.

To first inflection point: [(CH₃)₄N ·O]₃COH + HCl → [(CH₃)₄N]₂CO₃ + [(CH₃)₄N]Cl + H₂O

First to second inflection point: [(CH₃)₄N]₂CO₃ + HCl → (CH₃)₄NHCO₃ + [(CH₃)₄N]Cl

Second to third inflection point: (CH₃)₄NHCO₃ + HCl → [(CH₃)₄N]Cl + H₂O + CO₂

A substance which acts as an acid to the alkali source of the developing solution, reacts therewith to form a solvate, and manifests a buffering action in the alkaline region, can also act as a development accelerating agent. For example, WO₃, which is also a dissoluble component in the inorganic resist, is thought to be in a solvated state in an aqueous solution of (CH₃)₄N ·OH, which is a developing solution, to a structure such as [(CH₃)₄N]₂O ·WO₃ ·nH₂O. When the product obtained by dissolving WO₃ in an aqueous solution of (CH₃)₄N ·OH is titrated with hydrochloric acid, an inflection point accompanied by a gentle curve appears near pH 11, in addition to the point of neutralization of (CH₃)₄N ·OH, which appears near pH 7. This shows an end point of the neutralization reaction between the reactants of the development accelerating agent and the alkali source, and hydrochloric acid. Similarly to the case of [(CH₃)₄N]₂O ·SiO₂ or [(CH₃)4N]₂O ·CO₃, it is speculated that a solvate such as [(CH₃)₄N]₂O ·WO₃ ·nH₂O itself acts on WO₃, which is an acidic substance in the inorganic resist. It is thought that the solvate which acts as the development accelerating agent as such, is repeating a cycle such as of trapping WO₃ in the inorganic resist to elute it into the developing solution, and then delivering WO₃ to the alkali source of the developing solution. The phenomenon in which the rate of development keeps increasing while the development of the resist master which makes use of WOₓ (0 < x ≤ 3) as the inorganic resist, is repeated, is presumed to be the result of WO₃ acting in such manner as a kind of autocatalyst.

As such, an element or compound which forms a reaction product or a coordination product in the alkaline aqueous solution, can be used as a development accelerating agent, if the element or compound is capable of manifesting a pH buffering action in the alkaline region. A developing solution formed by adding such element or compound shows, when titrated with an acid, a region indicating the neutralization reaction of the acid by additives, in the titration curve (pH). This frequently appears as an inflection point accompanied by a gentle curve in the titration curve (pH), and frequently appears as the minimum value in the titration curve (conductivity). In other words, it can be predicted before actually performing development, as to whether a salt or the like can be utilized as a development accelerating agent, by verifying whether such region would appear in the alkaline region through titration.

### (1-5) Method for producing resist master

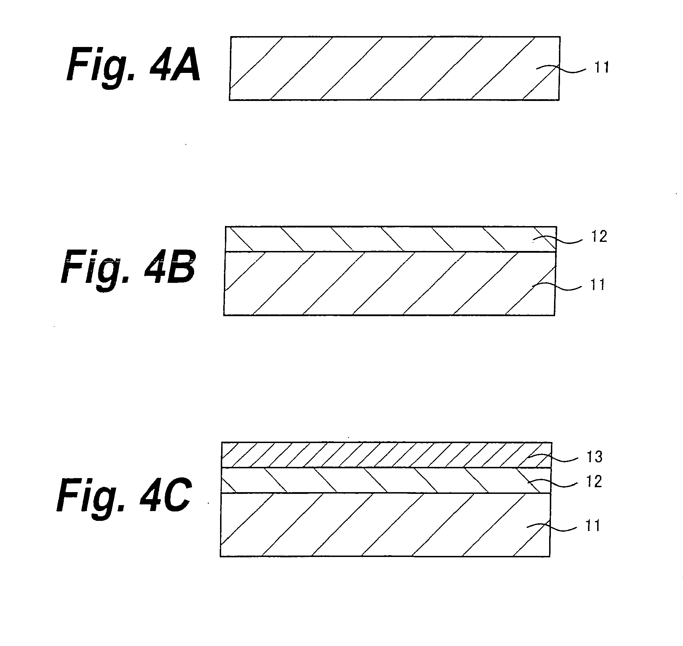

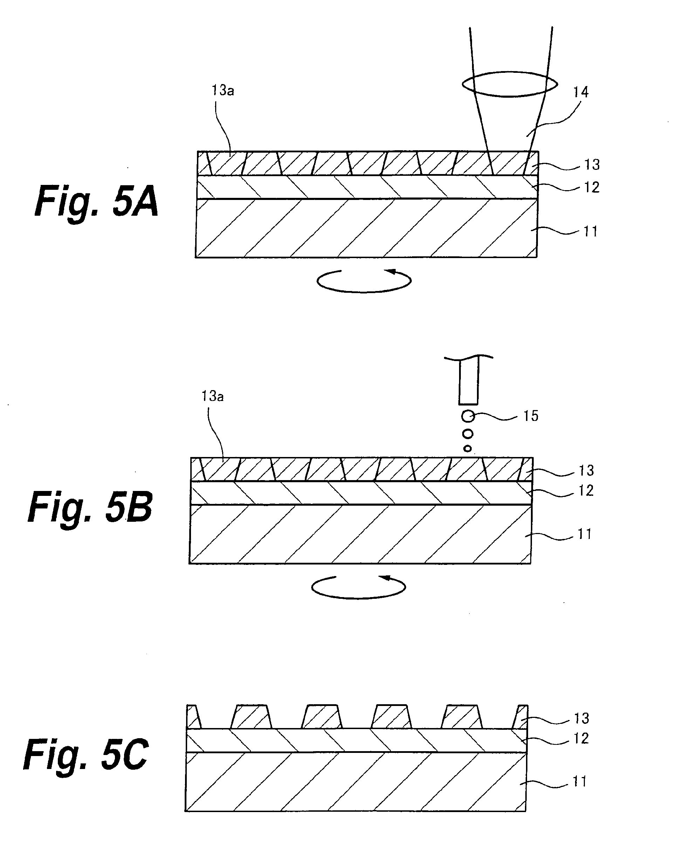

Next, an example of the method for producing a resist master by using the above-described inorganic resist and developing solution, will be described with reference to Fig. 4 and Fig. 5. This method for producing a master is suitable for the production method for a master for high density optical disk such as Blu-ray Disc (registered trademark). Furthermore, this method for producing a master is not intended to be limited to the optical disc type, but can also be used in the production of a master of any of the read-only type, the data addition type and the rewritable type.

To the alkaline aqueous solution, a development accelerating agent is added in an amount of incorporation that has been confirmed to be capable of obtaining stable development properties.

As shown in Fig. 4A, a flat and smooth substrate 11 made of, for example, silicon or the like, is produced. Then, according to necessity, as shown in Fig. 4B, a foundation layer 12 is formed on the substrate 11 by, for example, a sputtering method. As for the material constituting the foundation layer 12, for example, a mixture of zinc sulfide and silicon dioxide (ZnS-SiO₂ mixture), tantalum pentoxide (Ta₂O₅), titanium dioxide (TiO₂), amorphous silicon (a-Si), silicon dioxide (SiO₂), silicon nitride (SiN), and the like may be mentioned, and from the viewpoint of good exposure sensitivity, materials having high heat storability, such as a mixture of ZnS-SiO₂, tantalum pentoxide (Ta₂O₅), titanium dioxide (TiO₂) and silicon dioxide (SiO₂), are preferred. In the case of constituting the foundation layer 12 from a mixture of ZnS-SiO₂, the content of zinc sulfide (ZnS) is selected from the range of, for example, 70 mol% or more and 100 mol% or less, while the content of silicon dioxide (SiO₂) is selected from the range of, for example, 0 mol% or more and 30 mol% or less.

Subsequently, as shown in Fig. 4C, an inorganic resist layer 13 is formed on the foundation layer 12 by, for example, a sputtering method. The thickness of the inorganic resist layer 13 formed on the substrate 11 can be arbitrarily set, but it is necessary to set the value so that a desired depth of pit or groove may be obtained. For example, in the case of Blu-ray Disc (registered trademark), the thickness of the inorganic resist layer 13 is preferably in the range of 15 nm or more and 80 nm or less, and in the case of DVD-RW (Digital Versatile Disc-ReWritable), the thickness is preferably in the range of 20 nm or more and 90 nm or less.

Subsequently, as shown in Fig. 5A, the inorganic resist layer 13 is exposed over the entire surface, by rotating the substrate 11, and at the same time, irradiating the inorganic resist layer 13 with an exposure beam 14. Thereby, a latent image 13a corresponding to the land and the groove or pit of a desired optical disc, is formed over the entire surface of the inorganic resist layer 13.

Subsequently, the inorganic resist layer 13 is subjected to development, by adding dropwise a developing solution 15 onto the inorganic resist layer 13 while rotating the substrate 11, as shown in Fig. 5B. Thereby, as shown in Fig. 5C, a fine concavo-convex pattern is formed in a spiral form or concentric form, on the inorganic resist layer 13.

Thereby, a desired resist master is obtained.

As described above, according to the first embodiment of the present invention, by producing a salt which accelerates the elution of acid components of the inorganic resist, in the developing solution by means of a reaction with an alkaline aqueous solution, the development time can be shortened to a large extent, as compared to the developing solutions not containing this.

Also, by adjusting the amount of incorporation, the same development properties can be maintained throughout from the state of the developing solution being fresh.

### (1-6) Method for monitoring developing solution

The alkali residual amount in the developing solution, the presence or absence of development accelerating agent, absorption of carbon dioxide gas, dissolution of silicon wafer, and the like can be visually recognized by titrating with an acid such as hydrochloric acid. When a developing solution containing a development accelerating agent is titrated with an acid such as hydrochloric acid, if a titration curve is obtained by taking pH as an index, an inflection point accompanied by a gentle titration curve is obtained in many cases. However, since the pH value is a logarithmic indication, the difference in the change is likely to be obscure. In contrast to this, if a titration curve is obtained by taking conductivity as an index, since the minimum value at the part of pH inflection point is taken, the titration curve (conductivity) draws broad minimum regions at the parts between plural inflection points of a development accelerating agent.

According to the present invention, the developing solution is prepared such that the pH is set at a value higher than any of the point of neutralization of the alkali source of the developing solution and all of the points of neutralization of the development accelerating agent. Therefore, the time point where the first inflection point appears on the titration curve (pH), is taken as the lifespan of the developing solution required to obtain stable development conditions. Upon monitoring of the degree of deterioration of a developing solution which is in actual use, it becomes possible to obtain an index only by measuring the conductivity, and thus there is no need to go through sampling of the liquid and titration.

Hereinafter, the method for monitoring a developing solution, which takes conductivity as an index, will be described. First, the constitution of the apparatus used in the monitoring of a developing solution will be described. The monitoring apparatus includes a measuring unit for measuring conductivity of the developing solution; a memory unit for storing the value of conductivity of the developing solution which is judged to have come to the end of life, or the differential value (absolute value) of conductivity change; and a lifespan judging unit for comparing the value measured by the measuring unit with the value stored in the memory unit and determining whether the developing solution has come to the end of life.

Here, before monitoring the developing solution, the following treatment is carried out in advance. First, the conductivity data of the developing solution are measured in advance. Then, based on these data, the conductivity value indicating the lifespan of the developing solution, or the differential value (absolute values) of conductivity change is determined, and this value is stored in the memory unit of the monitoring apparatus.

Subsequently, the method for monitoring a developing solution by using the above-described monitoring apparatus, will be described. First, the monitoring apparatus measures conductivity of the developing solution used in the development of an inorganic resist. Subsequently, the monitoring apparatus compares the measured value of conductivity or the differential value (absolute value) of conductivity change with the value stored in advance in the memory unit, and determines whether the measured value of conductivity or differential value (absolute value) of conductivity change is equal to or less than the value stored in advance in the memory unit. In the case where it is determined that the measured value of conductivity or differential value (absolute value) of conductivity change is equal to or less than the value stored in advance in the memory unit, a picture notifying to the user that the developing solution has reached the end of life, is displayed on the display apparatus. It is also acceptable to have a sound notifying to the user that the developing solution has reached the end of life, to be outputted from a sound output unit. On the other hand, if it is determined that the measured conductivity is larger than the value of conductivity or the differential value (absolute value) of conductivity change, which has been stored in advance in the memory unit, measurement of conductivity is repeated again, and the above-described comparison and determination are repeated.

### (2) Second embodiment

The developing solution according to the second embodiment of the present invention is obtained by adding a development accelerating agent to an alkaline aqueous solution, or by adding a development accelerating agent which also serves as an alkali source, to water. Further explanation will be omitted by stating that this embodiment is similar to the first embodiment described above, except for the developing solution and the reaction between the inorganic resist and the developing solution.

### (2-1) Developing solution (development accelerating agent)

As for the salt to be added as a development accelerating agent, a compound having an ability to form an intermediate with the acidic substance, which is the dissoluble component from the inorganic resist, can be used, and in general, a salt formed from a weak acid and a strong base can be used.

As for the development accelerating agent, for example, the salts shown below can be used.

As for silicates, for example, lithium silicate (Li₂SiO₃), potassium silicate (K₂SiO₃), sodium silicate (Na₂SiO₃), ammonium silicate ((NH₄)₂SiO₃), tetramethylammonium silicate ([(CH₃)₄N]₂SiO₃), tetraethylammonium silicate ([(C₂H₅)₄N]₂SiO₃), tetrapropylammonium silicate ([(C₃H₇)₄N]₂SiO₃), and the like may be mentioned. Here, the molecular formula of sodium silicate is represented particularly by Na₂O ·nSiO₂ ·xH₂O, and the value of this n is called as molar ratio, while the weight ratio (SiO₂/Na₂O) is represented by (SiO₂/Na₂O)×1.0315. Products with n = 0.5 to 4 are commercially available, and they are classified into n = 0.5 (sodium orthosilicate), n = 1 (sodium metasilicate), n = 2 (No.1 sodium silicate), n = 2.5 (No. 2 sodium silicate), n = 3 (No. 3 sodium silicate), and n = 4 (No. 4 sodium silicate). However, the value of n can be continuously changed.

As for carbonates, for example, tetramethylammonium carbonate ([(CH₃)₄N]₂CO₃), tetraethylammonium carbonate ([(C₂H₅)₄N]₂CO₃), tetrapropylammonium carbonate ([(C₃H₇)₄N]₂CO₃), ammonium carbonate ((NH₃)₂CO₃), potassium carbonate (K₂CO₃), sodium carbonate (Na₂CO₃), lithium carbonate (Li₂CO₃), and the like may be mentioned.

As for borates, for example, ammonium pentaborate ((NH₄)₂O ·5B₂O₃), ammonium tetraborate ((NH₄)₂ ·B₄O₇), potassium tetraborate (K₂B₄O₇), sodium tetraborate (Na₂B₄O₇), disodium tetraborate (Na₂B₄O₇), lithium borate (Li₂B₄O₇), sodium tetraphenylborate (NaB(C₆H₅)₄), ammonium borate ((NH₄)₂B₄O₇), potassium borate (K₂B₄O₇), triethanolamine borate (C₆H1₂NO₃B), sodium borate (Na₂B₄O₇), lithium borate (Li₂B₄O₇), and the like may be mentioned.

As for phosphates, for example, ammonium phosphotungstate (2(NH₄)₃PO₄ ·24WO₃), 12-tungsto (IV) phosphoric acid (H₃(PW₁₂O₄₀)), sodium tungstophosphate (Na₃(PO₄ ·12WO₃)), sodium tripolyphosphate (Na₅P₃O₁₀), sodium diphosphate (Na₄P₂O₇), pyrophosphoric acid (H₄P₂O₇), potassium pyrophosphate (K₄P₂O₇), tetrasodium pyrophosphate (Na₄P₂O₇), sodium pyrophosphate (Na₄P₂O₇), potassium metaphosphate ((KPO₃)ₙ), sodium metaphosphate ((NaPO₃)ₙ), lithium phosphate (Li₃PO₄), trisodium phosphate (Na₃PO₄), tripotassium phosphate (Ka₃PO₄), triammonium phosphate (((NH₄)₃PO₄), and the like may be mentioned.

A suitable amount of incorporation into a developing solution, of these salts which are used as development accelerating agents, can be appropriately adjusted and determined in accordance with the desired rate of development. These salts can also be used individually alone, or as mixtures of two or more species.

In regard to the alkaline aqueous solution, the explanation will be omitted by stating that the current embodiment is similar to the first embodiment described above.

### (2-2) Reaction between inorganic resist and developing solution

The developing solution according to the second embodiment is to add the salt described in the first embodiment, which is produced by a reaction with the alkali source in the alkaline aqueous solution, or a salt prepared apart therefrom, into the alkaline aqueous solution from the beginning as a development accelerating agent. According to this preparation method, the alkali source is not consumed in the preparation of the developing solution, and also, the concentration of the development accelerating agent can be controlled quantitatively. In regard to the reaction mechanism by which an inorganic resist is developed by the developing solution, the explanation will be omitted by stating that the current embodiment is the same as the first embodiment.

Here, for example, in the case of using an ammonium hydroxide compound such as tetramethylammonium hydroxide as the alkali source of the developing solution, and adding an alkali metal salt as the development accelerating agent, it is likely that the development accelerating action exerted by the alkali metal is given priority to the development accelerating action exerted by catalytic action. Therefore, if the alkali source of the developing solution is an ammonium hydroxide compound, the catalytic action can be effectively induced by excluding the alkali metal, such as by using a development accelerating agent in which the base component is the same ammonium salt as the alkali source. As a preferred combination, there may be mentioned an example of using tetramethylammonium metasilicate or tetramethylammonium carbonate as the development accelerating agent for an aqueous solution of tetramethylammonium hydroxide.

As discussed above, according to the second embodiment of the present invention, when a salt which accelerates elution of the acid components in the inorganic resist, is added to the developing solution, the development time can be shortened to a large extent, as compared to the developing solutions which do not contain this salt.

Also, by incorporating a controlled amount of salt, the same development properties can be maintained throughout from the state of the developing solution being fresh, and it is also possible to shorten the development time in accordance with the structure of the salt.

### (3) Third embodiment

The developing solution according to the third embodiment of the present invention is obtained by using an ammonium hydroxide compound as a main alkali source of the developing solution, and adding an alkali metal salt as the development accelerating agent. The explanation will be omitted by stating that the current embodiment is similar to the first embodiment described above, except for the developing solution and the reaction between the inorganic resist and the developing solution.

### (3-1) Developing solution

A sufficient hydroxide ion (OH⁻) concentration is secured by means of an ammonium hydroxide compound, which is the alkali source, and the penetrating power into the inorganic resist film, or the stability of dissolved acid components in the solution is adjusted, and thereby the rate of development is adjusted, by means of the alkali metal ion included in the salt which is added as the development accelerating agent. This is considered to be different from the mechanism based on the catalytic action such as in the first and second embodiments.

As already described, the development accelerating action exerted by alkali metal ions is greater than the catalytic action exerted by carbonate, silicate or the like. Furthermore, in the case where what is added as the development accelerating agent, is a compound which does not exhibit catalytic action, such as sodium chloride for example, even though the developing solution is titrated, there is none appearing as an inflection point.

### (Development accelerating agent)

As for the compound to be added as a development accelerating agent, hydroxides of alkali metals, or a salt having at least one alkali metal in the molecule, is used. This salt is a product formed from at least one acid component selected from protic compounds or aprotic compounds, and at least one alkali component selected from alkali metals. Here, examples will be given without distinction between compounds associated with catalytic action and compounds not associated therewith.

As for silicates, for example, lithium silicate (Li₂SiO₃), sodium silicate (Na₂SiO₃), potassium silicate (K₂SiO₃), and the like may be mentioned.

As for carbonates, for examples, lithium hydrogen carbonate (LiHCO₃), sodium hydrogen carbonate (NaHCO₃), potassium hydrogen carbonate (KHCO₃), lithium carbonate (Li₂CO₃), sodium carbonate (Na₂CO₃), potassium carbonate (K₂CO₃), rubidium carbonate (Rb₂CO₃), cesium carbonate (Cs₂CO₃), and the like may be mentioned.

Lithium tetraborate (Li₂B₄O₇), sodium tetraborate (Na₂B₄O₇), potassium tetraborate (K₂B₄O₇), disodium tetraborate (Na₂B₄O₇), sodium tetraphenylborate (NaB(C₆H₅)₄), lithium borate (Li₂B₄O₇), sodium borate (Na₂B₄O₇), potassium borate (K₂B₄O₇), and the like may be mentioned.

As for phosphates, for example, sodium tripolyphosphate (Na₅P₃O₁₀), sodium diphosphate (Na₄P₂O₇), potassium pyrophosphate (K₄P₂O₇), tetrasodium pyrophosphate (Na₄P₂O₇), sodium pyrophosphate (Na₄P₂O₇), sodium metaphosphate ((NaPO₃)ₙ), potassium metaphosphate ((KPO₃)ₙ), lithium phosphate (Li₃PO₄), trisodium phosphate (Na₃PO₄), tripotassium phosphate (Ka₃PO₄), sodium hydrogen phosphite (NaHPHO₃), dipotassium phosphite (K₂PHO₃), sodium hypophosphite (NaPH₂O₂), sodium tungstophosphate (Na₃(PO₄ ·12WO₃)), disodium hydrogen phosphate (Na₂HPO₄), sodium dihydrogen phosphate (NaH₂PO₄), dipotassium hydrogen phosphate (K₂HPO₄), potassium dihydrogen phosphate (KH₂PO₄), ammonium lithium hydrogen phosphate (LiNH₂HPO₄), ammonium sodium hydrogen phosphate (NaNH₄HPO₄), ammonium potassium hydrogen phosphate (NaNH₄HPO₄), and the like may be mentioned.

As for halides, for example, lithium fluoride (LiF), sodium fluoride (NaF), potassium fluoride (KF), rubidium fluoride (RbF), cesium fluoride (CsF), lithium chloride (LiCl), sodium chloride (NaCl), potassium chloride (KCl), rubidium chloride (RbCl), cesium chloride (CsCl), lithium bromide (LiBr), sodium bromide (NaBr), potassium bromide (KBr), rubidium bromide (RbBr), cesium bromide (CsBr), lithium iodide (LiI), sodium iodide (NaI), potassium iodide (KI), rubidium iodide (RbI), cesium iodide (CsI), and the like may be mentioned.

As for nitrates, for example, lithium nitrate (LiNO₃), sodium nitrate (NaNO₃), potassium nitrate (KNO₃), rubidium nitrate (RbNO₃), cesium nitrate (CsNO₃), and the like may be mentioned.

As for sulfates, for example, lithium sulfate (Li₂SO₄), sodium sulfate (Na₂SO₄), potassium sulfate (K₂SO₄), rubidium nitrate (Rb₂SO₄), cesium nitrate (Cs₂SO₄), and the like may be mentioned.

As for hydroxides, for example, lithium hydroxide (LiOH), sodium hydroxide (NaOH), potassium hydroxide (KOH), rubidium hydroxide (RbOH), cesium hydroxide (CsOH), and the like may be mentioned.

In addition to these, as organic acid salts, for example, lithium acetate (CH₃COOLi), sodium acetate (CH₃COONa), potassium acetate (CH₃COOK), lithium formate (HCOOLi), sodium formate (HCOONa), potassium formate (HCOOK), potassium benzoate (C₆H₅COOK), sodium benzoate (C₆H₅COONa), triammonium citrate ((NH₄)₃C₆H₅O₇), diammonium hydrogen citrate ((NH₄)₂HC₆H₅O₇), potassium dihydrogen citrate (KH₂C₆H5O₇), dipotassium hydrogen citrate (K₂HC₆H5O₇), tripotassium citrate (K₃C₆H₅O₇), trisodium citrate (Na₃C₆H₅O₇), disodium hydrogen citrate (Na₂HC₆H₅O₇), sodium dihydrogen citrate (NaH₂C₆H₅O₇), lithium citrate (Li₃C₆H₅O₇), ammonium tartrate ((NH₄)₂C₄H₄O₆), ammonium hydrogen tartrate (NH₄HC₄H₄O₆), potassium tartrate (K₂C₄H₄O₆), potassium hydrogen tartrate (KHC₄H₄O₆), sodium hydrogen tartrate (NaHC₄H₄O₆), sodium potassium tartrate (NaKC₄H₄O₆), sodium tartrate (Na₂C₄H₄O₆), lithium tartrate (Li₂C₄H₄O₆), and the like, water-soluble salts which serve as the sources of alkali metal ions can be used. A suitable amount of incorporation into a developing solution, of these salts which are used as development accelerating agents, can be appropriately adjusted and determined in accordance with the desired rate of development. These salts can also be used individually alone, or as mixtures of two or more species.

### (Alkaline aqueous solution)

In regard to the alkaline aqueous solution, an aqueous solution formed from an alkali hydroxide which does not contain an alkali metal, can be used. As for the type of the alkaline compound which serves as the alkali source, tetramethylammonium hydroxide ((CH₃)₄NOH), tetraethylammonium hydroxide ((CH₂H₅)₄NOH), tetrapropylammonium hydroxide ((C₃H₇)₄NOH), tetrabutylammonium hydroxide ((C₄H₉)₄NOH), choline ((CH₃)₃N(OH)CH₂CH₂OH), and the like can be used. These can be used individually alone, or as mixtures of two or more species. The concentration of these hydroxide ion sources is not particularly limited, but it is necessary to establish the pH value to be higher than the point of neutralization of the development accelerating agent, when the alkaline aqueous solution is titrated with an acid while the development accelerating agent has been added.

Generally, it is desirable to adjust the concentration of the hydroxide ion source to obtain pH 10 or higher, and preferably pH 12 or higher.

Since these aqueous solutions of tetraalkylammonium hydroxide do not have such high developing power against inorganic resist by themselves, when only these are put into use, relatively long time is required for development. In that regard, the scope for adjusting the rate of development can be taken broadly, by adding only a controlled quantity of an alkali metal compound as the development accelerating agent.

### (3-2) Reaction between inorganic resist and developing solution

The mechanism by which the development accelerating agent added to an alkaline aqueous solution accelerates the reaction, is obscure, but it is speculated to be approximately such as follows.

For example, while the development time is not shortened even though tetramethylammonium chloride ((CH₃)₄N ·Cl) is dissolved in an aqueous solution of tetramethylammonium hydroxide ((CH₃)₄N ·OH), the development time is shortened to a large extent when sodium chloride (NaCl) is added. From this, it is understood that the development accelerating action depends largely on the nature of the cation moiety.

A case of using tetramethylammonium hydroxide as the teraalkylammonium hydroxide which is used as the hydroxide ion source, and using sodium chloride as the source of alkali metal ions, will be described as an example. The added sodium chloride dissolves in an aqueous solution of tetramethylammonium hydroxide, and nearly completely dissociates into a cation (Na⁺) and an anion (Cl⁻). The acidic substance (WO₃) produced in the inorganic resist as a result of the latent image formation of the inorganic resist, is attached by hydroxide ions (OH⁻) in the solution, and dissolves. At this time, under the action of cations such as tetramethylammonium ions ((CH₃)₄N⁺) and sodium ion, dissolution of WO₃ is accelerated. This is speculated such that during the time period in which WO₃ leaves from the inorganic resist and is stabilized by being solvated, a kind of intermediate state is formed, and since the rate of forming this intermediate state is faster with sodium ions (Na⁺) than with tetramethylammonium ions ((CH₃)₄N⁺), or since the penetrating power into the inorganic resist film is greater for sodium ions (Na⁺) than for tetramethylammonium ions ((CH₃)₄N⁺), a development accelerating effect is exhibited.

Here, tungsten oxide (WO₃) which is a dissoluble component of the inorganic resist, exhibits water-solubility in the state of an ammonium salt, an alkali metal salt, a magnesium salt or the like, but is nearly insoluble in the state of other metal salts. In the case where the element contained in the cation moiety of the development accelerating agent is an alkaline earth metal such as calcium or magnesium, when the development accelerating agent is incorporated into a strongly alkaline aqueous solution, calcium hydroxide (solubility in water: 1.7%, 20°C) or magnesium hydroxide (solubility in water: 0.0009%, 18°C), which are all scarcely soluble in water, is formed and precipitates out, and desired characteristics cannot be obtained. Therefore, in the present invention, the cation moiety of the development accelerating agent is defined to include an alkali metal.

Hereinafter, the present invention will be specifically described by way of Examples, but the present invention is not intended to be limited only to these Examples. In addition, Example 1 to Example 6 correspond to the first embodiment, Example 7 to Example 28 correspond to the second embodiment, and Example 29 to Example 42 correspond to the third embodiment.

### <Comparative Example 1>

The composition of the developing solution of Comparative Example 1 and the method of evaluation will be shown in the following.
Additive: None
Alkali source: Tetramethylammonium hydroxide
Evaluation: Development, titration

### (Titration of developing solution)

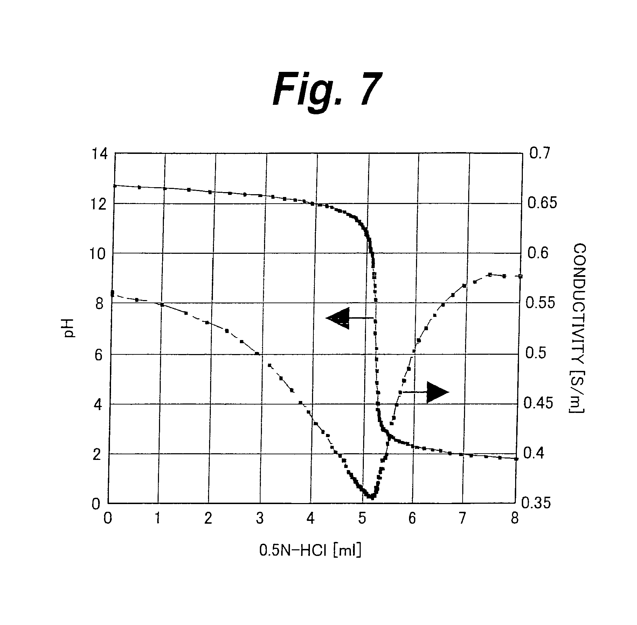

As an alkaline aqueous solution, a 2.38 wt% aqueous solution of tetramethylammonium hydroxide (Tokyo Ohka Kogyo Co. , Ltd., NMD-3) was provided, and this was used as a developing solution. Subsequently, this developing solution was titrated with 0.5 normal hydrochloric acid, and the relationship between the amount of dropwise addition of hydrochloric acid and the pH as well as conductivity was determined. The results are presented in Fig. 7. Here, the measurement was carried out by using a dilution prepared by adding 50 ml of pure water to a 10 ml sample of the developing solution. The arrows in Fig. 7 are provided to indicate which titration curve is associated with which, between pH and conductivity. The arrows for the titration curves given hereafter indicate the same as in Fig. 7.

### (Resist master production process)

A resist master was produced as follows. First, a 100 nm foundation layer formed from amorphous silicon was formed on a substrate by a sputtering method. Here, this foundation layer is for the heat of the laser radiation irradiated on the inorganic resist layer to be efficiently accumulated.

The conditions for film production of the foundation layer will be shown below.
Substrate: 8 inch silicon wafer
Target material: Silicon
Film producing gas: Argon (Ar) ·26 [SCCM]
Gas pressure for film production initiation: 5.0×10⁻⁴ [Pa]
Film producing power: DC 135 [W]

Subsequently, an inorganic resist layer having a thickness of 25 nm was formed on the foundation layer by a sputtering method.

The conditions for film formation of the inorganic resist layer will be shown below.
Target material: Tungsten (W)/molybdenum (Mo)/oxygen (O) = 32/8/60 (ratio of number of atoms)
Film producing gas: Argon (Ar) ·26 [SCCM]
Gas pressure for film production initiation: 5.0×10⁻⁴ [Pa]
Film producing power: DC 135 [W]

### (Exposure process)

Subsequently, exposure was performed by irradiating the inorganic resist layer with laser radiation, while rotating the resist master obtained as described above.

The condition for exposure of the inorganic resist layer will be shown below.
Light source: Semiconductor laser (wavelength 405 [nm])
Object lens: NA = 0.9
Resist master feed speed: 0.32 [µm/revolution]
Spindle: CLV (Constant Liner Velocity) mode 4.9 [m/seconds]

### (Development process)

Subsequently, the exposed inorganic resist layer was subjected to development, to produce a DC groove pattern.

The conditions for development of the inorganic resist layer will be shown below.
Developing solution temperature: 26°C
Development method: Continuous flow of the developing solution onto the resist master

Here, the development process will be described in more detail. First, a 2.38 wt% aqueous solution of tetramethylammonium hydroxide was placed in a developing tank (manufactured by Sony Disc & Digital Solutions, Inc., PTR3000), and was maintained at 26°C. Subsequently, the inorganic resist master was mounted on a rotating stage, was subjected to processes of pre-rinse, development and post-rinse, while the rotation was maintained at 400 rpm, and then was finally dried by shaking off at 1800 rpm.

The conditions for process treatment of pre-rinse, development and post-rinse will be shown below.
Pre-rinse: Incessant flow of pure water over 60 seconds.
Development: Incessant flow of the developing solution over an established time (three points between 360 seconds to 480 seconds).
Post-rinse: Incessant flow of pure water over 180 seconds.

As described above, a desired resist master for optical disc was obtained.

### (AFM measurement)

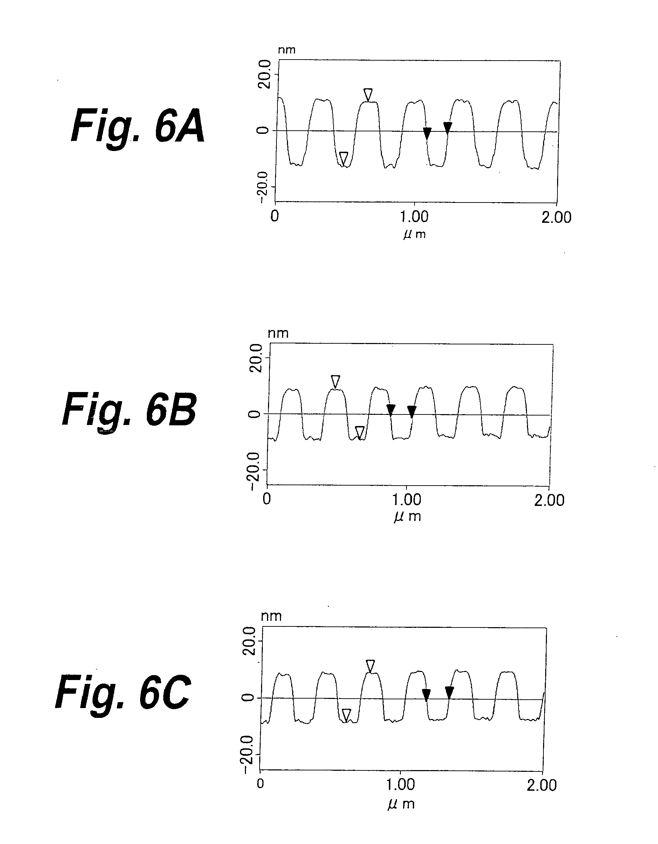

Subsequently, the grooves formed on the respective inorganic resist masters were measured by using AFM (Atomic Force Microscope). The results are presented in Table 1 and Fig. 6A to Fig. 6C. Here, the time [seconds] in which a shape pattern sufficiently dissolves down to the resist bottom so that the side geometry becomes linear, and the half-width of the groove width becomes about 160 nm, was defined as the optimum development time. Accordingly, the optimum development time for a developing solution which is not added with a development accelerating agent is 420 seconds.

Furthermore, the developing solution used in the development was titrated with hydrochloric acid, and the relationship between the amount of dropwise addition of hydrochloric acid and the pH as well as conductivity was determined. The results are presented in Fig. 7. Here, the measurement was carried out by titrating a dilution which was prepared by adding 50 ml of pure water to a 10 ml sample of the developing solution, with 0.5 normal hydrochloric acid.

### <Comparative Example 2>

The composition of the developing solution of Comparative Example 2 and the method of evaluation will be shown in the following.
Additive: None
Alkali source: Sodium hydroxide
Evaluation: Development, titration

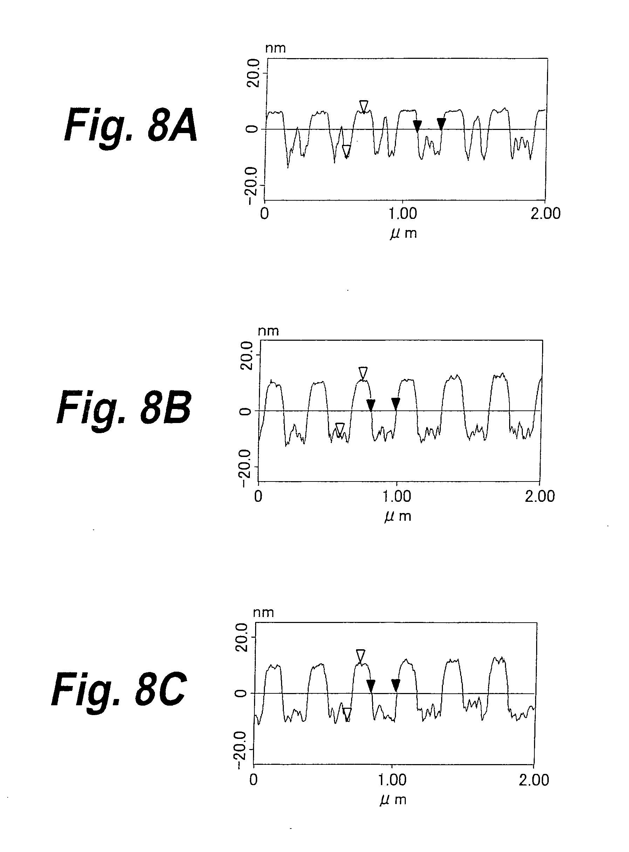

A resist master was obtained by carrying out the resist master production process and exposure process in the same manner as in Comparative Example 1. Subsequently, a 0.2 mol/L NaOH aqueous solution was provided as a developing solution. This was placed in a developing tank (manufactured by Sony Disc & Digital Solutions, Inc., PTR3000), and was maintained at 26°C. The resist master was developed in the same manner as in Comparative Example 1, except that this developing solution was incessantly flowed, and the development time was set at three points between 30 seconds to 90 seconds. Subsequently, the grooves formed on the inorganic resist master were measured by using AFM. The results are presented in Table 1 and Fig. 8A to Fig. 8C.

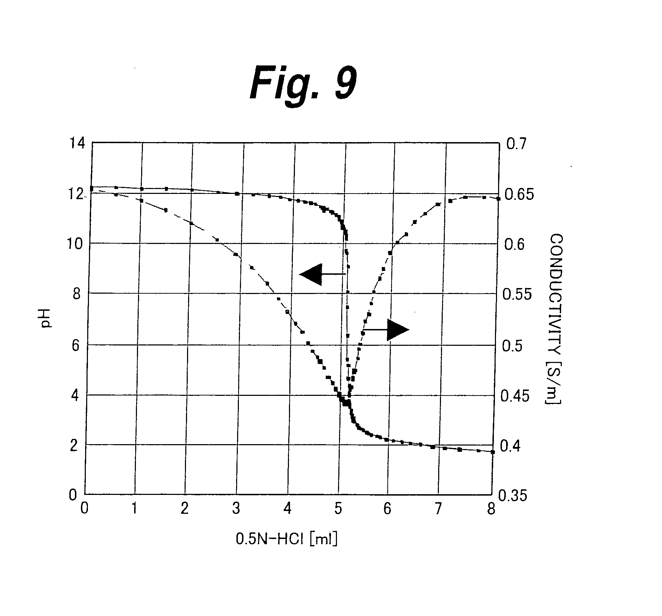

The developing solution used in the development was titrated with hydrochloric acid, and the relationship between the amount of dropwise addition of hydrochloric acid and the pH as well as conductivity was determined. The results are presented in Fig. 9. Here, the measurement was carried out by titrating a dilution which was prepared by adding 50 ml of pure water to a 10 ml sample of the developing solution, with 0.5 normal hydrochloric acid.

### <Comparative Example 3>

The composition of the developing solution of Comparative Example 3 and the method of evaluation will be shown in the following.
Additive: None
Alkali source: Trisodium phosphate ·12 water
Evaluation: Development, titration

A resist master was obtained by carrying out the resist master production process and exposure process in the same manner as in Comparative Example 1.

Subsequently, a 0.2 mol/L aqueous solution of trisodium phosphate ·12 water was provided as a developing solution.

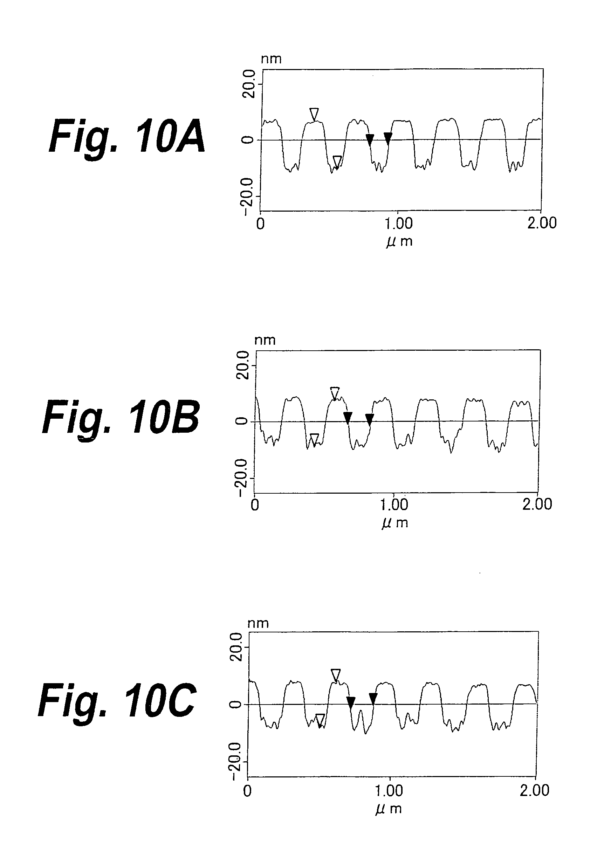

This was placed in a developing tank (manufactured by Sony Disc & Digital Solutions, Inc., PTR3000), and was maintained at 26°C. The resist master was developed in the same manner as in Comparative Example 1, except that this developing solution was incessantly flowed, and the development time was set at three points between 90 seconds to 120 seconds. Subsequently, the grooves formed on the inorganic resist master were measured by using AFM. The results are presented in Table 1 and Fig. 10A to Fig. 10C.

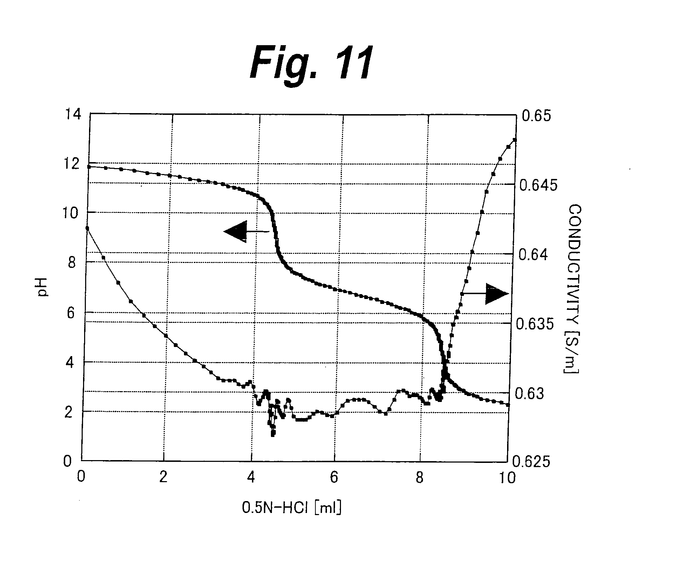

The developing solution used in the development was titrated with hydrochloric acid, and the relationship between the amount of dropwise addition of hydrochloric acid and the pH as well as conductivity was determined. The results are presented in Fig. 11. Here, the measurement was carried out by titrating a dilution which was prepared by adding 50 ml of pure water to a 10 ml sample of the developing solution, with 0.5 normal hydrochloric acid.

### <Comparative Example 4>

The composition of the developing solution of Comparative Example 4 and the method of evaluation will be shown in the following.
Additive: Tetramethylammonium chloride
Alkali source: Tetramethylammonium hydroxide
Evaluation: Development, titration

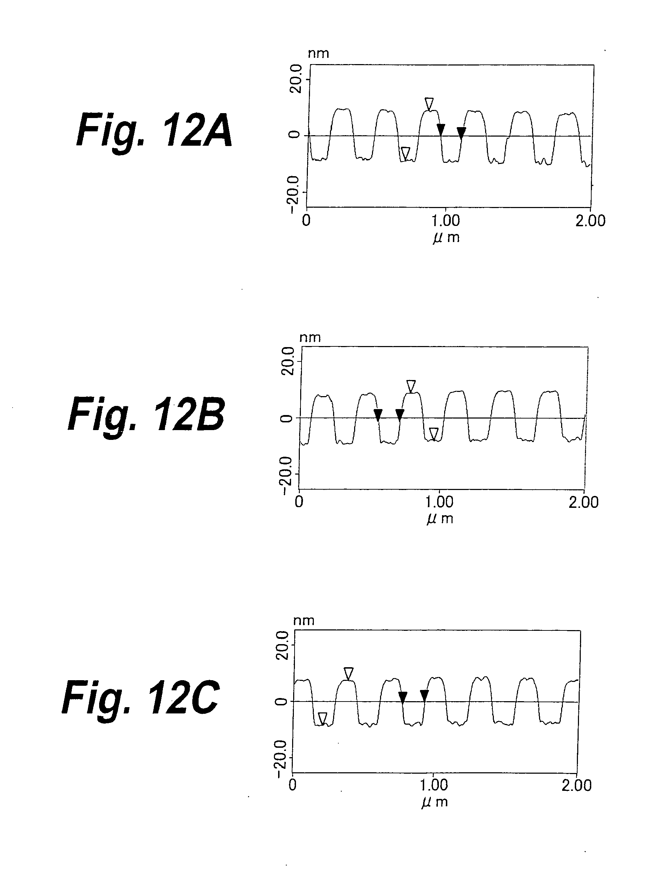

A resist master was obtained by carrying out the resist master production process and exposure process in the same manner as in Comparative Example 1. Subsequently, a solution obtained by mixing tetramethylammonium chloride ((CH₃)₄N ·Cl) at a concentration of 10. 0 g/L to a 2.38 wt% aqueous solution of tetramethylammonium hydroxide, was provided as a developing solution. This was placed in a developing tank (manufactured by Sony Disc & Digital Solutions, Inc., PTR3000), and was maintained at 26°C. The resist master was developed in the same manner as in Comparative Example 1, except that this developing solution was incessantly flowed. Subsequently, the grooves formed on the inorganic resist master were measured by using AFM. The results are presented in Table 1 and Fig. 12A to Fig. 12C.

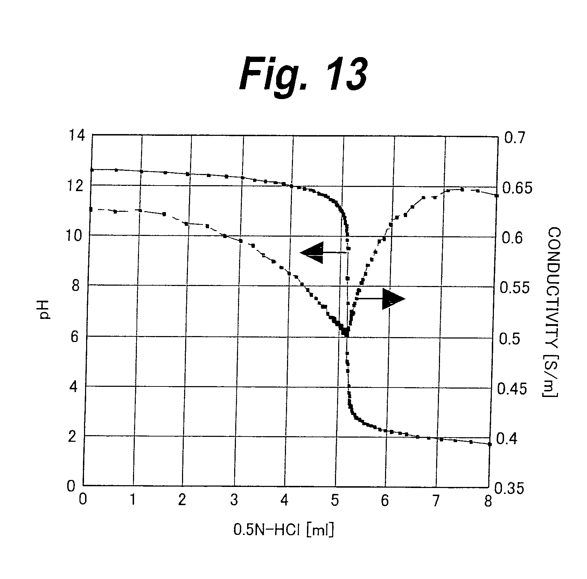

The developing solution used in the development was titrated with hydrochloric acid, and the relationship between the amount of dropwise addition of hydrochloric acid and the pH as well as conductivity was determined. The results are presented in Fig. 13. Here, the measurement was carried out by titrating a dilution which was prepared by adding 50 ml of pure water to a 10 ml sample of the developing solution, with 0.5 normal hydrochloric acid.

### <Comparative Example 5>

The composition of the developing solution of Comparative Example 4 and the method of evaluation will be shown in the following.
Additive: Tetramethylammonium tetrafluoroborate
Alkali source: Tetramethylammonium hydroxide
Evaluation: Development, titration

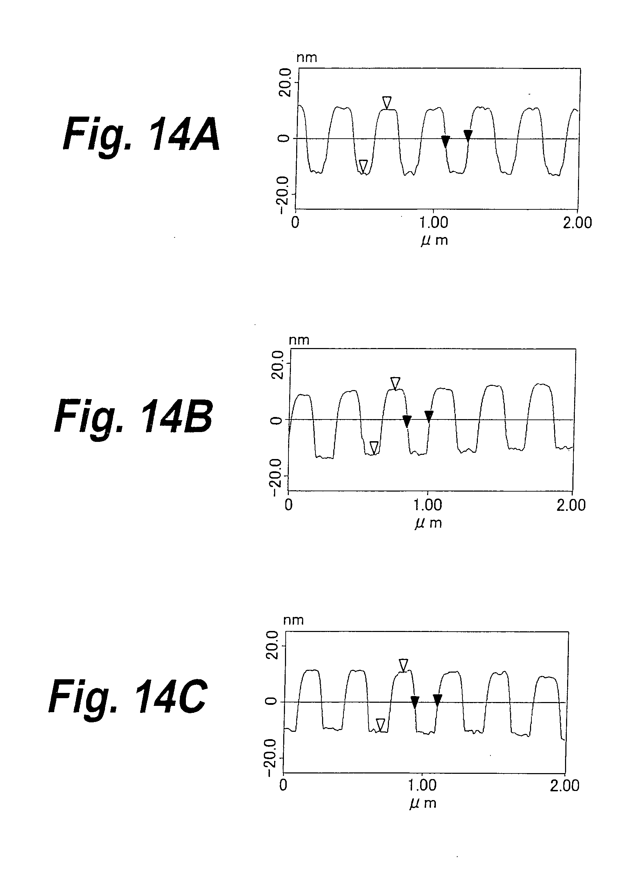

A resist master was obtained by carrying out the resist master production process and exposure process in the same manner as in Comparative Example 1. Subsequently, a solution obtained by mixing tetramethylammonium tetrafluoroborate ((CH₃)₄N ·BF₄) at a concentration of 10.0 g/L to a 2.38 wt% aqueous solution of tetramethylammonium hydroxide, was provided as a developing solution. This was placed in a developing tank (manufactured by Sony Disc & Digital Solutions, Inc., PTR3000), and was maintained at 26°C. Subsequently, the resist master was developed in the same manner as in Comparative Example 1, except that this developing solution was incessantly flowed. Subsequently, the grooves formed on the inorganic resist master were measured by using AFM. The results are presented in Table 1 and Fig. 14A to Fig. 14C.

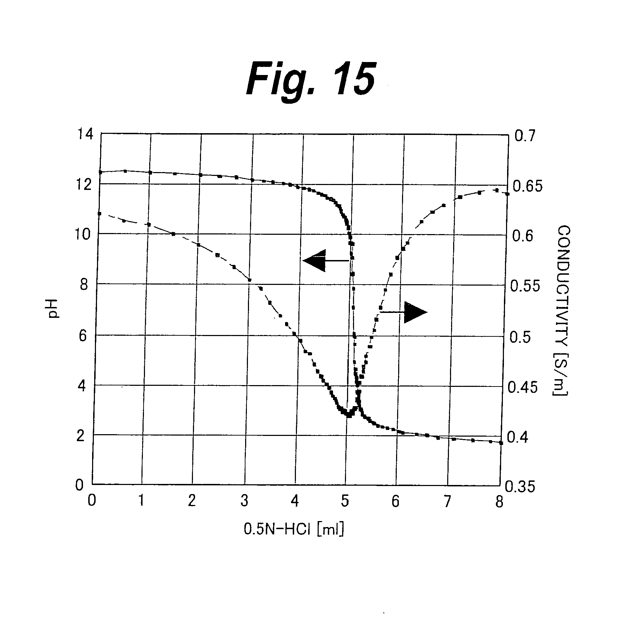

The developing solution used in the development was titrated with hydrochloric acid, and the relationship between the amount of dropwise addition of hydrochloric acid and the pH as well as conductivity was determined. The results are presented in Fig. 15. Here, the measurement was carried out by titrating a dilution which was prepared by adding 50 ml of pure water to a 10 ml sample of the developing solution, with 0.5 normal hydrochloric acid.

In Example 1 to Example 6, the method of mixing an additive which forms a development accelerating agent by forming a salt with the alkali source, into an alkaline aqueous solution, and the development accelerating action exerted by the resulting developing solution, on an inorganic resist, will be described.

### <Example 1>

The composition of the developing solution of Example 1 and the method of evaluation will be shown in the following.
Additive: Silicon powder
Alkali source: Tetramethylammonium hydroxide
Evaluation: Development, titration

A resist master was obtained by carrying out the resist master production process and exposure process in the same manner as in Comparative Example 1.

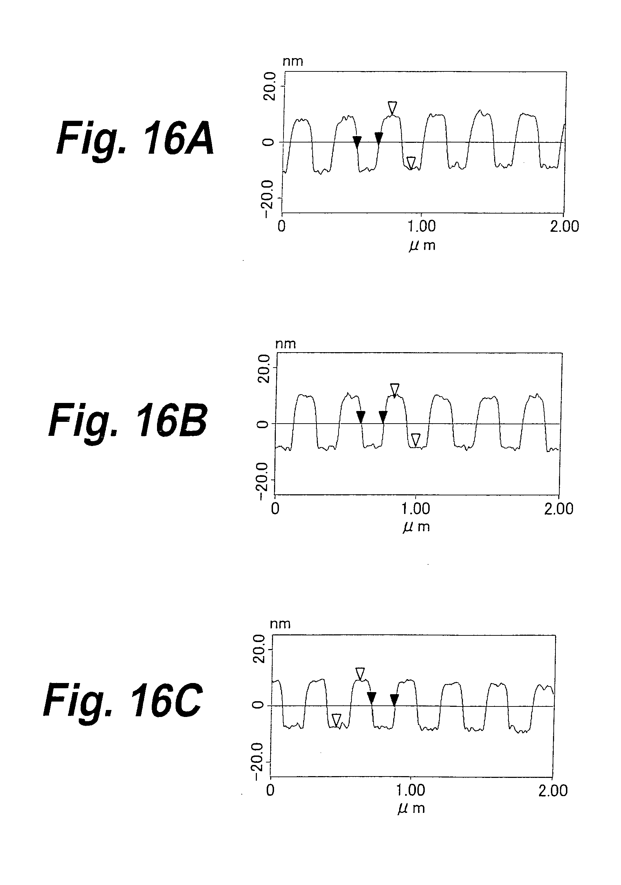

Subsequently, 1000 ml of a 2.38 wt% aqueous solution of tetramethylammonium hydroxide and 13.3 g of silicon powder were weighed in a stainless steel vat, and were stirred at 100°C on a hot stirrer. Subsequently, stirring was stopped when the silicon powder had all dissolved, and the system was cooled to room temperature. Subsequently, this was transferred to a Poly tank, and a fresh 2.38 wt% aqueous solution of tetramethylammonium hydroxide was added thereto to a total volume of 12 liters. The mixture was left to stand overnight at room temperature, and then was filtered through a membrane filter (Advantec Toyo Kaisha, Ltd., VH020). The resulting developing solution was placed in a developing tank of PTR3000 and was maintained at 26°C. Subsequently, a resist master was developed under the same conditions as in Comparative Example 1, except that this developing solution was incessantly flowed, and the development time was set at three points between 240 seconds to 300 seconds. Then, the grooves formed on the inorganic resist master were measured by using AFM. The results are presented in Table 1 and Fig. 16A to Fig. 16C.

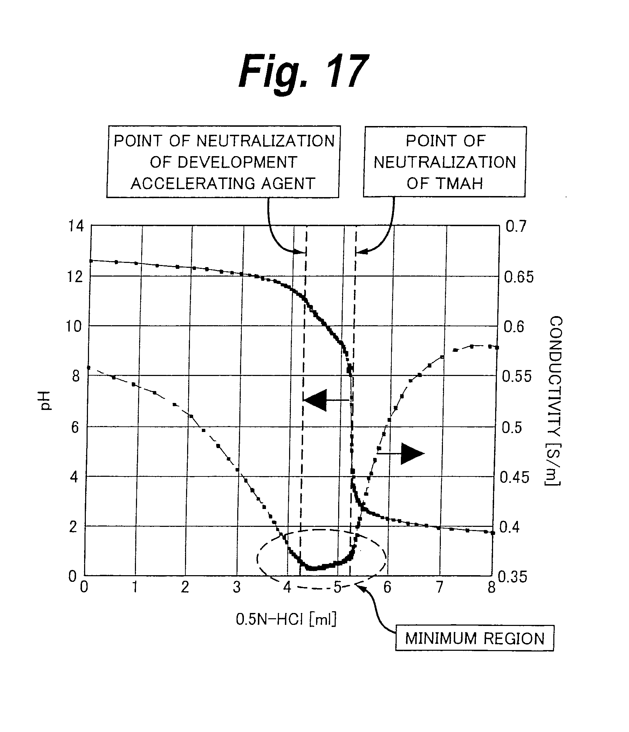

Also, the developing solution used in the development was titrated with hydrochloric acid, and the relationship between the amount of dropwise addition of hydrochloric acid and the pH as well as conductivity was determined. The results are presented in Fig. 17. Here, the measurement was carried out by titrating a dilution which was prepared by adding 50 ml of pure water to a 10 ml sample of the developing solution, with 0.5 normal hydrochloric acid.

The developing solution of Comparative Example 1 to which a development accelerating agent had not been added, exhibited only the inflection point of tetramethylammonium hydroxide, the alkali source, as shown in Fig. 7. However, it was found that in the titration of the developing solution of Example 1 to which silicon had been added, as shown in Fig. 17, the development accelerating agent formed as a result of the reaction between the added silicon and the aqueous solution of tetramethylammonium hydroxide, caused a neutralization reaction with hydrochloric acid, and the titration curve (pH) showed an inflection point accompanied by a gentle curve at near pH 11, while the titration curve (conductivity) draws a minimum region from this point to the point of neutralization of tetramethylammonium hydroxide.

### <Example 2>

The composition of the developing solution of Example 2 and the method of evaluation will be shown in the following.
Additive: Silicon powder
Alkali source: Tetramethylammonium hydroxide
Evaluation: Titration

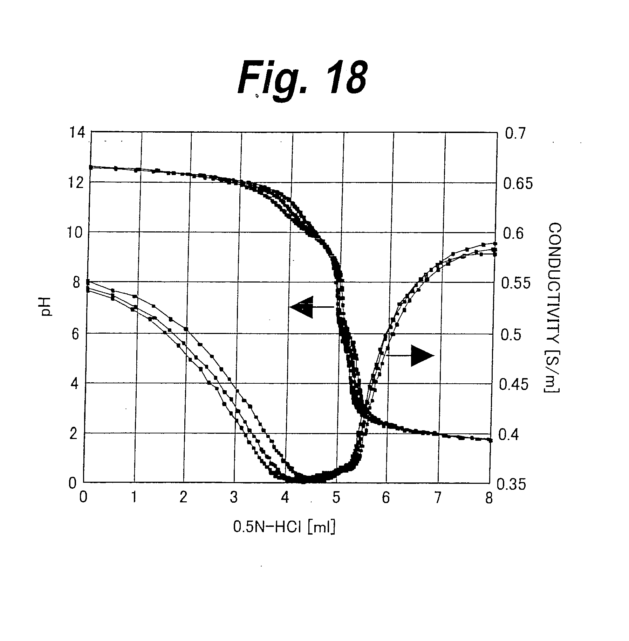

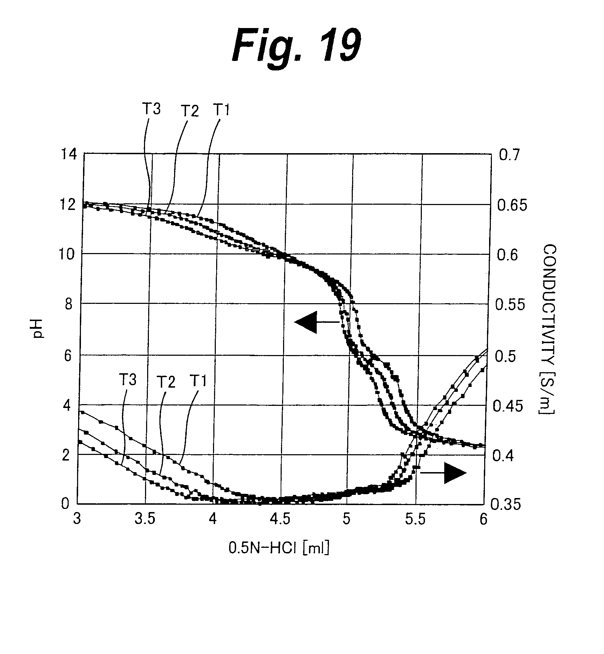

A 2.38 wt% aqueous solution of tetramethylammonium hydroxide was provided as an alkaline aqueous solution. To this aqueous solution, silicon (Si) powder was added to completely dissolve therein, and three types at concentrations 2.0, 4.0 and 6.0 g/L were prepared. Then, the solutions were respectively filtered through a membrane filter (Advantec Toyo Kaisha, Ltd., VH020), to obtain developing solutions. Subsequently, in the same manner as in Comparative Example 1, the relationship between the amount of dropwise addition of 0.5 normal hydrochloric acid and the pH as well as conductivity was determined for the respective developing solutions. The results are presented in Fig. 18, and a magnified view of the vicinity of the inflection point resulting from neutralization of the development accelerating agent is presented in Fig. 19. Here, T1, T2 and T3 in Fig. 19 represent the titration curves of the developing solutions at concentration 2.0, 4.0 and 6.0 g/L, respectively.

### <Example 3>

The composition of the developing solution of Example 3 and the method of evaluation will be shown in the following.
Additive: Carbon dioxide gas (dry ice)
Alkali source: Tetramethylammonium hydroxide
Evaluation: Titration

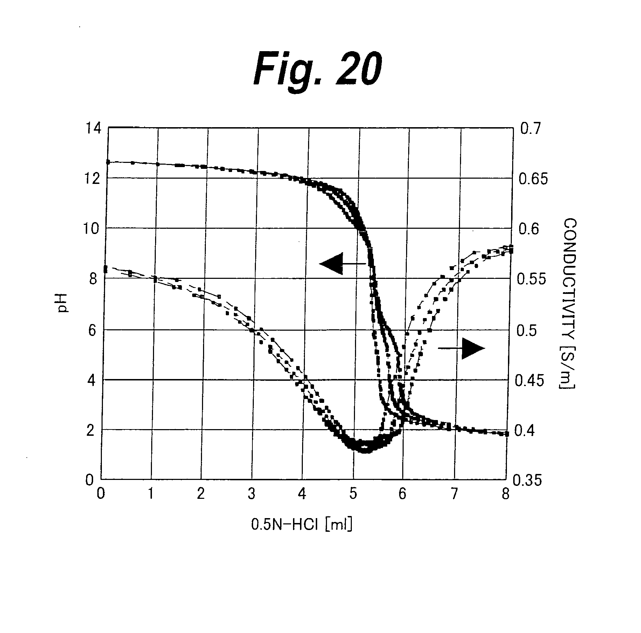

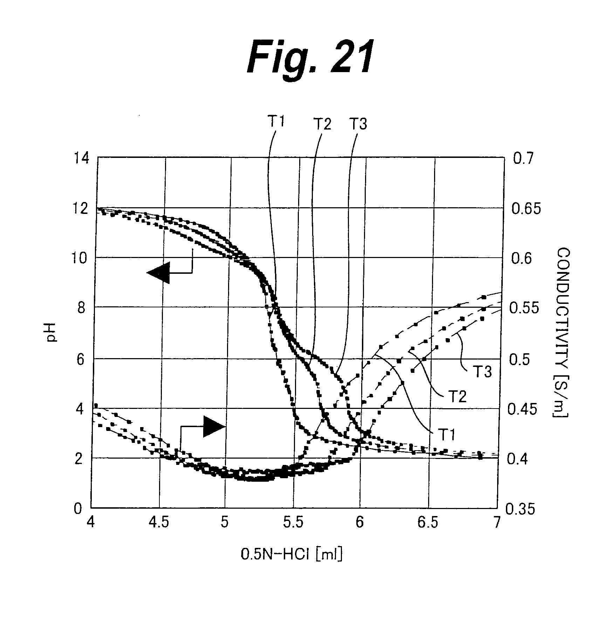

200 ml of a 2.38 wt% aqueous solution of tetramethylammonium hydroxide and 0.2, 0.4 or 0.6 g of dry ice were placed and sealed in a pressure vessel made of stainless steel, and were left to stand for 2 days at room temperature. Subsequently, the solutions were respectively filtered through a membrane filter (Advantec Toyo Kaisha, Ltd., VH020), to obtain developing solutions. For the respective developing solutions, the relationship between the amount of dropwise addition of 0.5 normal hydrochloric acid and the pH as well as conductivity was determined in the same manner as in Comparative Example 1. The results are presented in Fig. 20, and a magnified view of the vicinity of the inflection point resulting from neutralization of the development accelerating agent is presented in Fig. 21. Here, T1, T2 and T3 in Fig. 21 represent the titration curves of the developing solutions at concentration 0.2, 0.4 and 0.6 g, respectively.

### <Example 4>

The composition of the developing solution of Example 4 and the method of evaluation will be shown in the following.
Additive: Tungsten trioxide
Alkali source: Tetramethylammonium hydroxide
Evaluation: Development, titration

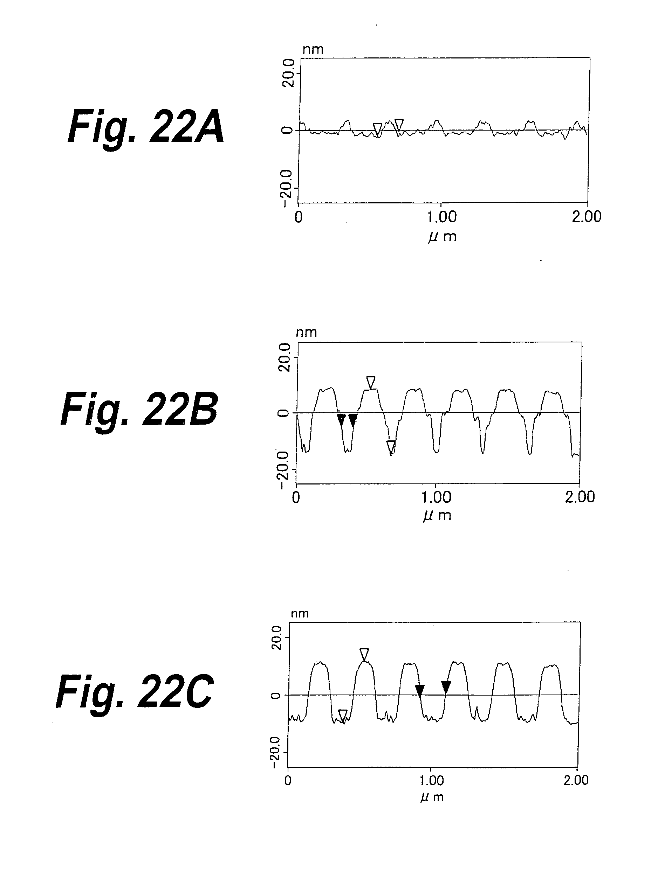

A resist master was obtained by carrying out the resist master production process and exposure process in the same manner as in Comparative Example 1. Subsequently, powdered tungsten trioxide was added to a 2.38 wt% aqueous solution of tetramethylammonium hydroxide to a concentration of 2.5 g/L in a beaker, and the tungsten trioxide was completely dissolved while ultrasonic irradiation was performed. This was filtered through a membrane filter (Advantec Toyo Kaisha, Ltd., VH020), to obtain a developing solution. Subsequently, the resist master was developed under the same conditions as in Comparative Example 1, except that this developing solution was incessantly flowed at a temperature of 26°C, and the development time was set at three points between 60 seconds to 180 seconds. Subsequently, the grooves formed on the inorganic resist master were measured by using AFM. The results are presented in Table 1 and Fig. 22A to Fig. 22C.

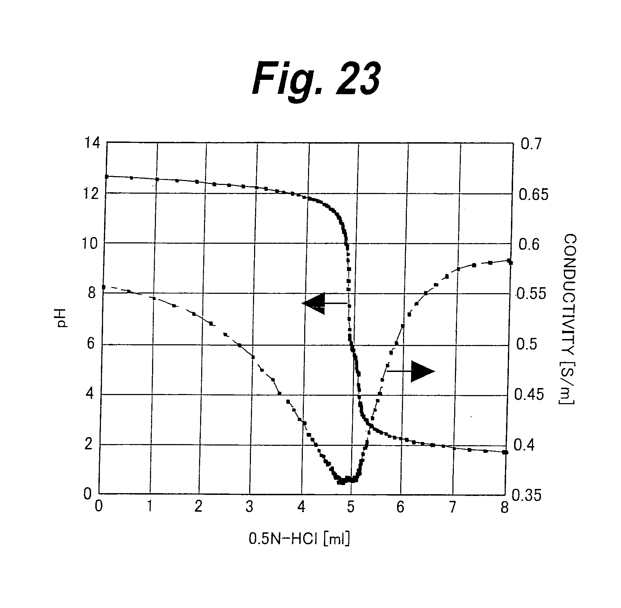

The developing solution used in the development was respectively titrated with hydrochloric acid, and the relationship between the amount of dropwise addition of hydrochloric acid and the pH as well as conductivity was determined. The results are presented in Fig. 23. The measurement was carried out by titrating a dilution which was prepared by adding 50 ml of pure water to a 10 ml sample of the developing solution, with 0.5 normal hydrochloric acid.

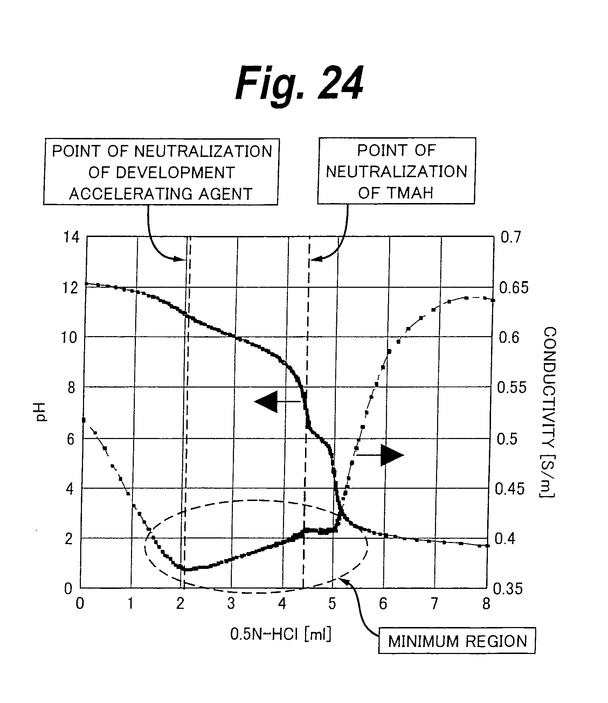

Here, the results obtained by metering 10 ml of a solution obtained by dissolving tungsten trioxide in the 2.38 wt% aqueous solution of tetramethylammonium hydroxide to saturation, adding 50 ml of pure water thereto to dilute the solution, and titrating the dilution with 0.5 normal hydrochloric acid, are presented in Fig. 24.

When Fig. 23 and Fig. 24 are compared, the presence of an inflection point at near pH 11, which is hardly recognized in the solution of tungsten trioxide at a low concentration, is clearly found at a high concentration. However, when the conductivity is compared, the minimum region clearly appears in Fig. 24 as well as in Fig. 23. The developing solution can maintain stable development properties, as a result of replacing before this region is reached. Furthermore, by taking the conductivity as an index, the degree of deterioration of the developing solution can be conveniently found.

### <Example 5>

The composition of the developing solution of Example 5 and the method of evaluation will be shown in the following.
Additive: Boric acid
Alkali source: Tetramethylammonium hydroxide
Evaluation: Development, titration

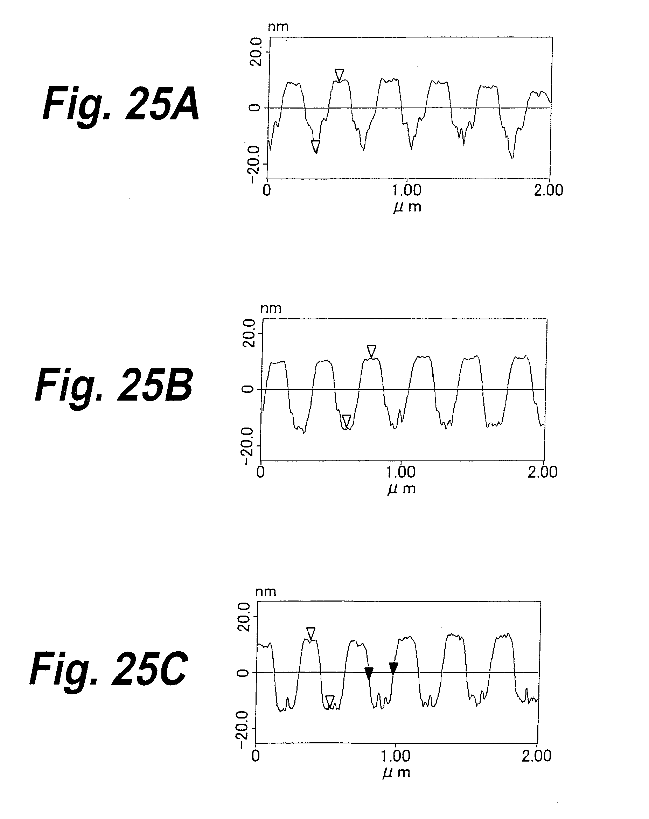

A resist master was obtained by carrying out the resist master production process and exposure process in the same manner as in Comparative Example 1. Subsequently, boric acid was added to a 2.38 wt% aqueous solution of tetramethylammonium hydroxide, and thus a developing solution at a concentration of 5.0 g/L was obtained. Subsequently, the resist master was developed under the same conditions as in Comparative Example 1, except that this developing solution was incessantly flowed at a temperature of 26°C. Subsequently, the grooves formed on the inorganic resist master were measured by using AFM. The results are presented in Table 1 and Fig. 25A to Fig. 25C.

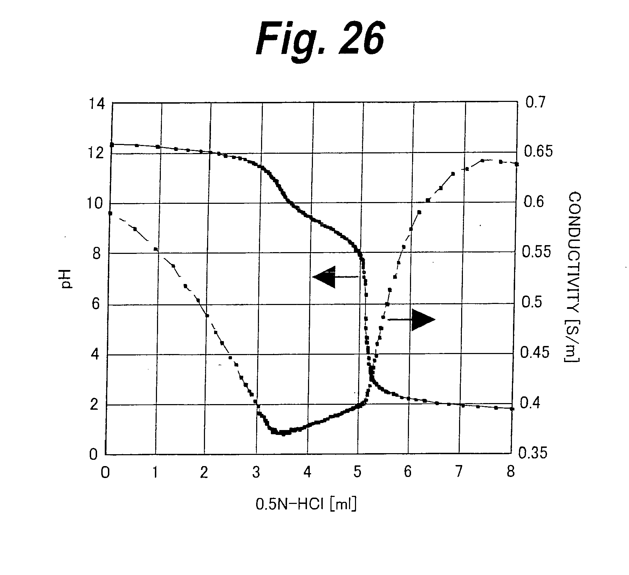

Furthermore, the developing solution used in the development was titrated with hydrochloric acid, and the relationship between the amount of dropwise addition of hydrochloric acid and the pH as well as conductivity was determined. The results are presented in Fig. 26. Here, the measurement was carried out by titrating a dilution which was prepared by adding 50 ml of pure water to a 10 ml sample of the developing solution, with 0.5 normal hydrochloric acid.

**(Table 1)**

| EXAMPLE /COMPARATIVE EXAMPLE | ADDITIVE | DEVELOPMENT TIME [sec] | AFM DIAGRAM | TITRATION CURVE | GROOVE WIDTH [nm] | GROOVE DEPTH [nm] |
|---|---|---|---|---|---|---|
| COMPARATIVE EXAMPLE 1 | NONE | 360 | Fig. 6A | | 156 | 19 |
| | | 420 | Fig. 6B | Fig.7 | 164 | 18 |
| | | 480 | Fig. 6C | | 164 | 18 |
| COMPARATIVE EXAMPLE 2 | NONE | 30 | Fig. 8A | | 168 | 16 |
| | | 60 | Fig. 8B | Fig. 9 | 176 | 20 |
| | | 90 | Fig. 8C | | 180 | 20 |
| COMPARATIVE EXAMPLE 3 | NONE | 90 | Fig. 10A | | 133 | 17 |
| | | 150 | Fig. 10B | Fig. 11 | 156 | 16 |
| | | 210 | Fig. 10C | | 164 | 15 |
| COMPARATIVE EXAMPLE 4 | TETRAMETHYLAMMONIUM CHLORIDE (CH₃)₄N·Cl | 360 | Fig. 12A | | | 18 |
| | | 420 | Fig. 12B | Fig. 13 | 164 | 17 |
| | | 480 | Fig. 12C | | 164 | 17 |
| COMPARATIVE EXAMPLE 5 | TETRAMETHYLAMMONIUM TETRAFLUOROBORATE (CH₃)₄N·BF₄ | 360 | Fig. 14A | | 152 | 22 |
| | | 420 | Fig. 14B | Fig. 15 | 164 | 23 |
| | | 480 | Fig. 14C | | 164 | 21 |
| EXAMPLE 1 | SILICON POWDER Si | 240 | Fig. 16A | | 156 | 19 |
| | | 270 | Fig. 16B | Fig. 17 | 164 | 18 |
| | | 300 | Fig. 16C | | 172 | 17 |
| EXAMPLE 2 | SILICON POWDER Si | - | - | Fig. 18 | - | - |
| | | - | - | Fig. 19 | - | - |
| | | - | - | | - | - |
| EXAMPLE 3 | DRY ICE CO₂ | - | - | Fig. 20 | - | - |
| | | - | - | Fig. 21 | - | - |
| | | - | - | | - | - |
| EXAMPLE 4 | TUNGSTEN TRIOXIDE WO₃ | 60 | Fig. 22A | Fig. 23 | - | - |
| | | 120 | Fig. 22B | Fig. 24 | 86 | 23 |
| | | 180 | Fig. 22C | | 164 | 21 |
| EXAMPLE 5 | BORIC ACID H₃BO₃ | 240 | Fig. 25A | | - | 25 |
| | | 270 | Fig. 25B | Fig. 26 | - | 25 |
| | | 300 | Fig. 25C | | 160 | 24 |
| EXAMPLE 6 | BORIC ACID H₃BO₃ | - | - | | - | - |
| | | - | - | - | - | - |
| | | - | - | | - | - |

### [As to shape obtained after development]

(a) From Comparative Example 1 and Comparative Example 2, it can be seen that the characteristics exhibited by pH or conductivity are almost the same, and an aqueous solution of sodium hydroxide shows markedly superior development accelerating action as compared to an aqueous solution of tetramethylammonium. That is, it can be seen that in the case of using tetramethylammonium as the cation moiety of the alkali source, the development margin is much larger than in the case of using sodium. Also in regard to the surface morphology obtained by development, the aqueous solution of tetramethylammonium hydroxide leads to reduced generation of irregularities. It is speculated that these actions originate from the difference in the penetrability to the inorganic resist, which is attributable to the difference in the steric hindrance of the cation moiety. Furthermore, it is understood that, as in Comparative Example 6, in the case where sodium hydroxide and tetramethylammonium are co-present in the developing solution, the properties of sodium hydroxide which has high development accelerating action are preferentially manifested.
(b) From a comparison of Comparative Example 1, Comparative Example 4 and Comparative Example 5, it can be seen that the development time taken until the half-width of the groove width reaches about 160 nm, is almost the same. That is, it can be seen that in the developing solution to which a neutral salt formed from a strong base whose alkali component is the same as the alkali source of the developing solution, and a strong acid, such as tetramethylammonium chloride or tetramethylammonium tetrafluoroborate, has been added, an increase in the rate of development is almost not seen. On the other hand, it is also understood that, as in Comparative Example 3, in a developing solution to which an alkali metal salt such as sodium chloride has been added as a neutral salt, the rate of development increases to a large extent. However, the development time is longer than that for the case where development is carried out with the aqueous solution of sodium hydroxide of Comparative Example 2, and the surface morphology obtainable therefrom is also associated with reduced generation of irregularities. That is, Comparative Example 3 is thought to involve development in a state which is intermediate between Comparative Example 1 and Comparative Example 2. It is speculated that this originates from the penetrating power into an inorganic resist film based on the difference in the alkali metal concentration, or from the difference in the contribution to the stabilization of the dissolved acid component, but does not originate from catalytic action.
(c) From a comparison between Example 1 and Example 2 to Example 5, it can be seen that the development time taken until the half-width of the groove width reaches about 160 nm, is shortened, as compared to Comparative Example 1. Particularly, Example 3 exhibits a marked decrease in the development time. Therefore, it is understood that, when silicon, carbon dioxide, tungsten trioxide, boric acid and the like are incorporated as additives, they respectively exhibit different development accelerating actions.

When a resist master manufactured by forming an inorganic resist layer containing tungsten oxide as a main component on a silicon substrate, is repeatedly developed, the development time is gradually shortened proportionally to the number of development process, and converges to a certain value. This is conceived to be the result of that tungsten oxide in the inorganic resist, silicon of the silicon substrate, and carbon dioxide gas in air separately blend in into the alkaline aqueous solution, and react with the alkali source of the developing solution to form development accelerating agents, and the development time converges to a stable value corresponding to the dissolution ratio of the three components.

### [As to titration curve]

In Comparative Example 1 to Comparative Example 5, any inflection point other than that originating from neutralization of the alkali source does not appear on the titration curve (pH), and the point of neutralization of pH remained almost unchanging (see Fig. 7, Fig. 9, Fig. 11, Fig. 13 and Fig. 15), whereas in Example 1 to Example 5, inflection points originating from the development accelerating agents produced in the developing solution, appear on the titration curve (pH), in addition to the point of neutralization of the alkali source (see Fig. 17 to Fig. 21, Fig. 23, Fig. 24 and Fig. 26). Moreover, the corresponding titration curve (conductivity) has a minimum value at the part of pH inflection point. That is, for a developing solution which is obtained by adding silicon, carbon dioxide gas, tungsten trioxide, boric acid or the like, which serve as the raw materials of development accelerating agents, to an alkaline aqueous solution, the presence of additives can be confirmed by titrating with an acid and verifying any change in the shape of the titration curve. Particularly, in Example 2 and Example 3, if the dissolution concentration of silicon or dry ice is low, it becomes difficult to determine the inflection point due to the development accelerating agent from the titration curve (pH), whereas the titration curve (conductivity) exhibits the minimum value in an extremely distinct form, thus determination being easy. As such, for the purpose of simply detecting the state of the developing solution, measurement of conductivity is an effective method. Furthermore, by verifying whether or not an inflection point other than that originating from the alkali source appears on the titration curve (pH), it can be predicted, before actually carrying out the development of an inorganic resist, as to whether an element or an oxide can be used as a development accelerating agent.

### <Example 6>

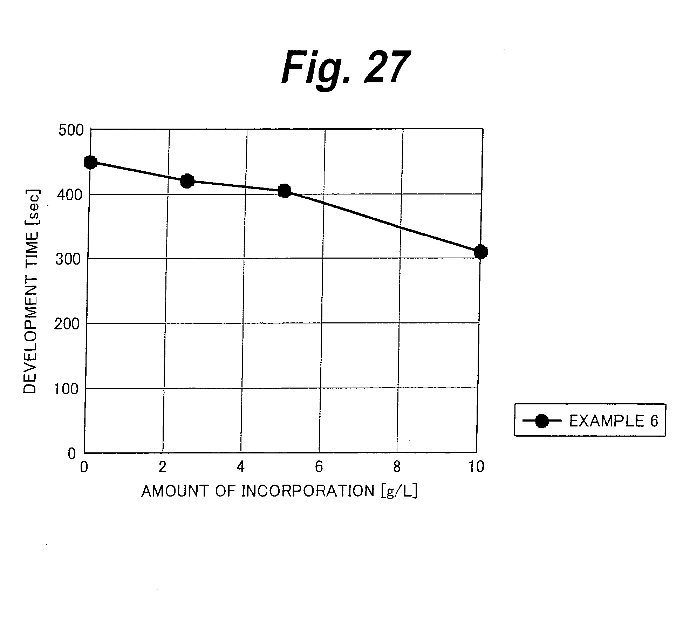

A resist master was obtained by carrying out the resist master production process and exposure process in the same manner as in Comparative Example 1. Subsequently, boric acid was added as a development accelerating agent to a 2.38 wt% aqueous solution of tetramethylammonium hydroxide, and four types of developing solutions at concentrations of 0.0, 2.5, 5.0 and 10.0 g/L were prepared. Subsequently, development of the inorganic resist master was carried out in the same manner as in Comparative Example 1, except that these developing solutions were used, and the time taken until the half-width of the groove width reached about 160 nm, was determined. The relationship between the amount of addition of the development accelerating agent and the development time is shown in Fig. 27.

As shown in Fig. 27, boric acid manifests a weak development accelerating action in a manner nearly proportional to the amount of addition. It is speculated that in the developing solution, the compound formed from tetramethylammonium hydroxide, which is the alkali source, and boric acid, acts on the dissoluble component (acid component) of the inorganic resist, and thereby development is accelerated.

In Example 7 to Example 26, the method for preparing a developing solution by using a 2.38 wt% aqueous solution of tetramethylammonium hydroxide as an alkaline aqueous solution, and incorporating a development accelerating agent thereto, and the development effect exerted by the obtained developing solution on an inorganic resist, will be described.

### <Example 7 to Example 16>

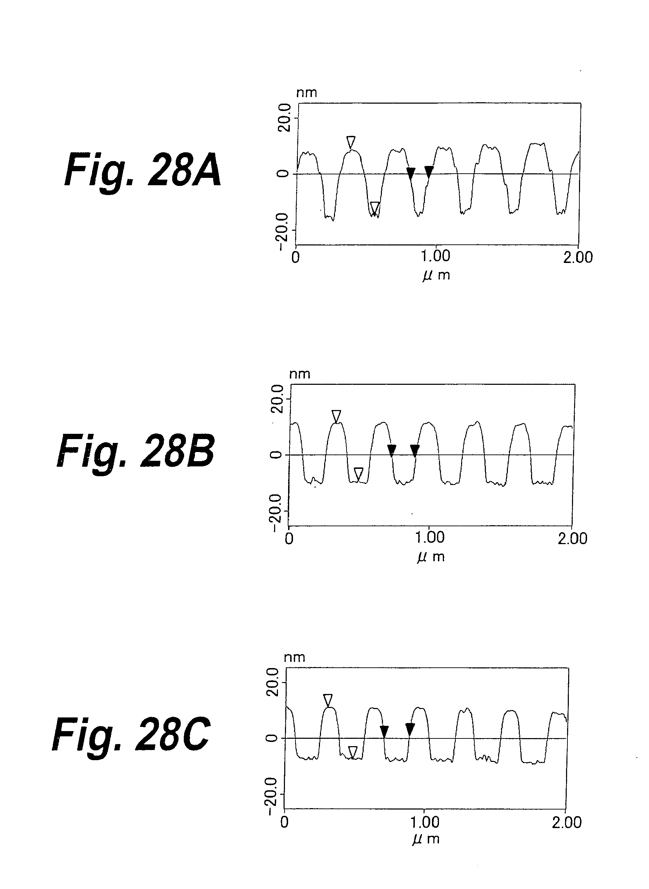

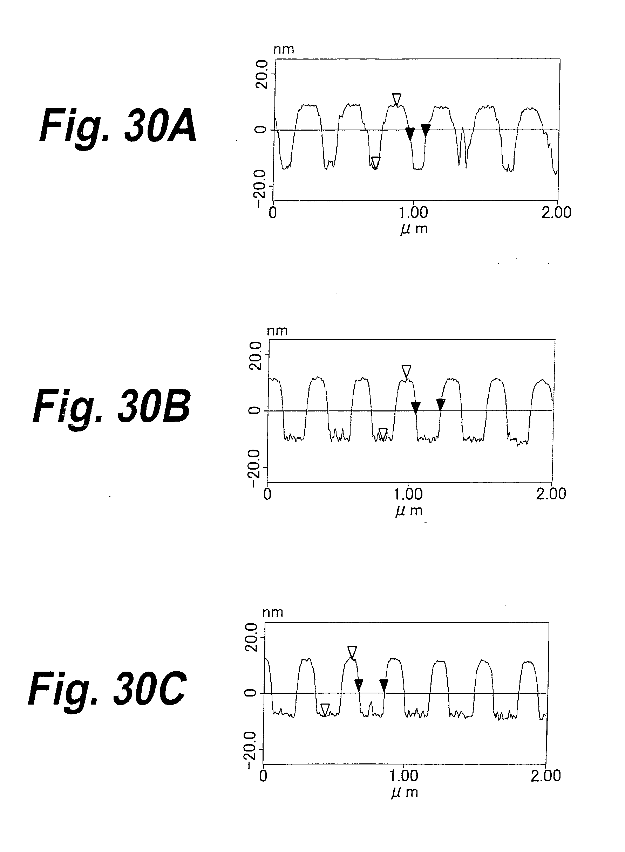

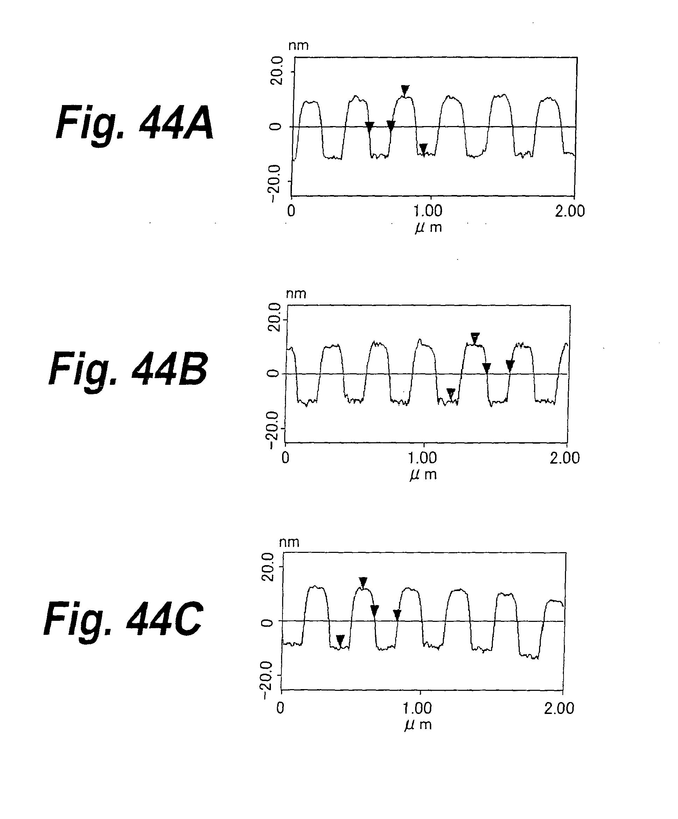

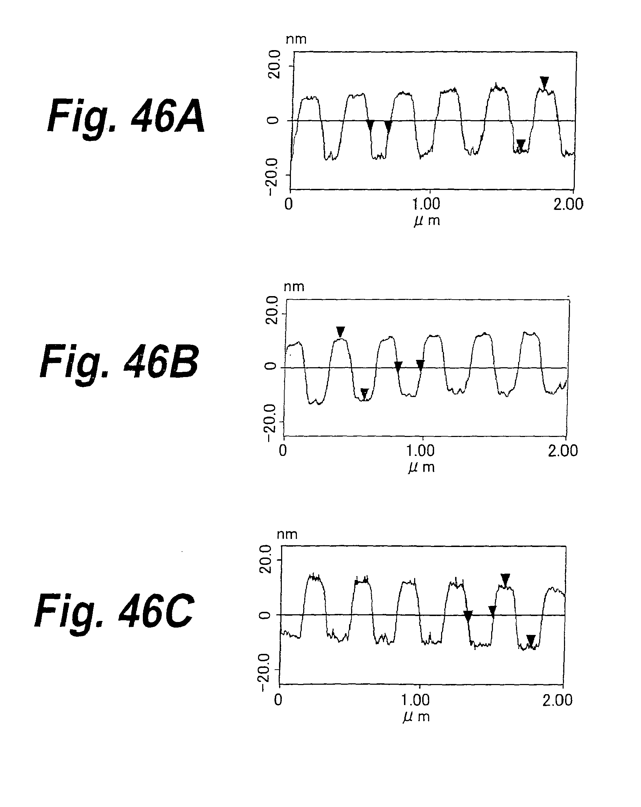

A resist master was obtained by carrying out the resist master production process and exposure process in the same manner as in Comparative Example 1. Subsequently, the development accelerating agents shown in Table 2 were added to a 2.38 wt% aqueous solution of tetramethylammonium hydroxide, and developing solutions at a concentration of 10 g/L were prepared for the respective development accelerating agents. Subsequently, development of the inorganic resist master was performed in the same manner as in Comparative Example 1, except that these developing solutions were used, and thus desired resist masters for optical disc were obtained. Subsequently, the grooves formed on the inorganic resist masters were measured by using AFM. The results are presented in Table 2 and Fig. 28, Fig. 30, ..., Fig. 44, and Fig. 46.

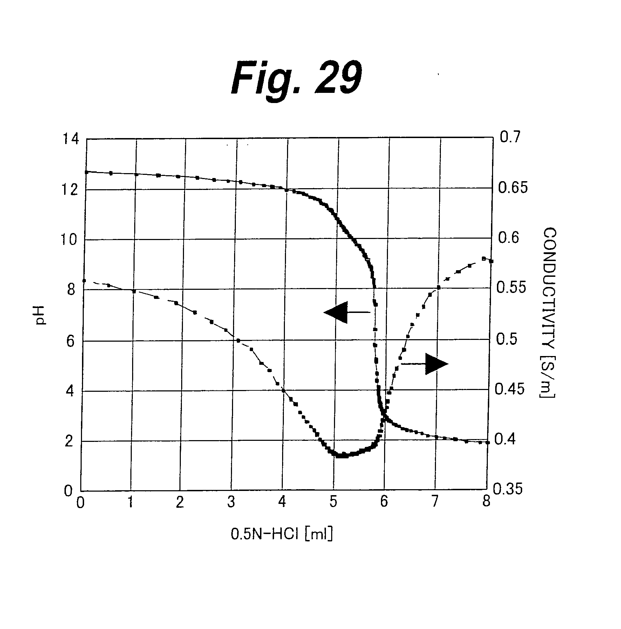

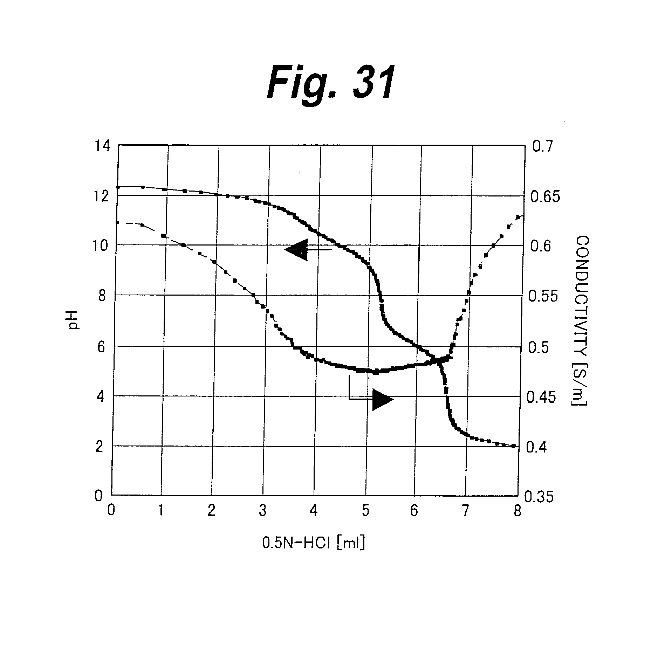

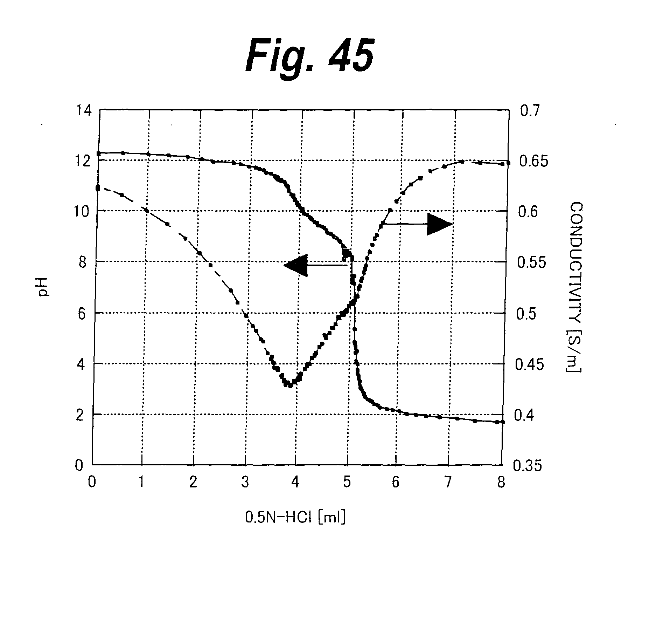

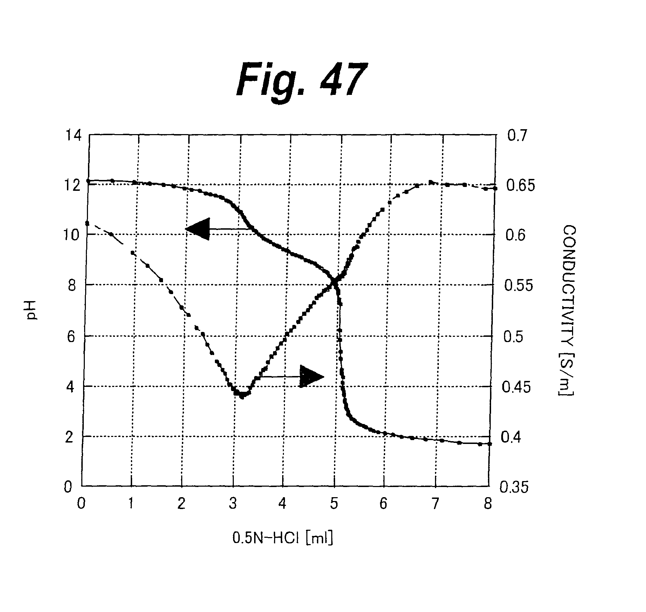

Furthermore, the developing solutions used in the development were titrated with hydrochloric acid, and the relationship between the amount of dropwise addition of hydrochloric acid and the pH as well as conductivity was determined. The results are presented in Fig. 29, Fig. 31, ..., Fig. 45, and Fig. 47. Here, the measurement was carried out by titrating a dilution which was prepared by adding 50 ml of pure water to a 10 ml sample of the developing solution, with 0.5 normal hydrochloric acid.

### <Example 17 to Example 26>

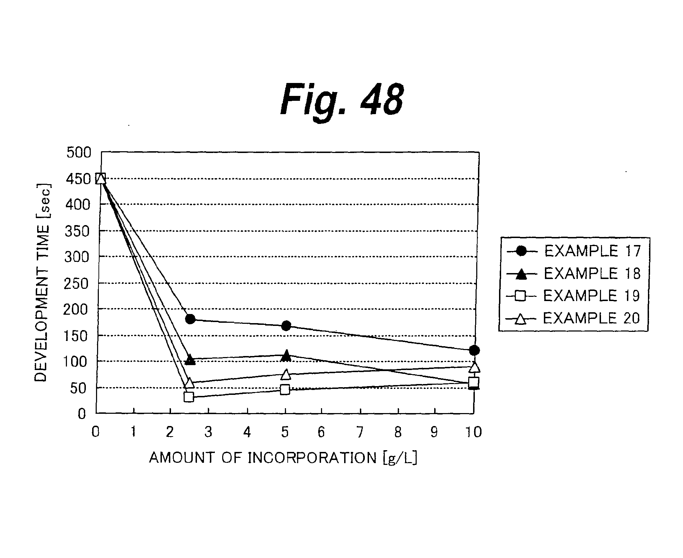

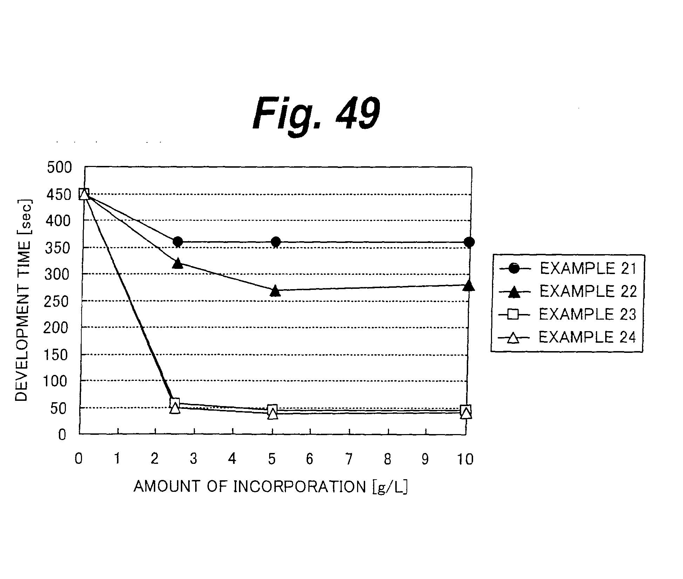

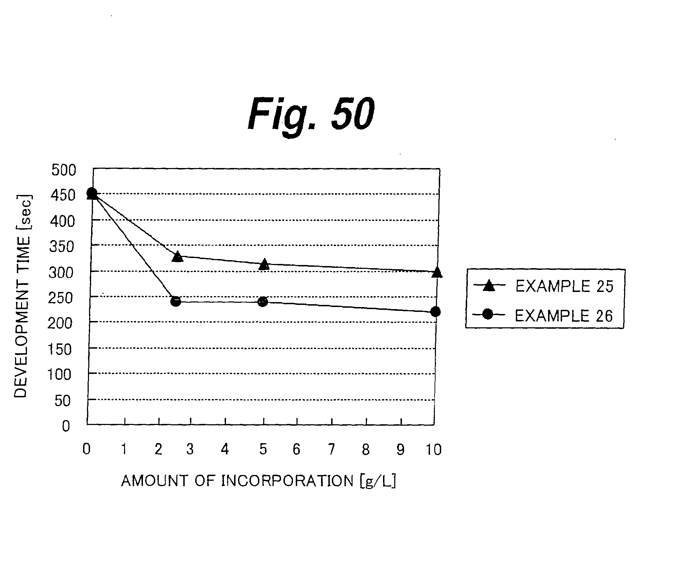

A resist master was obtained by carrying out the resist master production process and exposure process in the same manner as in Comparative Example 1. Subsequently, the development accelerating agents shown in Table 3 were added to a 2.38 wt% aqueous solution of tetramethylammonium hydroxide, and developing solutions at concentrations of 0.0, 2.5, 5.0 and 10.0 g/L were prepared for the respective development accelerating agents. Subsequently, development of the inorganic resist master was performed in the same manner as in Comparative Example 1, except that these developing solutions were used, and the time taken until the half-width of the groove width reached about 160 nm was determined. The relationship between the amount of addition of the development accelerating agent and the development time is presented in Fig. 48 to Fig. 50.

**(Table 2)**

| EXAMPLE | DEVELOPMENT ACCELERATING AGENT/RATIONAL FORMULA | DEVELOPMENT TIME [sec] | AFM DIAGRAM | TITRATION CURVE | GROOVE WIDTH [nm] | GROOVE DEPTH [nm] |
|---|---|---|---|---|---|---|
| EXAMPLE 7 | TETRAMETHYLAMMONIUM METASILICATE [(CH₃)₄N]₂O·SiO₂ | 60 | Fig. 28A | | 117 | 24 |
| | | 120 | Fig. 28B | Fig. 29 | 164 | 21 |
| | | 180 | Fig. 28C | | 180 | 18 |
| EXAMPLE 8 | TETRAMETHYLAMMONIUM CARBONATE [(CH₃)₄N]₂CO₃ | 30 | Fig. 30A | | 105 | 23 |
| | | 60 | Fig. 30B | Fig. 31 | 168 | 22 |
| | | 90 | Fig. 30C | | 184 | 20 |
| EXAMPLE 9 | SODIUM METASILICATE Na₂O·SiO₂ | 30 | Fig. 32A | | 172 | 17 |
| | | 60 | Fig. 32B | Fig. 33 | 172 | 20 |
| | | 90 | Fig. 32C | | 188 | 20 |
| EXAMPLE 10 | SODIUM CARBONATE Na₂CO₃ | 60 | Fig. 34A | | 148 | 23 |
| | | 90 | Fig. 34B | Fig. 35 | 164 | 18 |
| | | 120 | Fig. 34C | | 164 | 18 |
| EXAMPLE 11 | TETRAMETHYLAMMONIUM BORATE [(CH₃)₄N]₂O·2B₂O₃ | 300 | Fig. 36A | | - | 20 |
| | | 360 | Fig. 36B | Fig. 37 | 160 | 22 |
| | | 390 | Fig. 36C | | 160 | 22 |
| EXAMPLE 12 | AMMONIUM PENTABORATE· OCTAHYDRATE (NH₄)₂O·5B₂O₃·8H₂O | 150 | Fig. 38A | | - | 11 |
| | | 210 | Fig. 38B | Fig. 39 | 152 | 23 |
| | | 270 | Fig. 38C | | 164 | 22 |
| EXAMPLE 13 | SODIUM TETRABORATE·DECAHYDRATE Na₂B₄O₇·10H₂O | 30 | Fig. 40A | | 148 | 24 |
| | | 60 | Fig. 40B | Fig. 41 | 180 | 23 |
| | | 90 | Fig. 40C | | 191 | 23 |
| EXAMPLE 14 | SODIUM METABORATE·TETRAHYDRATE NaBO_{2·}4H₂O | 30 | Fig. 42A | | 152 | 24 |
| | | 60 | Fig. 42B | Fig. 43 | 180 | 24 |
| | | 90 | Fig. 42C | | 180 | 23 |
| EXAMPLE 15 | AMMONIUM NITRATE NH₄NO₃ | 270 | Fig. 44A | | 156 | 21 |
| | | 300 | Fig. 44B | Fig. 45 | 164 | 21 |
| | | 330 | Fig. 44C | | 168 | 21 |
| EXAMPLE 16 | AMMONIUM CHLORIDE NH₄Cl | 180 | Fig. 46A | | 133 | 23 |
| | | 210 | Fig. 46B | Fig. 47 | 160 | 23 |
| | | 240 | Fig. 46C | | 172 | 22 |

| | | | | | | |
|---|---|---|---|---|---|---|
| ALKALI SOURCE: TETRAMETHYLAMMONIUM HYDROXIDE | | | | | | |

In Example 16, the development time has been shortened to about 1/2, as compared to Comparative Example 1. As can be seen in Comparative Example 3, since chlorine ions do not exhibit a development accelerating action, this can be judged based on the action of ammonium ions.

**(Table 3)**

| EXAMPLE | DEVELOPMENT ACCELERATING AGENT/RATIONAL FORMULA | DEVELOPMENT TIME GRAPH |
|---|---|---|
| EXAMPLE 17 | TETRAMETHYLAMMONIUM METASILICATE [(CH₃)₄N]₂O·SiO₂ | Fig. 48 |
| EXAMPLE 18 | TETRAMETHYLAMMONIUM CARBONATE [(CH₃)₄N]₂CO₃ | Fig. 48 |
| EXAMPLE 19 | SODIUM METASILICATE Na₂O·SiO₂ | Fig. 48 |
| EXAMPLE 20 | SODIUM CARBONATE Na₂CO₃ | Fig. 48 |
| EXAMPLE 21 | TETRAMETHYLAMMONIUM BORATE [(CH₃)₄N]₂O·2B₂O₃ | Fig. 49 |
| EXAMPLE 22 | AMMONIUM PENTABORATE· OCTAHYDRATE (NH₄)₂O·5B₂O₃·8H₂O | Fig. 49 |
| EXAMPLE 23 | SODIUM TETRABORATE·DECAHYDRATE Na₂B₄O₇·10H₂O | Fig. 49 |
| EXAMPLE 24 | SODIUM METABORATE·TETRAHYDRATE NaBO₂·4H₂O | Fig. 49 |
| EXAMPLE 25 | AMMONIUM NITRATE NH₄NO₃ | Fig. 50 |
| EXAMPLE 26 | AMMONIUM CHLORIDE NH₄Cl | Fig. 50 |

| | | |
|---|---|---|
| ALKALI SOURCE: TETRAMETHYLAMMONIUM HYDROXIDE | | |

In Example 27, the method for preparing a developing solution by using a 0.2 mol/L aqueous solution of trisodium phosphate as an alkaline aqueous solution, and incorporating thereto tetramethylammonium metasilicate as a development accelerating agent, and the development effect exerted by the obtained developing solution on an inorganic resist, will be described.

### <Example 27>

The composition of the developing solution of Example 27 and the method of evaluation will be shown in the following.
Additive: Tetramethylammonium metasilicate
Alkali source: Trisodium phosphate ·12 water
Evaluation: Development, titration

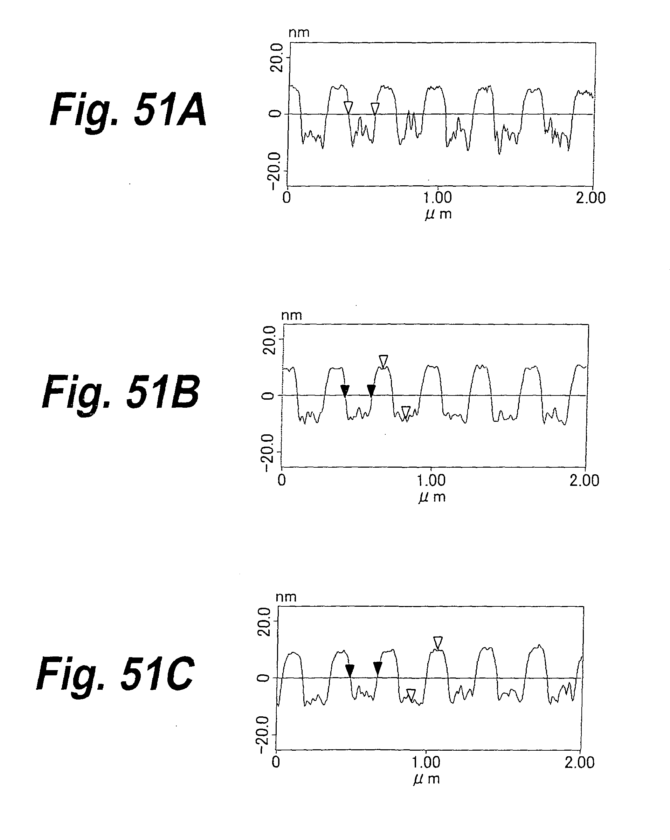

A resist master was obtained by carrying out the resist master production process and exposure process in the same manner as in Comparative Example 1. Subsequently, tetramethylammonium metasilicate was added to a 0.2 mol/L aqueous solution of trisodium phosphate ·12 water, and a developing solution at a concentration of 10 g/L was prepared. Subsequently, development of the inorganic resist master was performed in the same manner as in Comparative Example 1, except that this developing solution was used, and a desired resist master for optical disc was obtained. Subsequently, the grooves formed on the inorganic resist master were measured by using AFM. The results are presented in Table 4 and Fig. 51.

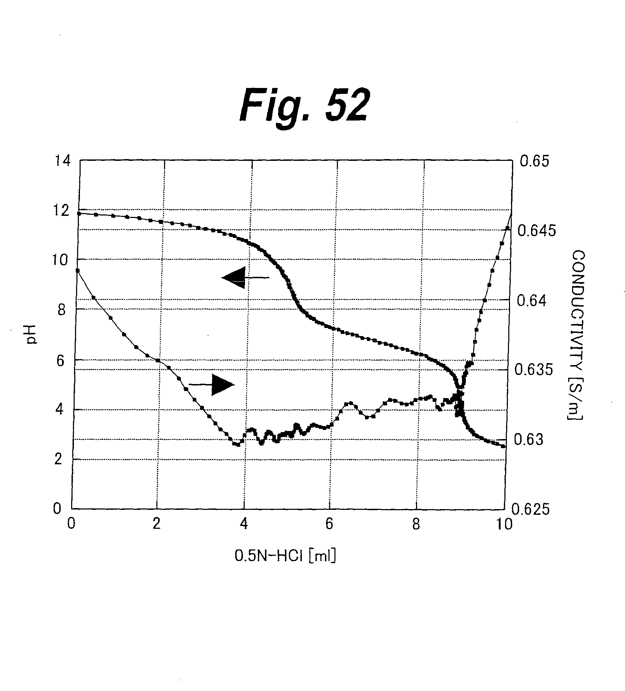

Furthermore, the developing solution used in the development was titrated with hydrochloric acid, and the relationship between the amount of dropwise addition of hydrochloric acid and the pH as well as conductivity was determined. The results are presented in Fig. 52. Here, the measurement was carried out by titrating a dilution which was prepared by adding 50 ml of pure water to a 10 ml sample of the developing solution, with 0.5 normal hydrochloric acid.

**(Table 4)**

| EXAMPLE | DEVELOPMENT ACCELERATING AGENT/RATIONAL FORMULA | DEVELOPMENT TIME [sec] | AFM DIAGRAM | TITRATION CURVE | GROOVE WIDTH [nm] | GROOVE DEPTH [nm] |
|---|---|---|---|---|---|---|
| EXAMPLE 27 | TETRAMETHYLAMMONIUM | 90 | Fig. 51A | Fig. 52 | 164 | - |
| | METASILICATE | 120 | Fig. 51B | | 164 | 18 |
| | [(CH₃)₄N]₂O·SiO₂ | 150 | Fig. 51C | | 180 | 19 |

| | | | | | | |
|---|---|---|---|---|---|---|
| ALKALI SOURCE: TRISODIUM PHOSPHATE·12-WATER | | | | | | |

When Example 27 is compared with Comparative Example 3, it can be seen that, even in the case of using trisodium phosphate ·12 water as the alkali source, a development accelerating effect based on the added tetramethylammonium metasilicate is manifested.

In Example 28, the method for preparing a developing solution by incorporating sodium metasilicate as a development accelerating agent which also serves as the alkali source, and the development effect exerted by the obtained developing solution on an inorganic resist, will be described.

### <Example 28>

The composition of the developing solution of Example 28 and the evaluation method will be shown in the following.
Additive doubling as alkali source: sodium metasilicate
Evaluation: Development, titration

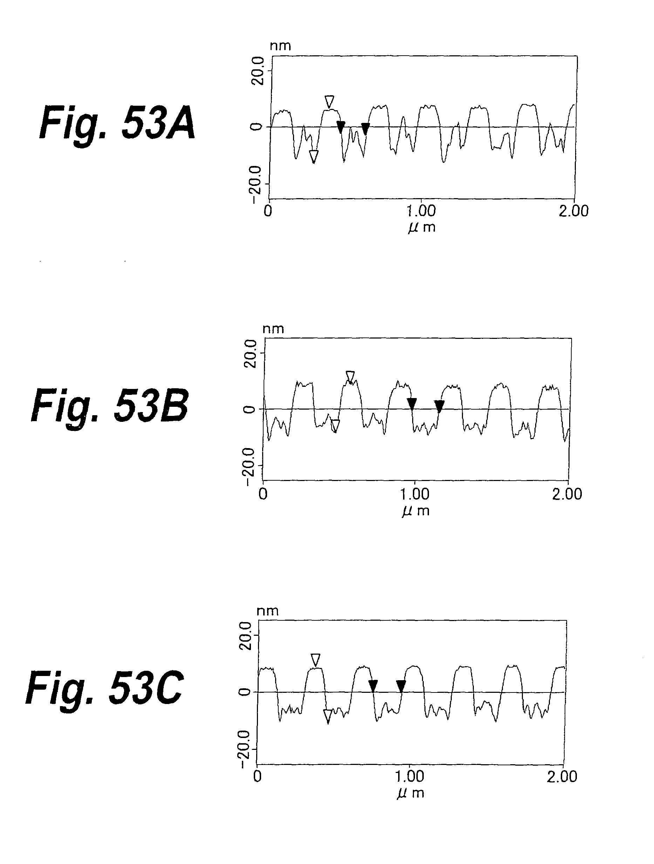

A resist master was obtained by carrying out the resist master production process and exposure process in the same manner as in Comparative Example 1. Subsequently, sodium silicate as a development accelerating agent which doubles as an alkali source was dissolved in pure water, and thus a developing solution at 0.2 mol/L was prepared. Subsequently, development of the inorganic resist master was performed in the same manner as in Comparative Example 1, except that this developing solution was used, and a desired resist master for optical disc was obtained. Subsequently, the grooves formed on the inorganic resist master were measured by using AFM. The results are presented in Table 5 and Fig. 53.

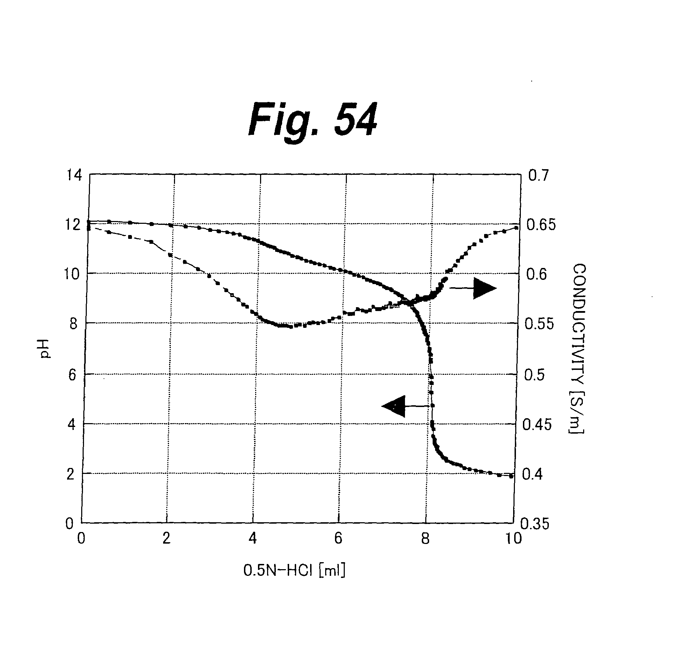

Furthermore, the developing solution used in the development was titrated with hydrochloric acid, and the relationship between the amount of dropwise addition of hydrochloric acid and the pH as well as conductivity was determined. The results are presented in Fig. 54. Here, the measurement was carried out by titrating a dilution which was prepared by adding 50 ml of pure water to a 10 ml sample of the developing solution, with 0.5 normal hydrochloric acid.

**(Table 5)**

| EXAMPLE | DEVELOPMENT ACCELERATING AGENT/RATIONAL FORMULA | DEVELOPMENT TIME [sec] | AFM DIAGRAM | TITRATION CURVE | GROOVE WIDTH [nm] | GROOVE DEPTH [nm] |
|---|---|---|---|---|---|---|
| EXAMPLE 28 | SODIUM METASILICATE Na₂O·SiO₂ | 60 | Fig. 53A | Fig. 54 | 156 | 19 |
| | | 90 | Fig. 53B | | 164 | 19 |
| | | 120 | Fig. 53C | | 172 | 19 |

| | | | | | | |
|---|---|---|---|---|---|---|
| ALKALI SOURCE: SODIUM METASILICATE | | | | | | |

In Example 29 to Example 42, the method for preparing a developing solution by using a 2.38 wt% aqueous solution of tetramethylammonium hydroxide as an alkaline aqueous solution, and incorporating thereto a development accelerating agent, and the development effect exerted by the obtained developing solution on an inorganic resist, will be described.

### <Example 29 to Example 35>

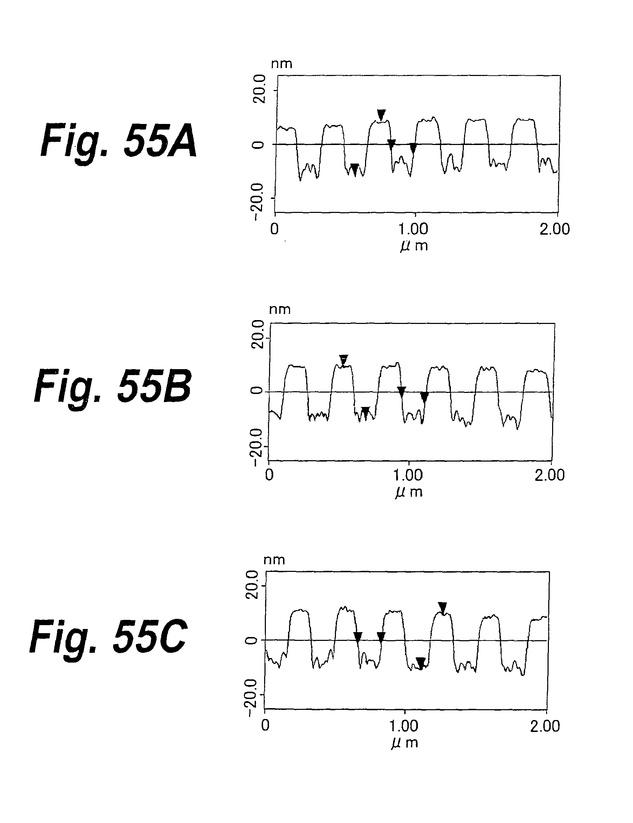

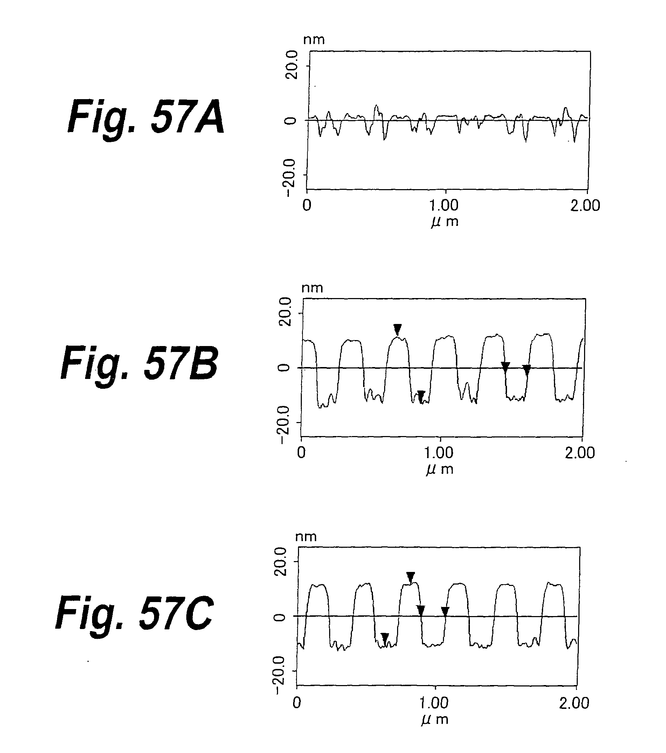

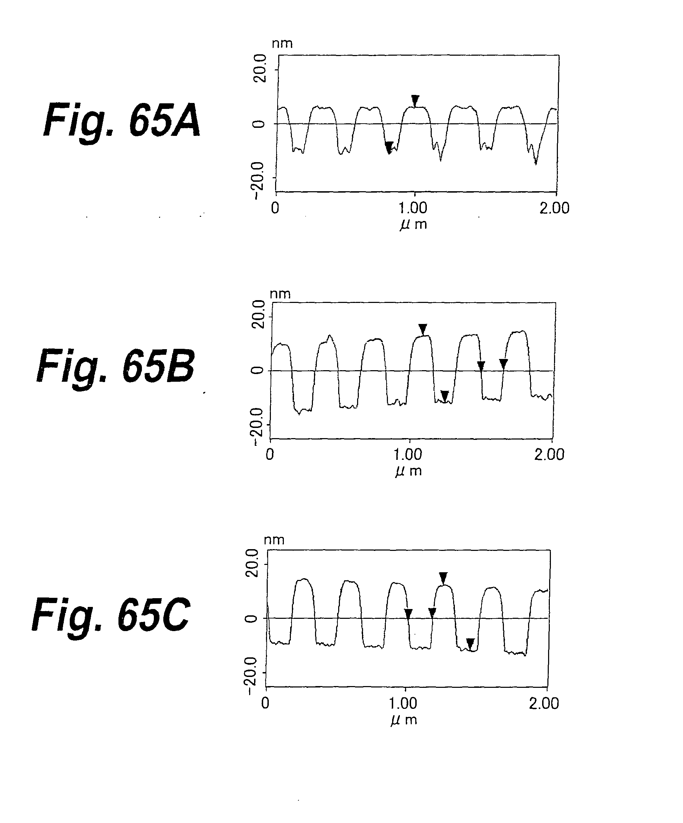

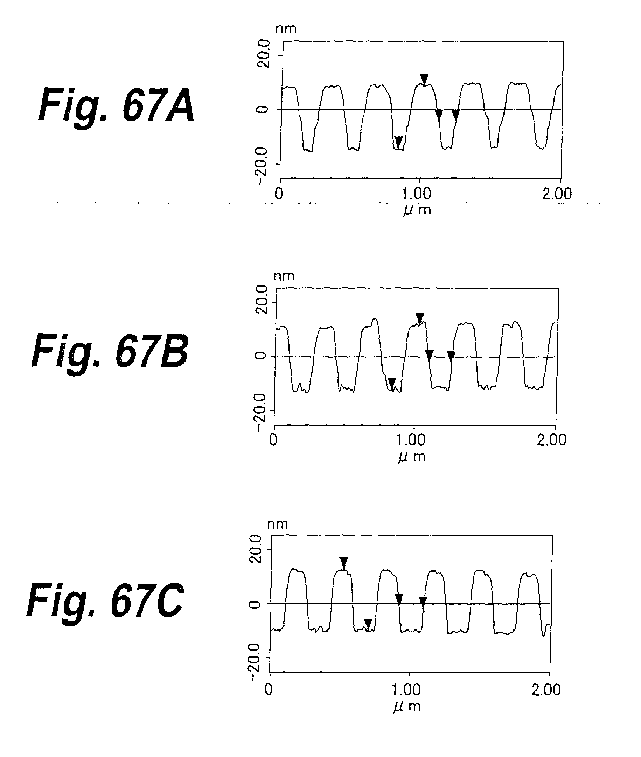

A resist master was obtained by carrying out the resist master production process and exposure process in the same manner as in Comparative Example 1. Subsequently, the development accelerating agents shown in Table 6 were added to a 2.38 wt% aqueous solution of tetramethylammonium hydroxide, and developing solutions at a concentration of 10 g/L were prepared for the respective development accelerating agents. Subsequently, development of the inorganic resist master was performed in the same manner as in Comparative Example 1, except that these developing solutions were used, and a desired resist master for optical disc was obtained. Subsequently, the grooves formed on the inorganic resist master were measured by using AFM. The results are presented in Table 6 and Fig. 55, Fig. 57, ..., Fig. 65, and Fig. 67.

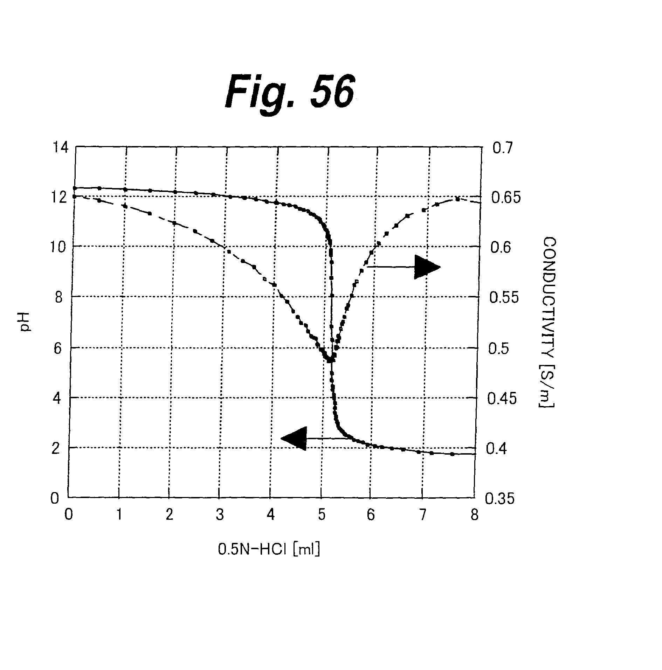

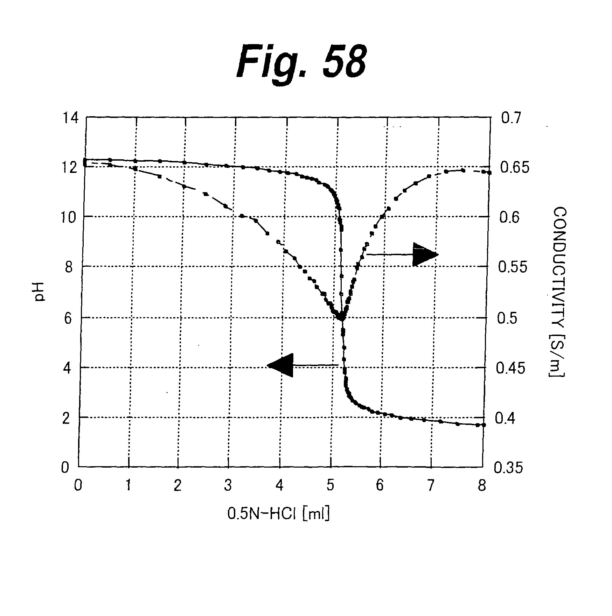

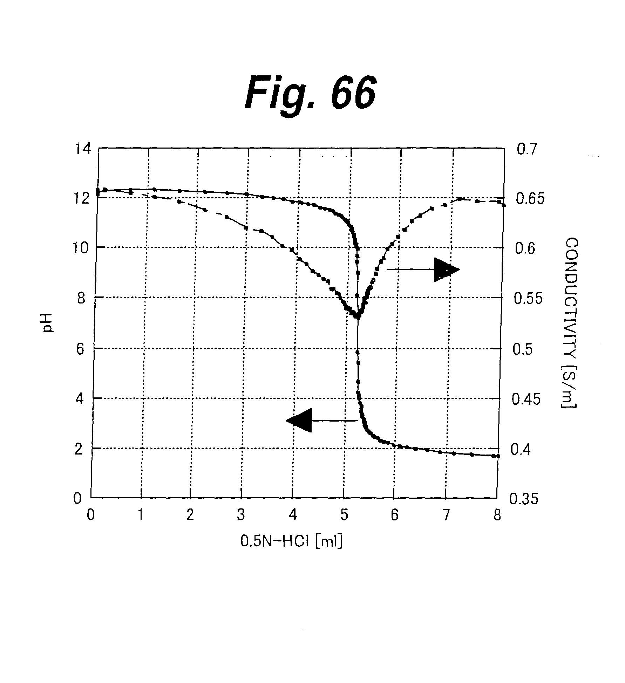

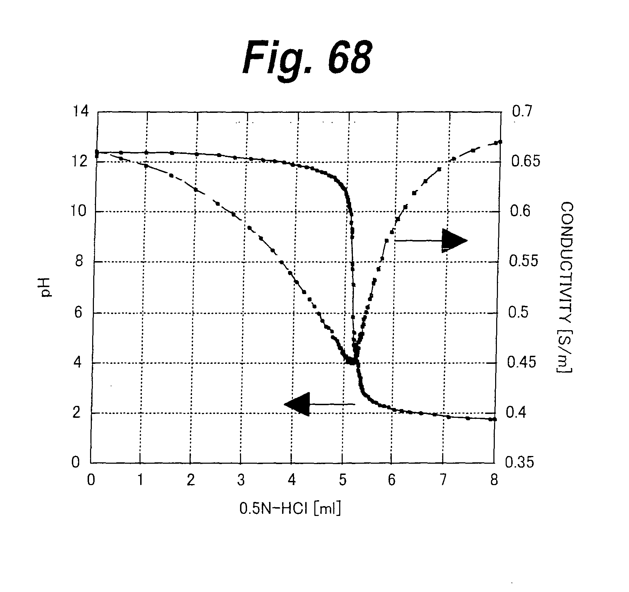

Furthermore, the developing solutions used in the development were titrated with hydrochloric acid, and the relationship between the amount of dropwise addition of hydrochloric acid and the pH as well as conductivity was determined. The results are presented in Fig. 56, Fig. 58, ..., Fig. 66, and Fig. 68. Here, the measurement was carried out by titrating a dilution which was prepared by adding 50 ml of pure water to a 10 ml sample of the developing solution, with 0.5 normal hydrochloric acid.

**(Table 6)**

| EXAMPLE | DEVELOPMENT ACCELERATING AGENT/RATIONAL FORMULA | DEVELOPMENT TIME [sec] | AFM DIAGRAM | TITRATION CURVE | GROOVE WIDTH [nm] | GROOVE DEPTH [nm] |
|---|---|---|---|---|---|---|
| EXAMPLE 29 | LITHIUM NITRATE LiNO₃ | 40 | Fig. 55A | Fig. 56 | 156 | 20 |
| | | 60 | Fig. 55B | | 160 | 20 |
| | | 80 | Fig. 55C | | 168 | 20 |
| EXAMPLE 30 | SODIUM NITRATE NaNO₃ | 20 | Fig. 57A | Fig. 58 | - | - |
| | | 40 | Fig. 57B | | 156 | 24 |
| | | 60 | Fig. 57C | | 172 | 22 |
| EXAMPLE 31 | POTASSIUM NITRATE KNO₃ | 20 | Fig. 59A | Fig. 60 | - | 24 |
| | | 40 | Fig. 59B | | 164 | 25 |
| | | 60 | Fig. 59C | | 180 | 24 |
| EXAMPLE 32 | LITHIUM CHLORIDE LiCl | 80 | Fig. 61A | Fig. 62 | 152 | 21 |
| | | 100 | Fig. 61B | | 156 | 21 |
| | | 120 | Fig. 61C | | 168 | 21 |
| EXAMPLE 33 | SODIUM CHLORIDE NaCl | 60 | Fig. 63A | Fig. 64 | 152 | 24 |
| | | 80 | Fig. 63B | | 164 | 23 |
| | | 100 | Fig. 63C | | 168 | 22 |
| EXAMPLE 34 | POTASSIUM CHLORIDE KCl | 20 | Fig. 65A | Fig. 66 | - | 17 |
| | | 40 | Fig. 65B | | 156 | 25 |
| | | 60 | Fig. 65C | | 172 | 24 |
| EXAMPLE 35 | CESIUM CHLORIDE CsCl | 40 | Fig. 67A | Fig. 68 | 121 | 23 |
| | | 60 | Fig. 67B | | 160 | 23 |
| | | 80 | Fig. 67C | | 168 | 22 |

| | | | | | | |
|---|---|---|---|---|---|---|
| ALKALI SOURCE: TETRAMETHYLAMMONIUM HYDROXIDE | | | | | | |

As shown by the titration curves of Fig. 56, Fig. 58, ..., Fig. 66, and Fig. 68, these alkali metal salts do not have points of neutralization other than the main alkali source. It is thought that the development acceleration due to the addition of these salts is not based on the catalytic action as in the case of the first and second embodiments, but is based only on the accelerating effect of the alkali metal ions.

### <Example 36 to Example 42>

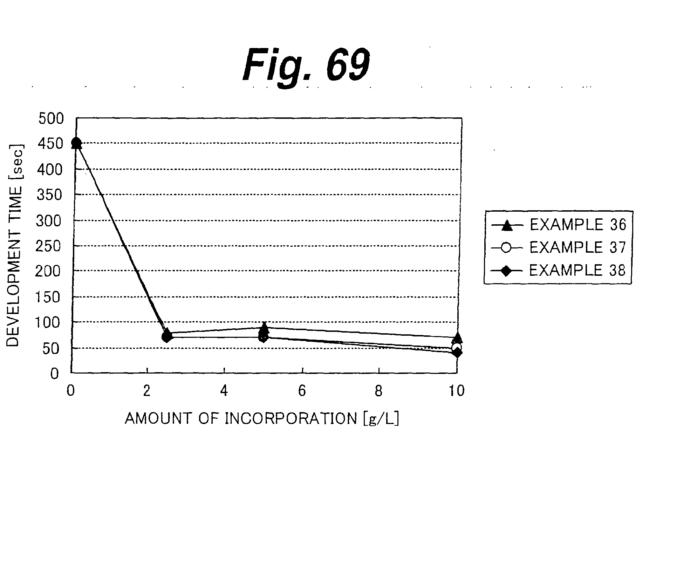

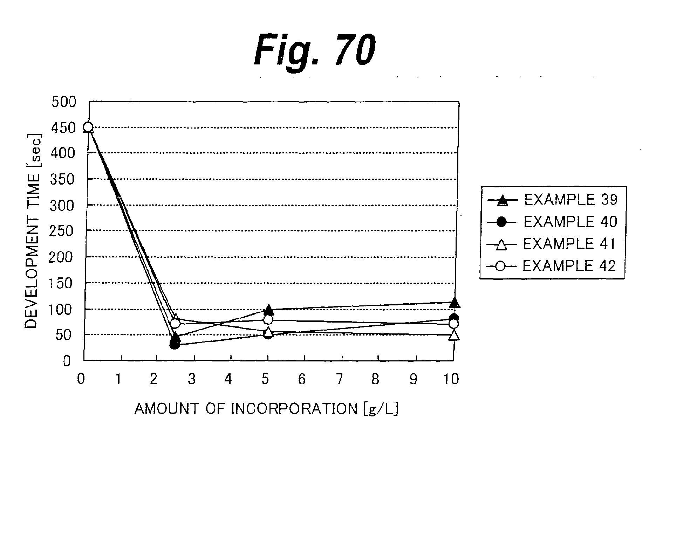

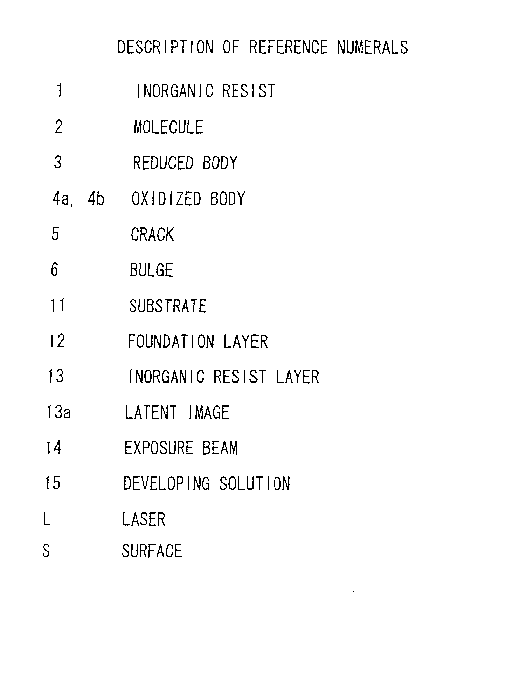

First, a resist master was obtained by carrying out the resist master production process and exposure process in the same manner as in Comparative Example 1. Subsequently, the development accelerating agents shown in Table 5 were added to a 2.38 wt% aqueous solution of tetramethylammonium hydroxide, and four types of developing solutions at concentrations of 0.0 g/L, 2.5 g/L, 5.0 g/L and 10.0 g/L were prepared. Subsequently, development of the inorganic resist master was performed in the same manner as in Comparative Example 1, except that these developing solutions were used, and the time taken until the half-width of the groove width reached 164 nm, was determined. The relationship between the amount of addition of the development accelerating agent and the development time is presented in Fig. 69 and Fig. 70.

**(Table 7)**

| EXAMPLE | DEVELOPMENT ACCELERATING AGENT/RATIONAL FORMULA | DEVELOPMENT TIME GRAPH |
|---|---|---|
| EXAMPLE 36 | LITHIUM NITRATE LiNO₃ | Fig. 69 |
| EXAMPLE 37 | SODIUM NITRATE NaNO₃ | Fig. 69 |
| EXAMPLE 38 | POTASSIUM NITRATE KNO₃ | Fig. 69 |
| EXAMPLE 39 | LITHIUM CHLORIDE LiCl | Fig. 70 |
| EXAMPLE 40 | SODIUM CHLORIDE NaCl | Fig. 70 |
| EXAMPLE 41 | POTASSIUM CHLORIDE KCl | Fig. 70 |
| EXAMPLE 42 | CESIUM CHLORIDE CsCl | Fig. 70 |

| | | |
|---|---|---|
| ALKALI SOURCE: TETRAMETHYLAMMONIUM HYDROXIDE | | |

By using the above-described results, the combination of the alkali source and the development accelerating agent can be appropriately selected in accordance with the type of the inorganic resist used or the surface morphology determined after development. For example, in the production of the resist master of a master stamper for optical disc, good pattern shapes can be respectively obtained by carrying out usage distinction, such as using a product prepared by adding tetramethylammonium metasilicate to an aqueous solution of tetramethylammonium hydroxide as a development accelerating agent when fabricating the groove shape, or using a product prepared by adding tetramethylammonium carbonate to an aqueous solution of tetramethylammonium hydroxide as a development accelerating agent when fabricating the pit shape. Furthermore, stable development properties can be obtained from the time of initiation of use, as a result of the addition of development accelerating agents.

As discussed above, embodiments and Examples of the present invention have been described in detail, but the present invention is not intended to the above-described embodiments and Examples, and various modifications based on the technical idea of the present invention are possible.

For example, the numerical values mentioned in the above-described embodiments and Examples are only examples after all, and numerical values different from these may also be used as necessary.

Furthermore, the present invention is also applicable to various optical discs, in addition to Blu-ray Disc (registered trademark), HD-DVD (Heigh Definition Digital Versatile Disc) and the like, and is also applicable to the next generation optical discs of higher density than the conventional optical discs as well as those optical discs such as Blu-ray Disc (registered trademark) or HD-DVD.

In the above-described embodiments and Examples, the cases where the present invention is applied to the method for producing a resist master for optical discs, have been discussed, but the present invention is not intended to be limited to the method for producing a resist master for optical discs, and is applicable to various devices having a fine concavo-convex pattern, for example, the anti-reflective structure in solar cells, the fuel flow channel in fuel cells, and the like, or methods for production thereof.

In the above-described embodiments and Examples, explanation was given on the case where the present invention was applied to the method for producing of a resist master which is used in the production of substrates for optical discs, but the present invention may also be applied to the method for producing a resist master which is used in the formation of intermediate layers of optical discs.

## Claims

1. A developing solution comprising:
an alkaline aqueous solution; and
at least one anion of a silicate ion, a carbonate ion, a borate ion and a phosphate ion.

2. The developing solution according to claim 1, wherein the alkaline aqueous solution is an aqueous solution of tetraalkylammonium hydroxide.

3. The developing solution according to claim 1, further comprising at least one of an ammonium ion and an organic ammonium ion as a cation.

4. The developing solution according to claim 1, further comprising an alkali metal ion as a cation.

5. The developing solution according to claim 1, further comprising an alkali metal ion and at least one of an ammonium ion and an organic ammonium ion, as cations.

6. The developing solution according to claim 1, wherein when the inorganic resist is developed, the anion repeatedly acts on the inorganic resist in the alkaline aqueous solution.

7. The developing solution according to claim 1, wherein when the inorganic resist is developed, the anion forms a bond with the inorganic resist.

8. The developing solution according to claim 1, wherein when titration is performed with an acid to determine a titration curve showing the relationship between the amount of dropwise addition and pH, the point of neutralization of the alkaline aqueous solution and an inflection point originating from the anion appear on the titration curve.

9. The developing solution according to claim 1, wherein the pH of the alkaline aqueous solution is set at a value higher than any of the pH values of the point of neutralization and the inflection point appearing on the titration curve.

10. The developing solution according to claim 9, wherein when titration is performed with an acid to determine a titration curve showing the relationship between the amount of dropwise addition and conductivity, the titration curve has a minimum region between the point of neutralization of the alkaline aqueous solution and the inflection point originating from the anion.

11. A developing solution comprising an alkaline aqueous solution and a development accelerating agent,
wherein the development accelerating agent is at least one of a silicate, a carbonate, a borate and a phosphate.

12. The developing solution according to claim 11, wherein the salt is a product produced by a reaction between the alkaline aqueous solution and at least one of silicon, a silicon compound, a carbon compound, a boron compound and a phosphorus compound.

13. The developing solution according to claim 11, wherein the salt is a product produced by a reaction between at least one selected, as an alkali component, from the group consisting of an alkali metal compound, an ammonium compound and a basic oxide, and at least one selected, as an acid component, from the group consisting of a protonic acid, an acidic oxide, an amphoteric oxide and an amphoteric hydroxide.

14. The developing solution according to claim 11, wherein the cation of the alkali source of the alkaline aqueous solution and the cation of the development accelerating agent are the same species.

15. The developing solution according to claim 14, wherein the cation of the alkali source of the alkaline aqueous solution and the cation of the development accelerating agent are ammonium ions or organic ammonium ions.

16. A method for producing a finely patterned material, the method comprising:
exposing an inorganic resist layer provided on a base material; and
developing the exposed inorganic resist with a developing solution,
wherein the developing solution contains:
an alkaline aqueous solution; and
at least one anion of a silicate ion, a carbonate ion, a borate ion and a phosphate ion.

17. The method for producing a finely patterned material according to claim 16, further comprising producing a developing solution by adding a silicate, a carbonate, a borate and a phosphate to the alkaline aqueous solution, prior to the exposing.
